# EUROPEAN PATENT APPLICATION

(11) **EP 4 773 779 A1**
(43) Date of publication of application: **08.07.2026**
(21) Application number: 24882758.6
(22) Date of filing: 21.10.2024
(51) Int. Cl.: H10K 59/131, G09G 3/00, G09G 3/3266, G09G 3/3233, H10K 77/10, G09F 9/30, H10K 59/121, H10K 59/123

(54) **DISPLAY DEVICE**

(30) Priority: 23.10.2023 KR 20230142431
(71) Applicant: Samsung Display Co., Ltd., Yongin-si, Gyeonggi-do 17113 (KR)
(72) Inventor: LEE, Sun Hwa, Yongin-si Gyeonggi-do 17113 (KR); KIM, Hyeong Seok, Yongin-si Gyeonggi-do 17113 (KR); PARK, Hee Jean, Yongin-si Gyeonggi-do 17113 (KR); JEON, Mu Kyung, Yongin-si Gyeonggi-do 17113 (KR)
(74) Representative: Walaski, Jan Filip
(86) International application number: PCT/KR2024/016012
(87) International publication number: WO 2025/089731

(57) **Abstract**

A display apparatus includes: a substrate including a first island portion and a second island portion spaced apart from each other, and a first bridge portion connecting the first island portion to the second island portion, a gate driving circuit disposed on the first island portion, a plurality of first input lines disposed on the second island portion, a connection line connected to some of the plurality of first input lines. The connection line is arranged to extend from the second island portion to the first island portion through the first bridge portion.

## Description

### Technical Field

One or more embodiments relate to a display apparatus, for example, a flexible display apparatus.

### Background Art

Along with the development of display apparatuses that visually display electrical signals, various flat panel display apparatuses having excellent characteristics such as a slim profile, being lightweight, and low power consumption, have been introduced. For example, flexible display apparatuses that are foldable or rollable have been developed. Research and development of a stretchable display apparatus capable of being changed into various shapes is being actively conducted of late.

### Disclosure of Invention

### Technical Problem

One or more embodiments include a display apparatus capable of implementing high-quality images by efficiently utilizing the space of a non-display area, while improving stretchability properties. However, aspects of embodiments are not limited thereto, and the above characteristics do not limit the scope of embodiments according to the disclosure.

### Solution to Problem

According to one or more embodiments, a display apparatus includes: a substrate including a first island portion and a second island portion spaced apart from each other, and a first bridge portion connecting the first island portion to the second island portion, a gate driving circuit disposed in the first island portion, a plurality of first input lines disposed on the second island portion, a connection line connected to some of the plurality of first input lines. The connection line is arranged to extend from the second island portion to the first island portion through the first bridge portion.

The first island portion and the second island portion may be arranged alternately in a first direction.

The connection line may include a first portion extending in the first direction on the first island portion, and a second portion branching from the first portion and extending in a second direction intersecting the first direction.

The gate driving circuit may include a plurality of stages, at least one stage of the plurality of stages may be disposed on the first island portion, and the second portion may be connected to the at least one stage.

The plurality of first input lines may include at least one of a gate high voltage line or a gate low voltage line, and the connection line may include at least one of a high voltage connection line connected to the gate high voltage line or a low voltage connection line connected to the gate low voltage line.

The high voltage connection line may include a portion having a 'T' shape in a plan view.

The high voltage connection line may include a first portion extending in a first direction from the first bridge portion toward a center of the first island portion, and a second portion branching from the first portion and extending in a second direction intersecting the first direction.

The first portion of the high voltage connection line and the second portion of the high voltage connection line may be disposed in the same layer and may be formed integrally with each other.

The low voltage connection line may include a portion having a loop shape having one side open in a plan view.

The low voltage connection line may include a first portion extending in a first direction from the first bridge portion toward a center of the first island portion, and a second portion branching from the first portion, surrounding at least a portion of the gate driving circuit in the plan view, and having a quadrangular shape with one side open.

The high voltage connection line may extend through the open side of the second portion.

The first portion of the low voltage connection line and the second portion of the low voltage connection line may be formed integrally with each other.

The low voltage connection line may include a first portion extending in a first direction from the first bridge portion disposed on one side surface of the first island portion toward an opposite side surface of the first island portion, and a second portion branching from the first portion and extending in a second direction intersecting the first direction.

The first portion of the low voltage connection line may include a portion having a diagonal shape extending in a diagonal direction between the first direction and the second direction.

The first portion of the low voltage connection line and the second portion of the low voltage connection line may be arranged in different layers from each other and may be electrically connected to each other through a contact hole.

The display apparatus may further include a plurality of second input lines arranged on the first island portion, and the plurality of second input lines may include at least one of a clock line, a carry line, or a reset signal line.

The display apparatus may further include a main island portion disposed in a display area, a pixel driving circuit portion disposed on the main island portion, and a light-emitting element disposed on the main island portion and connected to the pixel driving circuit portion. The pixel driving circuit portion and the light-emitting element may be connected to each other through at least one of a first connection piece disposed on the pixel driving circuit portion or a second connection piece disposed on the first connection piece.

A partial region of the clock line disposed on the first island portion may have a double wiring structure including a lower clock line and an upper clock line disposed on the lower clock line.

The lower clock line may be disposed in the same layer as a layer in which at least one of a source electrode or a drain electrode of the pixel driving circuit portion is disposed, and the upper clock line may be disposed in the same layer as a layer in which the first connection piece is disposed.

Each of the first island portion and the second island portion may be provided in plurality, the display apparatus may further include a second bridge portion connecting first island portions arranged adjacent to each other among the plurality of first island portions or connecting second island portions arranged adjacent to each other among the plurality of second island portions. Each of the plurality of first input lines and the plurality of second input lines may extend through the second bridge portion.

Each of the plurality of first input lines and the plurality of second input lines may have a single wiring structure on the second bridge portion.

Each of the plurality of first input lines and the plurality of second input lines may be disposed in the same layer as a layer in which at least one of the source electrode or the drain electrode of the pixel driving circuit portion is disposed.

Each of the plurality of first input lines and the plurality of second input lines may include a lower input line and an upper input line disposed on the lower input line, and may have a dual wiring structure on the second bridge portion.

The lower input line may be disposed in the same layer as a layer in which at least one of the source electrode or the drain electrode of the pixel driving circuit portion is disposed, and the upper input line may be disposed in the same layer as a layer in which the first connection piece is disposed.

The lower input line and the upper input line may be electrically connected to each other through a contact hole, and the contact hole may be disposed on the first island portion or the second island portion.

Each of the plurality of first input lines and the plurality of second input lines may include a lower input line, a middle input line disposed on the lower input line, and an upper input line disposed on the middle input line, and may have a triple wiring structure on the second bridge portion.

The lower input line may be disposed in the same layer as the layer in which at least one of the source electrode or the drain electrode of the pixel driving circuit portion is disposed. The middle input line may be disposed in the same layer as the layer in which the first connection piece is disposed. The upper input line may be disposed in the same layer as a layer in which the second connection piece is disposed.

The lower input line and the middle input line may be electrically connected to each other through a first contact hole, the middle input line and the upper input line may be electrically connected to each other through a second contact hole, and the first contact hole and the second contact hole may be disposed on the first island portion or the second island portion.

The gate driving circuit may include at least one of an emission control driving circuit, a bypass driving circuit, an initialization driving circuit, or a data writing driving circuit.

The first bridge portion may be disposed on a center of a side surface of each of the first island portion and the second island portion.

The first bridge portion may have a serpentine shape.

### Advantageous Effects of Invention

According to an embodiment, a display apparatus capable of preventing damage due to concentration of stress and stretching in various directions may be realized. A display apparatus according to an embodiment may efficiently utilize space in a non-display area and reduce the load on lines to realize images of excellent quality. These effects are only examples, and the scope of the disclosure is not limited thereto.

### Brief Description of Drawings

FIG. 1 is a schematic perspective view of a display apparatus according to an embodiment.
FIGS. 2A and 2B are perspective views of the display apparatus of FIG. 1 stretched in a first direction.
FIG. 2C is a perspective view of the display apparatus of FIG. 1 stretched in a second direction.
FIG. 2D is a perspective view of the display apparatus of FIG. 1 stretched in the first direction and the second direction.
FIG. 2E is a perspective view of the display apparatus of FIG. 1 stretched in a third direction.
FIG. 3 is a schematic plan view of a display apparatus according to an embodiment.
FIG. 4 is an enlarged plan view of a region A of FIG. 3, which is a portion of a display apparatus according to an embodiment.
FIG. 5 is a schematic cross-sectional view of a main island portion and a main bridge portion arranged in a display area of a display apparatus according to an embodiment.
FIGS. 6A through 6C are equivalent circuit diagrams of a sub-pixel of a display apparatus according to an embodiment.
FIGS. 7A and 7B are schematic cross-sectional views of a main island portion of a display apparatus according to an embodiment.
FIGS. 8A through 8G are schematic perspective views of embodiments of an electronic apparatus including a display apparatus according to an embodiment.
FIG. 9 is a schematic configuration diagram of a display apparatus according to an embodiment.
FIG. 10 schematically illustrates a gate driving circuit of a display apparatus according to an embodiment.
FIG. 11A is a circuit diagram of an embodiment of a first emission control stage included in the gate driving circuit of FIG. 10.
FIG. 11B is a circuit diagram of an embodiment of a first bypass stage included in the gate driving circuit of FIG. 10.
FIG. 11C is a circuit diagram of an embodiment of a first initialization stage included in the gate driving circuit of FIG. 10.
FIG. 12 is a schematic magnified plan view of a portion of a display apparatus according to an embodiment, that is, a magnified view of a region B of FIG. 3.
FIG. 13 is a schematic magnified plan view of a portion of a display apparatus according to an embodiment, that is, a magnified view of a region C of FIG. 12.
FIG. 14 is a schematic magnified plan view of a portion of a display apparatus according to an embodiment, that is, a magnified view of a region G of FIG. 13.
FIG. 15 is a cross-sectional view of a portion of a display apparatus according to an embodiment, and corresponds to a cross-section taken along line I-I' of FIG. 14.
FIG. 16 is a schematic magnified plan view of a portion of a display apparatus according to an embodiment, that is, a magnified view of a region D of FIG. 12.
FIG. 17 is a schematic magnified plan view of a portion of a display apparatus according to an embodiment, that is, a magnified view of a region E of FIG. 12.
FIG. 18 is a schematic magnified plan view of a portion of a display apparatus according to an embodiment, that is, a magnified view of a region F of FIG. 12.
FIG. 19 is a schematic magnified plan view of a portion of a display apparatus according to another embodiment.
FIG. 20 is a cross-sectional view of a portion of a display apparatus according to another embodiment, and corresponds to a cross-section taken along line II-II' of FIG. 19.
FIG. 21 is a schematic magnified plan view of a portion of a display apparatus according to another embodiment.
FIG. 22 is a cross-sectional view of a portion of a display apparatus according to another embodiment, and corresponds to a cross-section taken along line III-III' of FIG. 21.

### Mode for the Invention

As the disclosure allows for various changes and numerous embodiments, particular embodiments will be illustrated in the drawings and described in detail in the written description. Hereinafter, effects and features of the disclosure and a method for accomplishing them will be described more fully with reference to the accompanying drawings, in which embodiments of the disclosure are shown. The disclosure may, however, be embodied in many different forms and should not be construed as limited to the embodiments set forth herein.

One or more embodiments will be described below in more detail with reference to the accompanying drawings. Those components that are the same as or are in correspondence with each other are rendered the same reference numeral regardless of the figure number, and redundant explanations are omitted.

It will be understood that although the terms "first," "second," etc. may be used herein to describe various components, these components should not be limited by these terms. These components are only used to distinguish one component from another.

As used herein, the singular forms "a," "an," and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "formed on" another layer, region, or component, it can be directly or indirectly formed on the other layer, region, or component. That is, for example, intervening layers, regions, or components may be present.

Sizes of elements in the drawings may be exaggerated or reduced for convenience of explanation. For example, since sizes and thicknesses of components in the drawings are arbitrarily illustrated for convenience of explanation, embodiments are not limited thereto.

When a certain embodiment may be implemented differently, a specific process order may be performed differently from the described order. For example, two consecutively described processes may be performed substantially at the same time or performed in an order opposite to the described order.

It will also be understood that when a layer, region, or component is referred to as being "connected" or "coupled" to another layer, region, or component, it can be directly connected or coupled to the other layer, region, or/and component or intervening layers, regions, or components may be present. For example, when a layer, region, or component is referred to as being "electrically connected" or "electrically coupled" to another layer, region, or component, it can be directly electrically connected or coupled to the other layer, region, and/or component or intervening layers, regions, or components may be present.

In the following examples, the x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

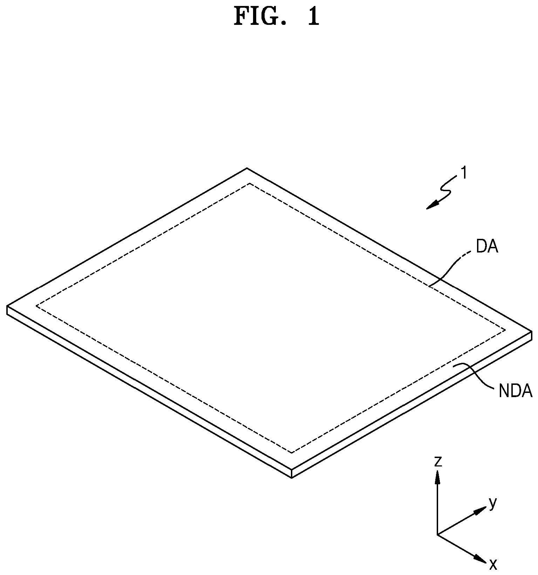

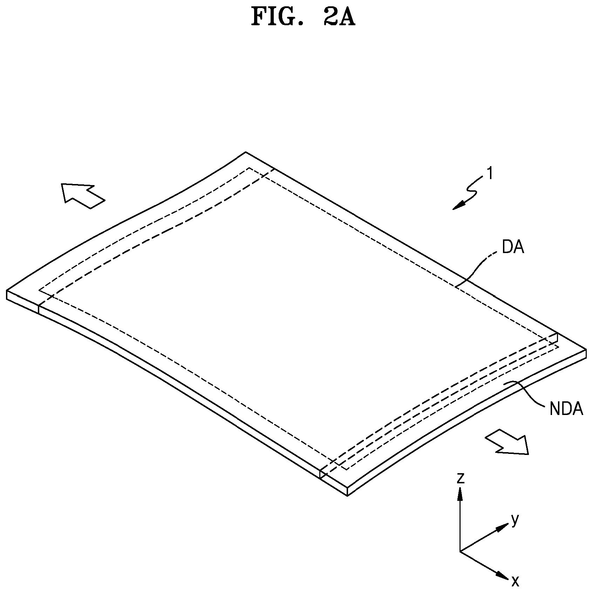

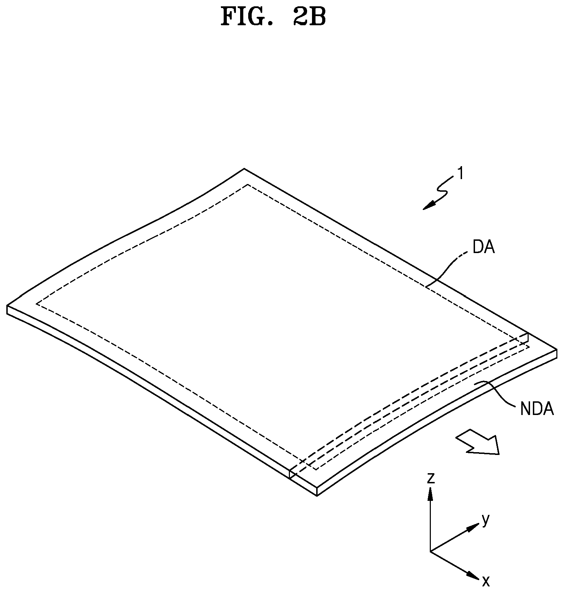

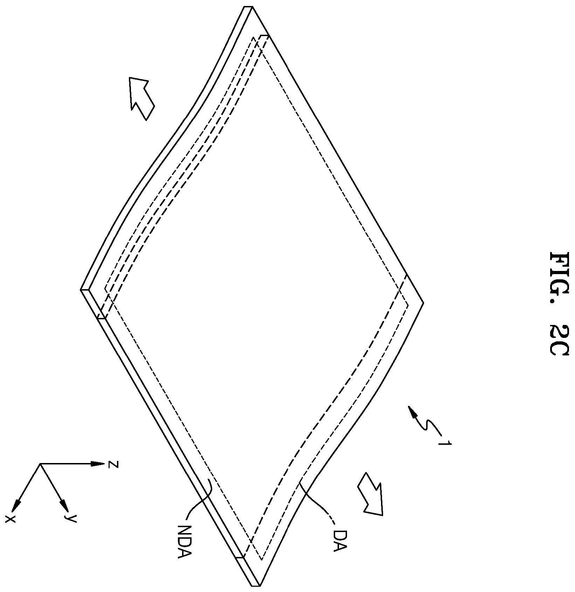

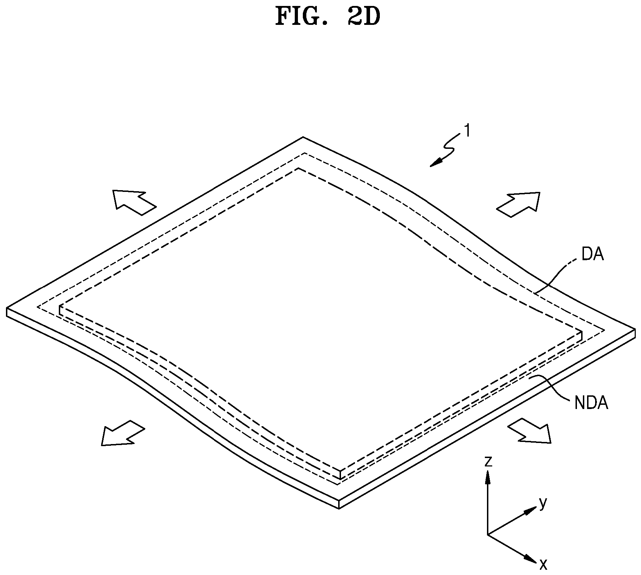

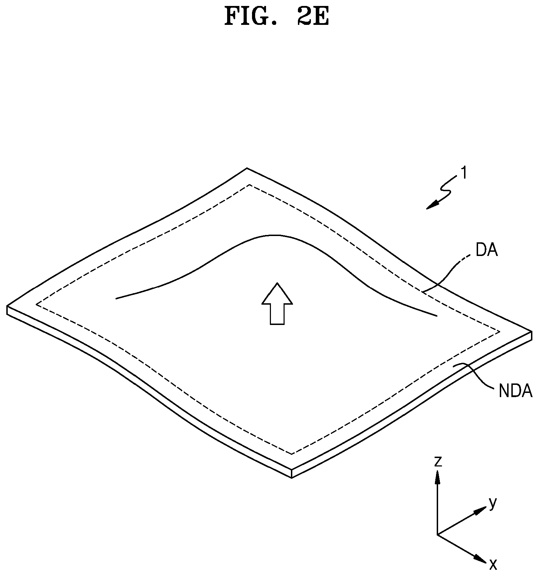

FIG. 1 is a schematic perspective view of a display apparatus 1 according to an embodiment. FIGS. 2A and 2B are perspective views of the display apparatus 1 of FIG. 1 stretched in a first direction. FIG. 2C is a perspective view of the display apparatus 1 of FIG. 1 stretched in a second direction. FIG. 2D is a perspective view of the display apparatus of FIG. 1 stretched in the first direction and the second direction. FIG. 2E is a perspective view of the display apparatus 1 of FIG. 1 stretched in a third direction.

Referring to FIG. 1, the display apparatus 1 may include a display area DA and a non-display area NDA. The display area DA may include a plurality of pixels. The display apparatus 1 may provide an image by using light emitted by the plurality of pixels. The non-display area NDA may be disposed outside the display area DA. The non-display area NDA may surround the display area DA entirely.

The display apparatus 1 may be stretched or shrunk in various directions. The display apparatus 1 may be stretched in the first direction (e.g., an x direction and/or an - x direction) due to an external force applied by an external object or a user. According to an embodiment, as shown in FIGS. 2A and 2B, the display area DA and/or the non-display area NDA of the display apparatus 1 may be stretched in the x direction (for example, the x direction and/or the -x direction). For example, as shown in FIG. 2A, the display area DA and/or the non-display area NDA may be stretched in the x direction and the -x direction, or may be stretched in the x direction with one side of the display apparatus 1 fixed as shown in FIG. 2B.

The display apparatus 1 may be stretched in the second direction (e.g., a y direction and/or a -y direction) due to an external force exerted by an external object or a user. According to an embodiment, as shown in FIG. 2C, the display area DA and/or the non-display area NDA of the display apparatus 1 may be stretched in the y direction and/or the -y direction. According to another embodiment, the display area DA and/or the non-display area NDA may be stretched in the y direction or the -y direction with one side of the display apparatus 1 fixed.

The display apparatus 1 may be stretched in a plurality of directions, for example, the first direction (e.g., the x direction and/or the -x direction) and the second direction (e.g., the y direction and/or the -y direction) due to an external force exerted by an external object or a portion of a human body. As shown in FIG. 2D, the display area DA and/or the non-display area NDA of the display apparatus 1 may be stretched in the ±x direction and the ±y direction.

The display apparatus 1 may be stretched in a third direction (e.g., a z direction or a -z direction) due to an external force exerted by an external object or a portion of a human body. According to an embodiment, it is shown in FIG. 2E that a portion of the display apparatus 1, for example, a partial region of the display area DA, protrudes in the z direction. According to another embodiment, a portion of the display apparatus 1, for example, a partial region of the display area DA, may protrude in the z direction (or may be depressed in the -z direction).

Although it is shown in FIGS. 2A through 2E that the display apparatus 1 is stretched in the first direction, the second direction, and/or the third direction, embodiments are not limited thereto. According to another embodiment, the display apparatus 1 may be transformed into various irregular shapes such as being bent or twisted along two or more axes.

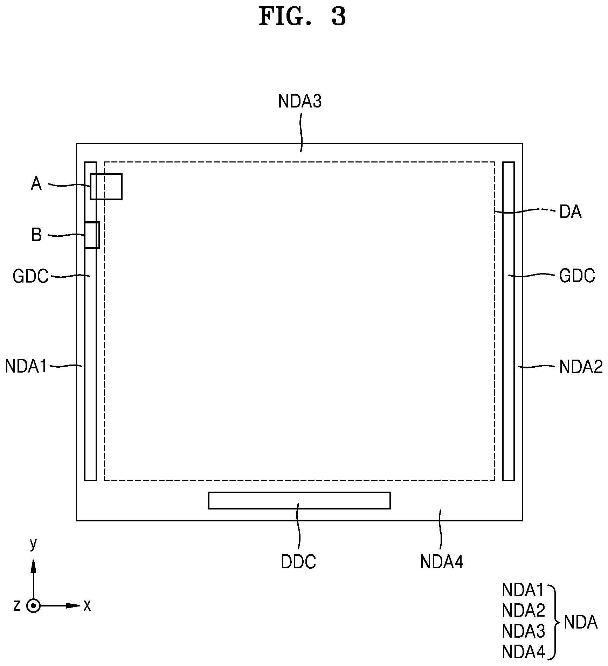

FIG. 3 is a schematic plan view of the display apparatus 1 according to an embodiment. As used herein, the "plan view" is a view in a thickness direction (i.e., z direction) of the substrate 100.

A plurality of pixels may be arranged in the display area DA of the display apparatus 1. Each pixel may include sub-pixels configured to emit light of different colors. A light-emitting element corresponding to each sub-pixel may be arranged in the display area DA. A circuit may be located in the non-display area NDA around the display area DA, wherein the circuit is configured to provide electrical signals to the light-emitting elements arranged in the display area DA and transistors electrically connected to the light-emitting elements. Gate driving circuits GDC may be respectively arranged in a first non-display area NDA1 and a second non-display area NDA2, respectively, arranged on two opposite sides with the display area DA therebetween. The gate driving circuits GDC may include drivers configured to provide electrical signals to a gate electrode of each of the transistors electrically connected to the light-emitting elements. Although it is shown in FIG. 3 that the gate driving circuits GDC are respectively arranged in the first non-display area NDA1 and the second non-display area NDA2, embodiments are not limited thereto. According to another embodiment, a gate driving circuit GDC may be arranged in one of the first non-display area NDA1 and the second non-display area NDA2.

A data driving circuit DDC may be arranged in a third non-display area NDA3 and/or a fourth non-display area NDA4 each connecting the first non-display area NDA1 to the second non-display area NDA2. According to an embodiment, it is shown in FIG. 3 that the data driving circuit DDC is arranged in the fourth non-display area NDA4. According to another embodiment, data driving circuits DDC may be respectively arranged in the third non-display area NDA3 and the fourth non-display area NDA4.

Although it is shown in FIG. 3 that the data driving circuit DDC is arranged in the fourth non-display area NDA4 of the display apparatus 1, embodiments are not limited thereto. According to another embodiment, the display apparatus 1 may further include a flexible circuit board (not shown) electrically connected through a terminal portion (not shown) arranged in the fourth non-display area NDA4, and the data driving circuit DDC may be arranged on the flexible circuit board.

According to some embodiments, an elongation rate of the non-display area NDA may be equal to or less than an elongation rate of the display area DA. According to an embodiment, the elongation rate of the non-display area NDA may be different for each region thereof. For example, although the first non-display area NDA1, the second non-display area NDA2, and the third non-display area NDA3 may have substantially the same elongation rates, an elongation rate of the fourth non-display area NDA4 may be less than that of each of the first non-display area NDA1, the second non-display area NDA2, and the third non-display area NDA3.

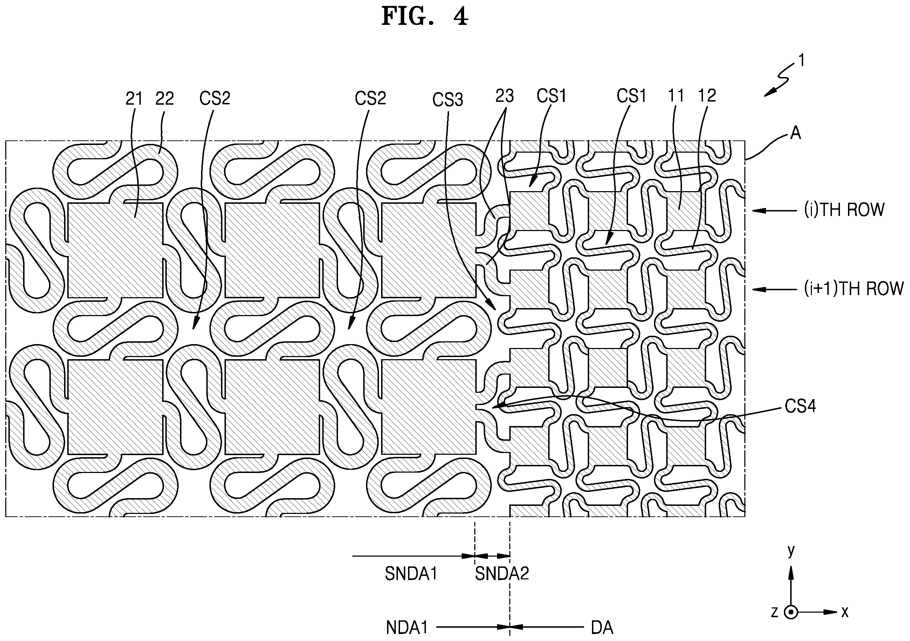

FIG. 4 is an enlarged plan view of a region A of FIG. 3, which is a portion of the display apparatus 1 according to an embodiment.

Referring to FIG. 4, the display apparatus 1 may include main island portions 11 and main bridge portions 12 in the display area DA, wherein the main island portions 11 are apart from each other in the first direction (e.g., the x direction or the -x direction) and the second direction (e.g., the y direction or the -y direction), and the main bridge portions 12 connect adjacent main island portions 11 to each other.

The main bridge portions 12 may be arranged apart from each other by a first opening CS1 located between the main bridge portions 12. Each of the main bridge portions 12 may have a serpentine shape. For example, as shown in FIG. 4, the main bridge portion 12 may have an approximately 'alphabet S' shape.

Each main island portion 11 may be connected to a plurality of main bridge portions 12. For example, each main island portion 11 may be connected to four main bridge portions 12. Two main bridge portions 12 may be respectively arranged on two opposite sides of the main island portion 11 in the first direction (e.g., the x direction or the -x direction), and the remaining two main bridge portions 12 may be respectively arranged on two opposite sides of the main island portion 11 in the second direction (e.g., the y direction or the -y direction). The four main bridge portions 12 may be respectively connected to four lateral sides of the main island portion 11. The four main bridge portions 12 may be adjacent to corners of the main island portion 11, respectively.

The display apparatus 1 may include peripheral island portions 21 and peripheral bridge portions 22 in the non-display area NDA, for example, in the first non-display area NDA1 shown in FIG. 4, wherein the peripheral island portions 21 are apart from each other in the first direction (e.g., the x direction or the -x direction) and the second direction (e.g., the y direction or the -y direction) and the peripheral bridge portions 22 connect adjacent peripheral bridge portions 22 island portions 21 to each other.

The peripheral bridge portions 22 may be arranged apart from each other by a second opening CS2 located between the peripheral bridge portions 22. Each of the peripheral bridge portions 22 may have a serpentine shape. For example, as shown in FIG. 4, the peripheral bridge portion 22 may have an approximately 'alphabet S' shape. A size and/or a width of the peripheral bridge portion 22 may be different from a size and/or a width of the main bridge portion 12. For example, the size and/or a width of the peripheral bridge portion 22 may be greater than the size and/or the width of the main bridge portion 12. A curvature radius of a round portion of the peripheral bridge portion 22 may be different from a curvature radius of a round portion of the main bridge portion 12. For example, the curvature radius of the round portion of the peripheral bridge portion 22 may be greater than the curvature radius of the round portion of the main bridge portion 12.

Each peripheral island portion 21 may be connected to a plurality of peripheral bridge portions 22. A size and/or a width of the peripheral island portion 21 may be different from a size and/or a width of the main island portion 11. For example, a planar area of the peripheral island portion 21 may be greater than that of the main island portion 11. Each peripheral island portion 21 may be connected to four peripheral bridge portions 22. Two peripheral bridge portions 22 may be respectively arranged on two opposite sides of the main island portion 21 in the first direction (e.g., the x direction or the -x direction), and the remaining two peripheral bridge portions 22 may be respectively arranged on two opposite sides of the peripheral island portion 21 in the second direction (e.g., the y direction or the -y direction). According to an embodiment, four peripheral bridge portions 22 may be respectively connected to four lateral sides of the peripheral island portion 21. Each peripheral bridge portion 22 may be connected to a central portion of each lateral side of the peripheral island portion 21.

The peripheral island portions 21 in one row arranged in the first non-display area NDA1 may correspond to the main island portions 11 in a plurality of rows arranged in the display area DA. For example, the peripheral island portions 21 in one row arranged in the first non-display area NDA1 may correspond to the main island portions 11 arranged in an i-th row in the display area DA and the main island portions 11 arranged in an (i+1)th row in the display area DA (here, i is a positive number greater than 0). According to another embodiment, the peripheral island portions 21 in one row may correspond to n rows of the main island portions 11 (here, n is a positive number equal to or greater than 3).

The non-display area NDA of FIG. 3, for example, the first non-display area NDA1, may include a first sub-non-display area SNDA1 in which the peripheral island portions 21 and the peripheral bridge portions 22 are arranged, and a second sub-non-display area SNDA2 between the first sub-non-display area SNDA1 and the display area DA. Sub-bridge portions 23 may be arranged in the second sub-non-display area SNDA2, wherein the sub-bridge portions 23 connect the display area DA to the first sub-non-display area SNDA1. One end of each of the sub-bridge portions 23 may be connected to the peripheral island portion 21, and the other end of the sub-bridge portion 23 may be connected to the main island portion 11. For example, one end of the sub-bridge portion 23 may be connected to the central portion of one lateral side of the peripheral island portion 21, and the other end of the sub-bridge portion 23 may be connected to the central portion of one lateral side of the main island portion 11.

Each of the sub-bridge portion 23 may have a serpentine shape. According to an embodiment, the shape of the sub-bridge portion 23 may be different from the shape of each of the main bridge portion 12 and the peripheral bridge portion 22. A width of the sub-bridge portion 23 may be different from a width of the main bridge portion 12 and a width of the peripheral bridge portion 22. The width of the sub-bridge portion 23 may be greater than the width of the main bridge portion 12 and may be less than the width of the peripheral bridge portion 22. In the second direction (e.g., the y direction or the -y direction), third openings CS3 and fourth openings CS4 having different shapes may be alternately arranged between the sub-bridge portions 23.

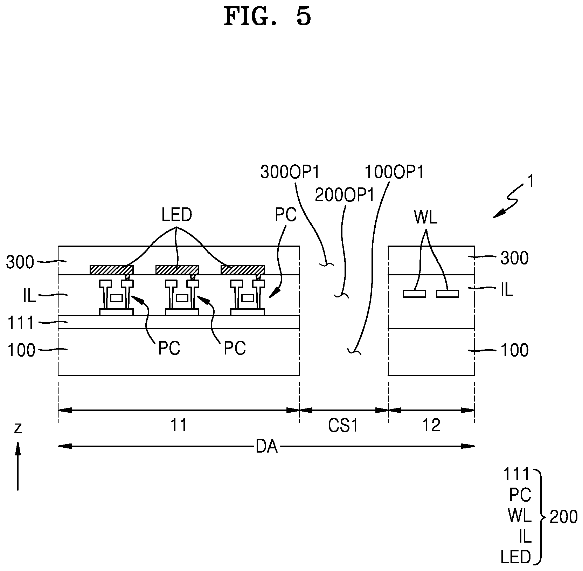

FIG. 5 is a schematic cross-sectional view of the main island portion 11 and the main bridge portion 12 arranged in the display area DA of the display apparatus 1 according to an embodiment.

Referring to FIG. 5, the main island portion 11 and the main bridge portion 12 arranged in the display area DA may be apart from each other with the first opening CS1 therebetween. The main island portion 11 may include light-emitting elements LED and circuits, for example, pixel driving circuit portions PC, electrically connected to the light-emitting elements LED and configured to drive the light-emitting elements LED. The main bridge portion 12 may include lines WL electrically connected to the pixel driving circuit portions PC respectively arranged on adjacent first island portions 11.

Regarding the main island portion 11, a buffer layer 111 including an inorganic insulating material may be disposed on a substrate 100, and the pixel driving circuit portions PC may be arranged on the buffer layer 111. An insulating layer IL including an inorganic insulating material and/or an organic insulating material may be disposed between the pixel driving circuit portions PC and the light-emitting elements LED. The light-emitting elements LED may be disposed on the insulating layer IL and electrically connected to the pixel driving circuit portions PC corresponding to the light-emitting elements LED. The light-emitting elements LED may be configured to emit light of different colors or emit light of the same color. According to an embodiment, the light-emitting elements LED may be configured to respectively emit red light, green light, and blue light. According to some embodiments, the light-emitting elements LED may be configured to emit white light. According to another embodiment, the light-emitting elements LED may be configured to respectively emit red light, green light, blue light, and white light.

The substrate 100 may include polymer resin such as polyethersulfone, polyarylate, polyetherimide, polyethylene naphthalate, polyethylene terephthalate, polyphenylene sulfide, polyimide, polycarbonate, cellulose triacetate, or cellulose acetate propionate, for example. According to an embodiment, the substrate 100 may be a single layer including the above-described polymer resin. According to another embodiment, the substrate 100 may have a multi-layered structure including a base layer including the aforementioned polymer resin and a barrier layer including an inorganic insulating material. The substrate 100 including polymer resin may be flexible, rollable, or bendable.

According to an embodiment, although it is shown in FIG. 5 that three pixel driving circuit portions PC are arranged in each main island portion 11 and three light-emitting elements LED are respectively connected to the three pixel driving circuit portions PC, embodiments are not limited thereto. According to another embodiment, the respective numbers of pixel driving circuit portions PC and light-emitting elements LED arranged in the main island portion 11 may be one, two, four, or more.

An encapsulation layer 300 may be disposed on the light-emitting elements LED, and may protect the light-emitting elements LED from an external force and/or moisture transmission. The encapsulation layer 300 may include an organic encapsulation layer and/or an inorganic encapsulation layer. According to some embodiments, the encapsulation layer 300 may have a structure in which an inorganic encapsulation layer including an inorganic insulating material, an organic encapsulation layer including an organic insulating material, and an inorganic encapsulation layer including an inorganic insulating material are stacked. According to another embodiment, the encapsulation layer 300 may include an organic material such as resin. According to some embodiments, the encapsulation layer 300 may include urethane epoxy acrylate. The encapsulation layer 300 may include a photosensitive material, for example, a photoresist.

Regarding the main bridge portion 12, the insulating layer IL including an organic insulating material may be disposed on the substrate 100. Unlike the main island portion 11, the main bridge portion 12, which is relatively transformed much when the display apparatus 1 is stretched, may not include a layer including an inorganic insulating material that is prone to cracking.

According to an embodiment, the substrate 100 corresponding to the main bridge portion 12 may have the same stack structure as the substrate 100 corresponding to the main island portion 11. According to an embodiment, the substrate 100 corresponding to the main bridge portion 12 and the substrate 100 corresponding to the main island portion 11 may be polymer resin layers simultaneously formed during the same process. According to another embodiment, the substrate 100 corresponding to the main bridge portion 12 may have a different stack structure from the substrate 100 corresponding to the main island portion 11. According to some embodiments, the substrate 100 corresponding to the main bridge portion 12 may have a multi-layered structure including a base layer including polymer resin and a barrier layer including an inorganic insulating material, and the substrate 100 corresponding to the main bridge portion 12 may have a structure of a polymer resin layer without a layer including an inorganic insulating material.

As described above, the lines WL of the main bridge portion 12 may be signal lines (e.g., a gate line and a data line) configured to provide electrical signals to transistors included in the pixel driving circuit portions PC of the main island portion 11, or may be voltage lines (e.g., a driving voltage line and an initialization voltage line) configured to provide voltages. The encapsulation layer 300 may also be disposed in the main bridge portion 12. According to another embodiment, the encapsulation layer 300 may not be present in the main bridge portion 12.

Referring to FIGS. 4 and 5, the substrate 100 corresponding to the main island portion 11 and the substrate 100 corresponding to the main bridge portion 12 may be connected to each other. In other words, the plan view of FIG. 4 may be substantially the same as the plan view of the substrate 100 of FIG. 5. In other words, the substrate 100 may include a region corresponding to the main island portion 11, a region corresponding to the main bridge portion 12, and an opening 100OP1 having a shape equal to the shape of the first opening CS1.

Similarly, the encapsulation layer 300 corresponding to the main island portion 11 and the encapsulation layer 300 corresponding to the main bridge portion 12 may be connected to each other. For example, the plan view of FIG. 4 may be substantially the same as the plan view of the encapsulation layer 300. In other words, the encapsulation layer 300 may include a region corresponding to the main island portion 11, a region corresponding to the main bridge portion 12, and an opening 300OP1 having a shape equal to the shape of the first opening CS1.

A circuit-light-emitting element layer 200 between the substrate 100 and the encapsulation layer 300 may include the buffer layer 111, the pixel driving circuit portions PC, the lines WL, the insulating layer IL, and the light-emitting elements LED. Similar to the substrate 100, the plan view of FIG. 4 may be substantially the same as the plan view of the circuit-light-emitting element layer 200. In other words, the circuit-light-emitting element layer 200 may include an opening 200OP1 having the same shape as the first opening CS1.

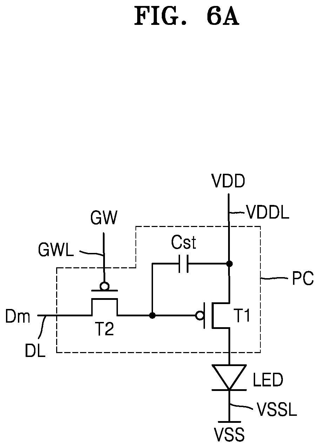

FIGS. 6A through 6C are equivalent circuit diagrams of a sub-pixel of the display apparatus 1 according to an embodiment.

Referring to FIG. 6A, a light-emitting element LED corresponding to the sub-pixel may be electrically connected to a pixel driving circuit portion PC, and the pixel driving circuit portion PC may include a first transistor T1, a second transistor T2, and a storage capacitor Cst. The pixel driving circuit portion PC may be electrically connected to signal lines and voltage lines. The signal lines may include a gate line such as a scan signal line GWL, and a data line DL, and the voltage lines may include a first voltage line VDDL.

The second transistor T2 may be electrically connected to the scan signal line GWL and the data line DL. The scan signal line GWL may be configured to provide a scan signal GW to a gate electrode of the second transistor T2. The second transistor T2 may be configured to transfer a data signal Dm to the first transistor T1 according to the scan signal GW input from the scan signal line GWL, wherein the data signal Dm is input from the data line DL.

The storage capacitor Cst may be electrically connected to the second transistor T2 and the first voltage line VDDL, and may store a voltage corresponding to a difference between a voltage received from the second transistor T2 and a first power supply voltage VDD supplied by the first voltage line VDDL.

The first transistor T1, which is a driving transistor, may be configured to control a driving current flowing through the light-emitting element LED. The first transistor T1 may be connected to the first voltage line VDDL and the storage capacitor Cst. The first transistor T1 may control a driving current flowing from the first voltage line VDDL to the light-emitting element LED according to a voltage value stored in the storage capacitor Cst. The light-emitting element layer 200 may emit light having a certain brightness according to the driving current. A first electrode of the light-emitting element LED may be electrically connected to the first transistor T1, and a second electrode of the light-emitting element LED may be electrically connected to a second voltage line VSSL configured to supply a second power voltage VSS.

In FIG. 6A, the pixel driving circuit portion PC includes two transistors and one storage capacitor. However, according to another embodiment, the pixel driving circuit portion PC may include three or more transistors.

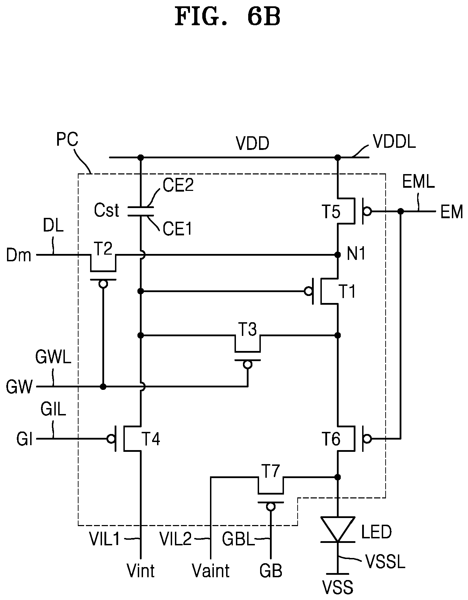

Referring to FIG. 6B, the pixel driving circuit portion PC may include a first transistor T1, a second transistor T2, a third transistor T3, a fourth transistor T4, a fifth transistor T5, a sixth transistor T6, a seventh transistor T7, and a storage capacitor Cst.

The pixel driving circuit portion PC is electrically connected to signal lines and voltage lines. The signal lines may include gate lines, such as a scan signal line GWL, a bypass control line GBL, an initialization control line GIL, and a light-emission control line EML, and a data line DL. The voltage lines may include first and second initializing voltage lines VIL1 and VIL2 and the first voltage line VDDL.

The first voltage line VDDL may transmit the first power supply voltage VDD to the first transistor T1. The first initializing voltage line VIL1 may transmit, to the pixel driving circuit portion PC, a first initializing voltage Vint that initializes the first transistor T1. The second initializing voltage line VIL2 may transmit, to the pixel driving circuit portion PC, a second initializing voltage Vaint that initializes a first electrode of the light-emitting element LED.

The first transistor T1 may be electrically connected to the first voltage line VDDL through the fifth transistor T5, and may be electrically connected to the light-emitting diode LED through the sixth transistor T6. The first transistor T1 severs as a driving transistor, and receives a data signal Dm according to a switching operation of the second transistor T2 and supplies a driving current to the light-emitting element LED.

The second transistor T2, which is a data write transistor, is electrically connected to the scan signal line GWL and the data line DL. The second transistor T2 is electrically connected to the first voltage line VDDL through the fifth transistor T5. The second transistor T2 is turned on in response to a scan signal GW received through the scan signal line GWL, to perform a switching operation of transmitting the data signal Dm received through the data line DL to a first node N1.

The third transistor T3 is electrically connected to the scan signal line GWL, and is electrically connected to the light-emitting element LED via the sixth transistor T6. The third transistor T3 may be turned on in response to the scan signal GW received through the scan signal line GWL, to diode-connect the first transistor T1.

The fourth transistor T4, which is a first initialization transistor, is electrically connected to the initialization control line GIL and the first initializing voltage line VIL1. The fourth transistor T4 is turned on in response to an initialization control signal GI received through the initialization control line GIL, and transmit the first initializing voltage Vint from the first initializing voltage line VIL1 to the gate electrode of the first transistor T1 to thereby initialize the voltage of the gate electrode of the first transistor T1. The initialization control signal GI may correspond to a scan signal of another pixel driving circuit portion arranged in a row previous to the row of the current pixel driving circuit portion PC.

The fifth transistor T5 may be an operation control transistor, and the sixth transistor T6 may be a light-emission control transistor. The fifth transistor T5 and the sixth transistor T6 are electrically connected to the light-emission control line EML, and are simultaneously turned on according to a light-emission control signal EM received through the light-emission control line EML and form a current path so that the driving current flows from the first voltage line VDDL toward the light-emitting element LED.

The seventh transistor T7, which is a second initialization transistor, may be electrically connected to the bypass control line GBL, the second initializing voltage line VIL2, and the sixth transistor T6. The seventh transistor T7 may be turned on according to a bypass control signal GB received through the bypass control line GBL, and may be configured to transfer the second initializing voltage Vaint from the second initializing voltage line VIL2 to the first electrode of the light-emitting element LED to thereby initialize the first electrode of the light-emitting element LED.

The storage capacitor Cst includes a first electrode CE1 and a second electrode CE2. The first electrode CE1 is electrically connected to the gate electrode of the first transistor T1, and the second electrode CE2 is electrically connected to the first voltage line VDDL. The storage capacitor Cst may maintain a voltage applied to the gate electrode of the first transistor T1 by storing and maintaining a voltage corresponding to a difference between the voltage of the first voltage line VDDL and the voltage of the gate electrode of the first transistor T1.

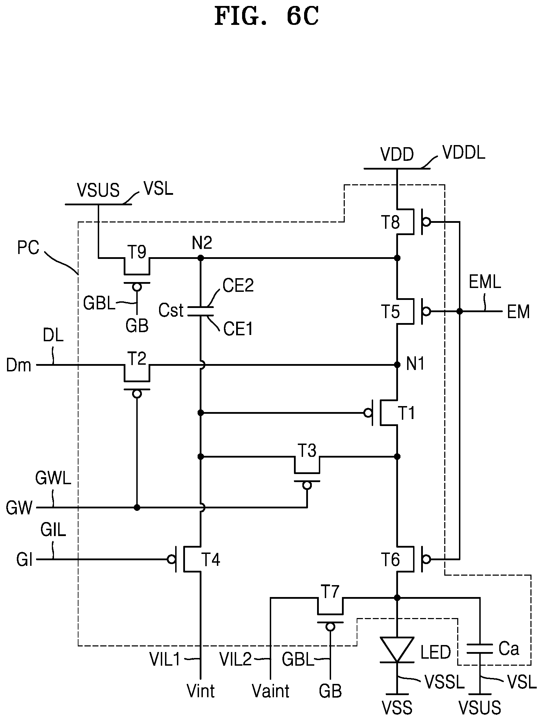

Referring to FIG. 6C, the pixel driving circuit portion PC may include a first transistor T1, a second transistor T2, a third transistor T3, a fourth transistor T4, a fifth transistor T5, a sixth transistor T6, a seventh transistor T7, an eighth transistor T8, a ninth transistor T9, a storage capacitor Cst, and an auxiliary capacitor Ca.

The pixel driving circuit portion PC is electrically connected to signal lines and voltage lines. The signal lines may include gate lines, such as a scan signal line GWL, a bypass control line GBL, an initialization control line GIL, and a light-emission control line EML, and a data line DL. The voltage lines may include first and second initializing voltage lines VIL1 and VIL2, a sustain voltage line VSL, and the first voltage line VDDL.

The first voltage line VDDL may transmit the first power supply voltage VDD to the first transistor T1. The first initializing voltage line VIL1 may transmit, to the pixel driving circuit portion PC, a first initializing voltage Vint that initializes the first transistor T1. The second initializing voltage line VIL2 may transmit, to the pixel driving circuit portion PC, a second initializing voltage Vaint that initializes a first electrode of the light-emitting element LED. The sustain voltage line VSL may be configured to provide a sustain voltage VSUS to a second node N2, for example, to the second electrode CE2 of the storage capacitor Cst, during an initialization section and a data-write section.

The first transistor T1 may be electrically connected to the first voltage line VDDL through the fifth transistor T5 and the eighth transistor T8, and may be electrically connected to the light-emitting diode LED through the sixth transistor T6. The first transistor T1 severs as a driving transistor, and may receive a data signal Dm according to a switching operation of the second transistor T2 and supply a driving current to the light-emitting element LED.

The second transistor T2 is electrically connected to the scan signal line GWL and the data line DL, and is electrically connected to the first voltage line VDDL via the fifth transistor T5 and the eighth transistor T8. The second transistor T2 is turned on in response to a scan signal GW received through the scan signal line GWL, to perform a switching operation of transmitting the data signal Dm received through the data line DL to a first node N1.

The third transistor T3 is electrically connected to the scan signal line GWL, and is electrically connected to the light-emitting element LED via the sixth transistor T6. The third transistor T3 may be turned on in response to the scan signal GW received through the scan signal line GWL to diode-connect the first transistor T1, thereby compensating for a threshold voltage of the first transistor T1.

The fourth transistor T4 is electrically connected to the initialization control line GIL and the first initializing voltage line VIL1, and is turned on in response to an initialization control signal GI received through the initialization control line GIL and transmit the first initializing voltage Vint from the first initializing voltage line VIL1 to the gate electrode of the first transistor T1 to thereby initialize the voltage of the gate electrode of the first transistor T1. The initialization control signal GI may correspond to a scan signal of another pixel driving circuit portion arranged in a row previous to the row of the current pixel driving circuit portion PC.

The fifth transistor T5, the sixth transistor T6, and the eighth transistor T8 are electrically connected to the light-emission control line EML, and are simultaneously turned on according to a light-emission control signal EM received through the light-emission control line EML and form a current path so that the driving current flows from the first voltage line VDDL toward the light-emitting element LED.

The seventh transistor T7, which is a second initialization transistor, may be electrically connected to the bypass control line GBL, the second initializing voltage line VIL2, and the sixth transistor T6. The seventh transistor T7 is turned on according to a bypass control signal GB received through the bypass control line GBL, and is configured to transfer the second initializing voltage Vaint from the second initializing voltage line VIL2 to the first electrode of the light-emitting element LED to thereby initialize the first electrode of the light-emitting element LED.

The ninth transistor T9 may be electrically connected to the bypass control line GBL, the second electrode CE2 of the storage capacitor Cst, and the sustain voltage line VSL. The ninth transistor T9 may be turned on according to the bypass control signal GB transferred through the bypass control line GBL, and may be configured to transfer the sustain voltage VSUS to the second node N2, for example, the second electrode CE2 of the storage capacitor Cst, during the initialization section and the data-write section.

Each of the eighth transistor T8 and the ninth transistor T9 may be electrically connected to the second node N2, for example, the second electrode CE2 of the storage capacitor Cst. According to some embodiments, during the initialization section and the data-write section, the eighth transistor T8 may be turned off and the ninth transistor T9 may be turned on, and, during an emission section, the eighth transistor T8 may be turned on and the ninth transistor T9 may be turned off. Because, during the initialization section and the data-write section, the sustain voltage VSUS is transferred to the second node N2, uniformity in brightness of the display apparatus (e.g., long range uniformity ("LRU")) according to a voltage drop of the first voltage line VDDL may be improved.

The storage capacitor Cst includes a first electrode CE1 and the second electrode CE2. The first electrode CE1 is electrically connected to the gate electrode of the first transistor T1, and the second electrode CE2 is electrically connected to the eighth transistor T8 and the ninth transistor T9.

The auxiliary capacitor Ca may be electrically connected to the sixth transistor T6, the sustain voltage line VSL, and the first electrode of the light-emitting element LED. While the seventh transistor T7 and the ninth transistor T9 are being turned on, the auxiliary capacitor Ca stores and maintains a voltage corresponding to a difference between the voltage of the first electrode of the light-emitting element LED and the voltage of the sustain voltage line VSL, thereby preventing a black brightness from rising when the sixth transistor T6 is turned off.

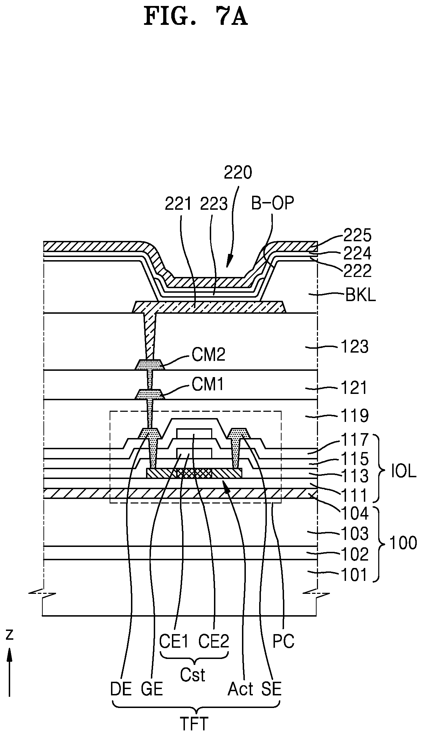

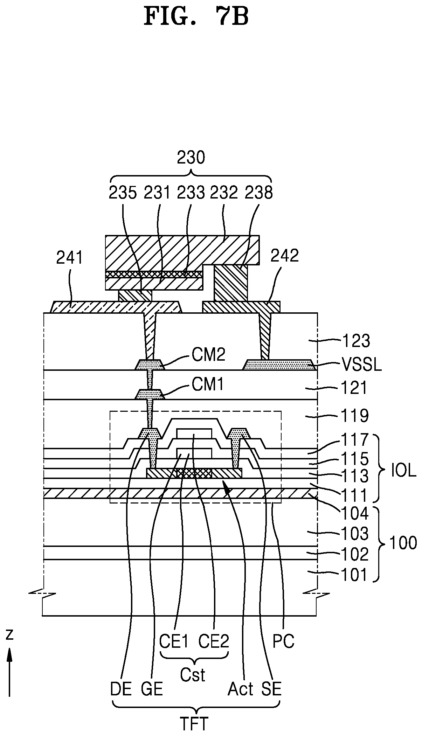

FIGS. 7A and 7B are schematic cross-sectional views of a main island of a display apparatus according to an embodiment.

Referring to FIGS. 7A and 7B, a main island portion 11 (see FIG. 4) of the display apparatus according to an embodiment may include a pixel driving circuit portion PC and a light-emitting element LED of FIG. 6A. The light-emitting element LED of FIG. 6A may include an organic light-emitting diode 220 as shown in FIG. 7A or an inorganic light-emitting diode 230 as shown in FIG. 7B. The pixel driving circuit portion PC may be disposed between the substrate 100 and the light-emitting element LED of FIG. 6A. The pixel driving circuit portion PC may include a transistor and a storage capacitor as described above with reference to FIGS. 6A through 6C. According to an embodiment, the pixel driving circuit portion PC is shown as having the same structure as the pixel driving circuit portion PC described above with reference to FIG. 6A, and a detailed structure thereof is the same as described above.

First, referring to FIG. 7A, the substrate 100 corresponding to the main island portion 11 (see FIG. 4) may include a first sub-substrate 101, a first barrier layer 102, a second sub-substrate 103, and a second barrier layer 104. Each of the first sub-substrate 101 and the second sub-substrate 103 may include a polymer resin, such as polyethersulfone, polyarylate, polyetherimide, polyethylene naphthalate, polyethylene terephthalate, polyphenylene sulfide, polyimide, polycarbonate, cellulose triacetate, or cellulose acetate propionate, for example. Each of the first and second barrier layers 102 and 104 may include an inorganic insulating material such as silicon oxide, silicon nitride, or silicon oxynitride.

A buffer layer 111 may be disposed on the substrate 100, and the pixel driving circuit portion PC may be disposed on the buffer layer 111. The buffer layer 111 may include an inorganic insulating material such as silicon oxide, silicon nitride, or silicon oxynitride.

The pixel driving circuit portion PC may include a transistor TFT. The transistor TFT may include a semiconductor layer Act, a gate electrode GE, a source electrode SE, and a drain electrode DE. In FIG. 7A, the transistor TFT is a top gate type in which the gate electrode GE is arranged on the semiconductor layer Act with a gate insulating layer 113 therebetween. However, according to another embodiment, the transistor TFT may be a bottom gate type.

The semiconductor layer Act may include polysilicon. Alternatively, the semiconductor layer Act may include, for example, amorphous silicon, an oxide semiconductor, or an organic semiconductor. The gate electrode GE may include a low resistance metal material. The gate electrode GE may include a conductive material including molybdenum (Mo), aluminum (Al), copper (Cu), and titanium (Ti), and may be formed as a multi-layer or single layer including the aforementioned materials.

The gate insulating layer 113 between the semiconductor layer Act and the gate electrode GE may include an inorganic insulating material such as silicon oxide, silicon nitride, silicon oxynitride, aluminum oxide, or titanium oxide. The gate insulating layer 113 may be a single layer or multi-layer including the aforementioned materials.

The source electrode SE and the drain electrode DE may be located in the same layer, for example, on a second interlayer-insulating layer 117, and may include the same materials. The source electrode SE and the drain electrode DE may include a highly conductive material. Each of the source electrode SE and the drain electrode DE may include a conductive material including molybdenum (Mo), aluminum (Al), copper (Cu), and titanium (Ti), and may be a multi-layer or single layer including the aforementioned materials. According to an embodiment, each of the source electrode SE and the drain electrode DE may be formed as a multi-layer of a titanium layer, an aluminum layer, and a titanium layer (Ti/Al/Ti). The second interlayer-insulating layer 117 may include an inorganic insulating material such as silicon oxide, silicon nitride, silicon oxynitride, aluminum oxide, or titanium oxide, and may be a single layer or multiple layers including the aforementioned materials.

The storage capacitor Cst may include a first electrode CE1 and a second electrode CE2 overlapping each other with a first interlayer-insulating layer 115 therebetween. The storage capacitor Cst and the transistor TFT may overlap each other. With regard to this, FIG. 7A illustrates a case where the gate electrode GE of the transistor TFT is the first electrode CE1 of the storage capacitor Cst. According to another embodiment, the storage capacitor Cst and the transistor TFT may not overlap each other. The storage capacitor Cst may be covered by the second interlayer-insulating layer 117. The second electrode CE2 of the storage capacitor Cst may include a conductive material including molybdenum (Mo), aluminum (Al), copper (Cu), and titanium (Ti), and may be formed as a multi-layer or single layer including the aforementioned materials. The first interlayer-insulating layer 115 may be disposed between the gate insulating layer 113 and the second interlayer-insulating layer 117. The first interlayer-insulating layer 115 may include an inorganic insulating material such as silicon oxide, silicon nitride, silicon oxynitride, aluminum oxide, or titanium oxide, and may be a single layer or multiple layers including the aforementioned materials.

A size or area of an inorganic insulating material layer ("IOL") corresponding to the main island portion 11 of FIG. 4 may be less than a size or area of the main island portion 11 of FIG. 4. In other words, the size or area of the inorganic insulating material layer IOL disposed on the substrate 100 may be less than the size or area of the first sub-substrate 101, the first barrier layer 102, and/or the second sub-substrate 103. The inorganic insulating material layer IOL on the substrate 100 may include, for example, the buffer layer 111, the gate insulating layer 113, the first interlayer-insulating layer 115, and the second interlayer-insulating layer 117.

A first organic insulating layer 119 may be disposed on the second interlayer-insulating layer 117, and a second organic insulating layer 121 may be disposed on the first organic insulating layer 119. Each of the first and second organic insulating layers 119 and 121 may include an organic insulating material such as polyimide.

A first connection piece CM1 may be disposed on the first organic insulating layer 119, and a second connection piece CM2 may be disposed on the second organic insulating layer 121. The first connection piece CM1 and the second connection piece CM2 may electrically connect the transistor TFT and the light-emitting element LED of FIG. 6A. Each of the first connection piece CM1 and the second connection piece CM2 may include a conductive material including molybdenum (Mo), aluminum (Al), copper (Cu), and titanium (Ti), and may be a multi-layer or single layer including the aforementioned materials.

A second voltage line VSSL may be disposed on the second organic insulating layer 121, and a third organic insulating layer 123 may be disposed on the second organic insulating layer 121. The third organic insulating pattern 123 may include an organic insulating material such as polyimide. The second voltage line VSSL may include a conductive material including molybdenum (Mo), aluminum (Al), copper (Cu), and titanium (Ti), and may be formed as a multi-layer or single layer including the aforementioned materials.

According to an embodiment, as shown in FIG. 7A, the light-emitting element LED (see FIG. 6A) according to an embodiment may include an organic light-emitting diode 220 including an organic material. The organic light-emitting diode 220 may include a first electrode 221 disposed on an insulating layer, a second electrode 225 facing the first electrode 221, and an emission layer 223 interposed between the first electrode 221 and the second electrode 225. A first functional layer 222 may be interposed between the first electrode 221 and the emission layer 223, and a second functional layer 224 may be interposed between the emission layer 223 and the second d electrode 225.

An edge of the first electrode 221 may be covered with a bank layer BKL including an insulating material. The bank layer BKL may include an opening B-OP overlapping a center portion of the first electrode 221.

The first electrode 221 may include conductive oxide such as indium tin oxide ("ITO"), indium zinc oxide ("IZO"), zinc oxide (ZnO), indium oxide (In₂O₃), indium gallium oxide ("IGO"), or aluminum zinc oxide ("AZO"). According to another embodiment, the first electrode 221 may include a reflective layer including, for example, silver (Ag), magnesium (Mg), aluminum (Al), platinum (Pt), palladium (Pd), gold (Au), nickel (Ni), neodymium (Nd), iridium (Ir), chromium (Cr), or a compound of these materials. According to another embodiment, the first electrode 221 may further include a layer formed of ITO, IZO, ZnO, or In₂O₃ above/below the reflective layer.

The emission layer 223 may include a low molecular or high molecular organic material that emits light of a certain color. The first functional layer 222 may include a hole transport layer ("HTL") and/or a hole injection layer ("HIL"). The second functional layer 224 may include an electron transport layer ("ETL") and/or an electron injection layer ("EIL").

The second electrode 225 may include a conductive material having a low work function. For example, the second electrode 225 may include a (semi)transparent layer including, for example, silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca) or an alloy of these materials. Alternatively, the second electrode 225 may further include a layer, such as ITO, IZO, ZnO, or In₂O₃, on the (semi)transparent layer including any of the above-described materials.

Next, referring to FIG. 7B, the light-emitting element LED (see FIG. 6) according to an embodiment may include an inorganic light-emitting diode 230 including an inorganic material. The inorganic light-emitting diode 230 may include a first semiconductor layer 231, a second semiconductor layer 232, an intermediate layer 233 between the first semiconductor layer 231 and the second semiconductor layer 232, a first electrode 235 electrically connected to the first semiconductor layer 231, and a second electrode 238 electrically connected to the second semiconductor layer 232. The first electrode 235 and the second electrode 238 of the inorganic light-emitting diode 230 may be electrically connected to a first electrode pad 241 and a second electrode pad 242, respectively, disposed in the same layer.

According to some embodiments, the first semiconductor layer 231 may include a p-type semiconductor layer. The p-type semiconductor layer may be selected from semiconductor materials having a composition formula of InₓAl_{y}Ga_{1-x-y}N (0≥x≥1, 0≥y≥1, 0≥x+y≥1), for example, GaN, AIN, AlGaN, InGaN, InN, InAlGaN, and AlInN, and may be doped with a p-type dopant such as Mg, Zn, Ca, Sr, or Ba.

The second semiconductor layer 232 may include, for example, an n-type semiconductor layer. The n-type semiconductor layer may be selected from semiconductor materials having a composition formula of InₓAl_{y}Ga_{1-x-y}N (0≥x≥1, 0≥y≥1, 0≥x+y≥1), for example, GaN, AIN, AlGaN, InGaN, InN, InAlGaN, and AlInN, and may be doped with an n-type dopant such as Si, Ge, or Sn.

The intermediate layer 233, in which electrons and holes are recombined, may transit to a low energy level due to recombination between electrons and holes, and may generate light having a wavelength corresponding to the low energy level. The intermediate layer 233 may be formed by including a semiconductor material having a composition formula of InₓAl_{y}Ga_{1-x-y}N (0≥x≥1, 0≥y≥1, 0≥x+y≥1), and may have a single quantum well structure or a multi-quantum well ("MQW") structure. Alternatively, the intermediate layer 233 may have a quantum wire structure or a quantum dot structure.

It has been described with reference to FIG. 7B that the first semiconductor layer 231 includes a p-type semiconductor layer and the second semiconductor layer 232 includes an n-type semiconductor layer, but embodiments are not limited thereto. According to another embodiment, the first semiconductor layer 231 may include an n-type semiconductor layer, and the second semiconductor layer 232 may include a p-type semiconductor layer.

The display apparatus 1 according to the above-described embodiments may be used in various electronic apparatuses capable of providing images. Here, an electronic apparatus refers to an apparatus that uses electricity and is capable of providing a certain image.

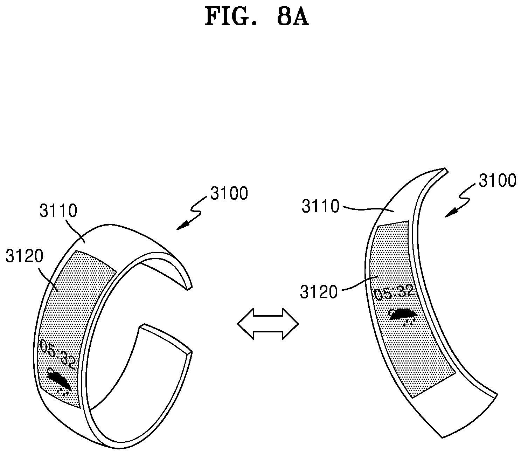

FIGS. 8A through 8G are schematic perspective views of embodiments of an electronic apparatus including a display apparatus according to an embodiment.

Referring to FIG. 8A, the display apparatus according to an embodiment may be utilized in a wearable electronic apparatus 3100 that may be worn on a portion of a user's body. The wearable electronic apparatus 3100 may include a body portion 3110 and a display 3120 provided in the body portion 3110. The display apparatus according to embodiments may be used as the display 3120 of the wearable electronic apparatus 3100. As shown in FIG. 8A, the wearable electronic apparatus 3100 may be transformed. According to an embodiment, the wearable electronic apparatus 3100 may be used as a smartwatch or a smartphone according to the user's selection.

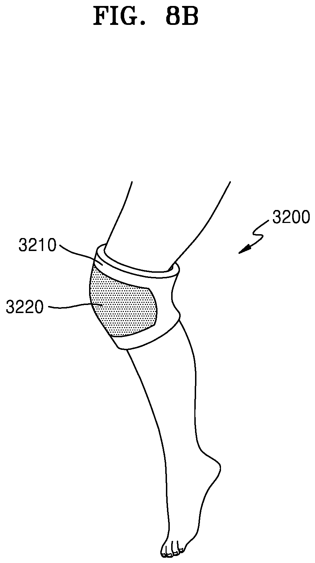

FIG. 8B shows a medical electronic apparatus 3200. According to an embodiment, the medical electronic apparatus 3200 may include a body portion 3210 and an emission portion 3220. The display apparatus according to embodiments may be used as the emission portion 3220 of the medical electronic apparatus 3200. The emission portion 3220 may be configured to emit light in a certain wavelength band (e.g., an infrared ray or a visible ray) to a patient's body. According to an embodiment, the body portion 3210 may have a stretchable fiber material, and may have a structure that may be worn on the body of the user who uses the emission portion 3220.

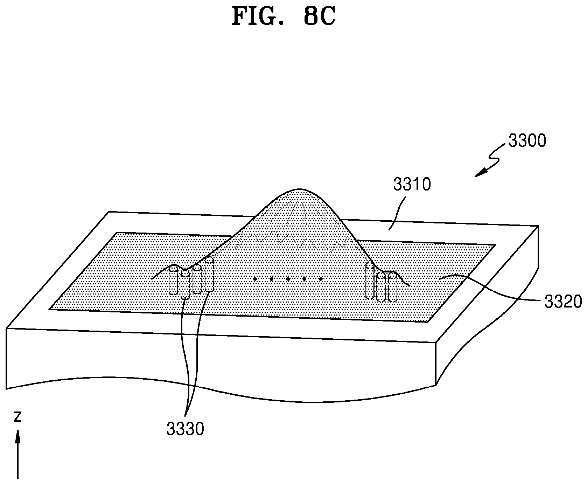

FIG. 8C shows an educational electronic apparatus 3300. According to an embodiment, the educational electronic apparatus 3300 may include a display 3320 provided inside a frame 3310. The display 3320 may use the display apparatus according to embodiments. Images such as sea with waves, a mountain covered with snow, or a volcano with flowing lava may be provided through the display 3320, and in this case, the display 3320 may extend in a height direction (e.g., a z direction) to reflect the height of waves, mountains, or volcanoes. According to some embodiments, because the height of a portion of the display 3320 sequentially varies in a direction in which the lava flows, the display 3320 may show the movements of lava three-dimensionally. The educational electronic apparatus 3300 may include a plurality of pins 3330 (or stroke portions) disposed on the backside of the display 3320 such that the display 3320 extends in the height direction. As the pins 3330 move in the third direction (e.g., a z direction or a -z direction), the image displayed on the display 3320 may be implemented to have a three-dimensional height. Although FIG. 8C describes the educational electronic apparatus 3300, the purpose of the electronic apparatus is not limited as long as the electronic apparatus provides certain image information.

Although the electronic apparatuses shown in FIGS. 8A through 8C are described as electronic apparatuses whose shapes are variable, embodiments are not limited thereto. As in embodiments described below, the display apparatus according to embodiments may be used in an electronic apparatus in which a portion (e.g., a screen) capable of displaying images is fixed.

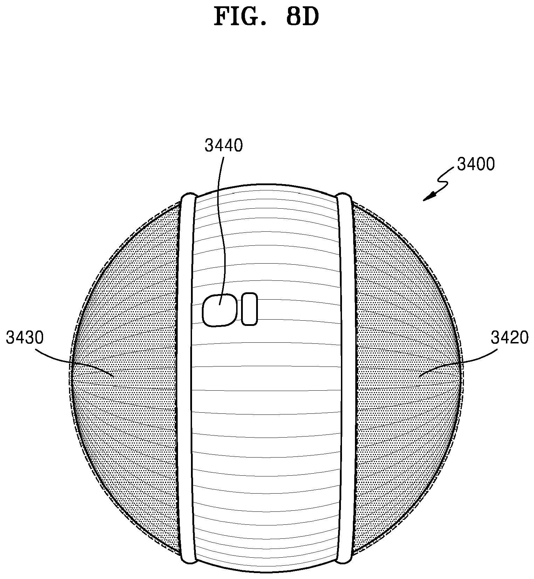

FIG. 8D shows a robot 3400 as an electronic apparatus according to an embodiment. The robot 3400 may recognize an object or movement by using a camera 3440, and may display certain images to a user through displays 3420 and 3430. According to some embodiments, because display apparatuses according to an embodiment may be stretched in various directions as described above, the display apparatuses may be assembled to a body frame having a hemispherical shape, and thus, the robot 3400 may include the displays 3420 and 3430 each having a hemispherical shape.

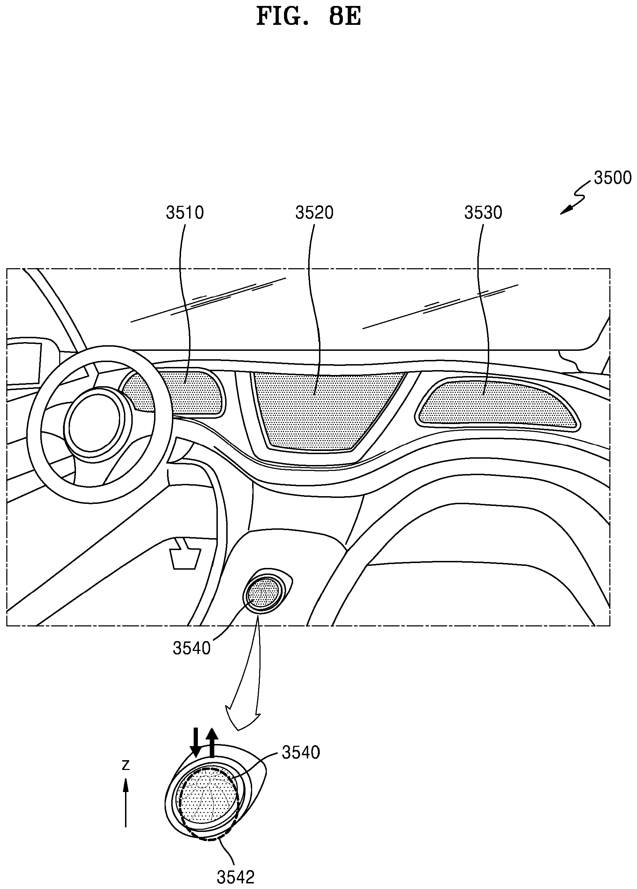

FIG. 8E shows a vehicle display apparatus 3500 as an electronic apparatus according to an embodiment. The vehicle display apparatus 3500 may include a cluster 3510, a center information display ("CID") 3520, and/or a co-driver display 3530. Because the display apparatus according to an embodiment may be stretched in various directions, the display apparatus may be used as the cluster 3510, the CID 3520, and/or the co-driver display 3530 regardless of the shape of an internal frame of the vehicle.

Although it is shown in FIG. 8E that the cluster 3510, the CID 3520, and/or the co-driver display 3530 are separated from each other, embodiments are not limited thereto. According to another embodiment, two or more of the cluster 3510, the CID 3520, and the co-driver display 3530 may be integrally connected to each other.

According to some embodiments, the vehicle display apparatus 3500 may include a button 3540 that may display certain images. Referring to an enlarged view of FIG. 8E, the button 3540 having a hemispherical shape may include an object 3542 that provides the feeling of using the button while moving in the z direction or -z direction, and a display apparatus disposed on the object 3542. According to some embodiments, when the object 3542 has a surface rounded three-dimensionally, the display apparatus may also have a surface rounded three-dimensionally.

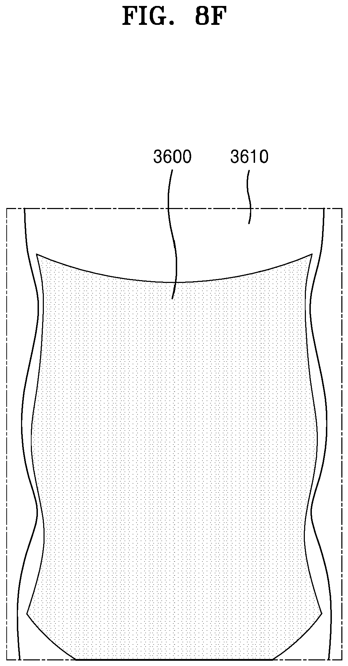

FIG. 8F shows that the electronic apparatus according to an embodiment is an electronic apparatus 3600 for advertising or exhibition. According to some embodiments, the electronic apparatus 3600 for advertising or exhibition may be installed on a structure 3610 such as a wall or pillar. When the structure 3610 includes an uneven surface as shown in FIG. 8F, the electronic apparatus 3600 for advertising or exhibition may also be disposed along the uneven surface of the structure 3610. According to some embodiments, the electronic apparatus 3600 for advertising or exhibition may be installed on the structure 3610 by using a heat shrink film and the like.

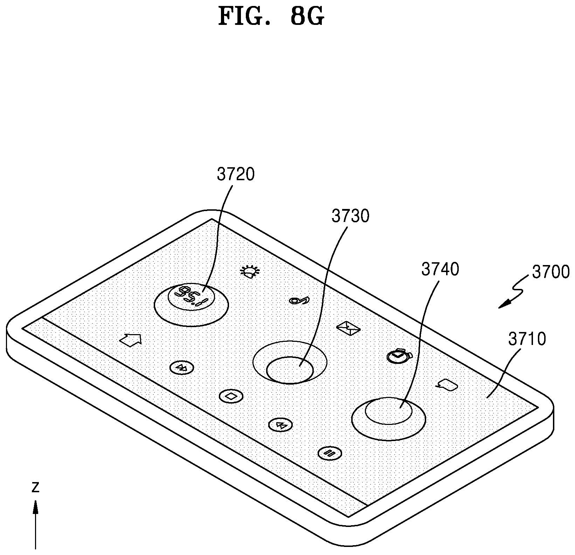

FIG. 8G shows that the electronic apparatus according to an embodiment is a controller 3700. The controller 3700 may include an image type button. For example, the controller 3700 may include first, second, and third bottom regions 3720, 3730, and 3740 in which a partial region of a display 3710 protrudes in a z direction or -z direction (or is recessed in the z direction). According to some embodiments, the first and third button regions 3720 and 3740 may each protrude in the z direction, and the second button region 3730 may protrude in the -z direction (or be recessed in the z direction).

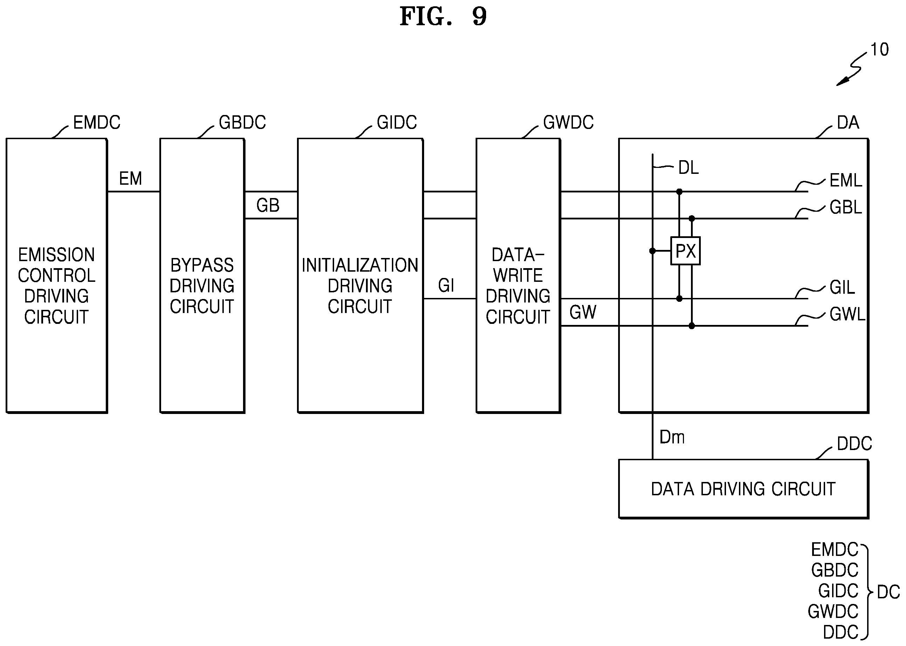

FIG. 9 is a schematic configuration diagram of a display apparatus according to an embodiment.

Referring to FIG. 9, a plurality of pixels PX and signal lines capable of applying electrical signals to the plurality of pixels PX may be located in the display area DA. The signal lines capable of applying electrical signals to the plurality of pixels PX may include a plurality of data lines DL, a plurality of emission control lines EML, a plurality of scan signal lines GWL, and a plurality of initialization control lines GIL, and a plurality of bypass control lines GBL.

A driving circuit DC for providing a signal for driving the pixels PX may be arranged outside the display area DA. The driving circuit DC may include the data driving circuit DDC of FIG. 3 and the gate driving circuit GDC of FIG. 3, and the gate driving circuit GDC of FIG. 3 may include an emission control driving circuit EMDC, a bypass driving circuit GBDC, an initialization driving circuit GIDC, and a data write driving circuit GWDC. The data driving circuit DDC may be disposed adjacent to a lower side surface of the display area DA, and may be connected to the data lines DL to output the data signal Dm to the data lines DL.

The emission control driving circuit EMDC (or a first gate driving circuit), the bypass driving circuit GBDC (or a second gate driving circuit), the initialization driving circuit GIDC (or a third gate driving circuit), and the data write driving circuit GWDC (or a fourth gate driving circuit) may be disposed adjacent to a left or right side surface of the display area DA. The emission control driving circuit EMDC may be connected to the emission control lines EML and may output an emission control signal EM to the emission control lines EML. The bypass driving circuit GBDC may be connected to the bypass control lines GBL and may output the bypass control signal GB to the bypass control lines GBL. The initialization driving circuit GIDC may be connected to the initialization control lines GIL and may output the initialization control signal GI to the initialization control lines GIL. The data write driving circuit GWDC may be connected to the scan signal lines GWL and may output the scan signal GW.

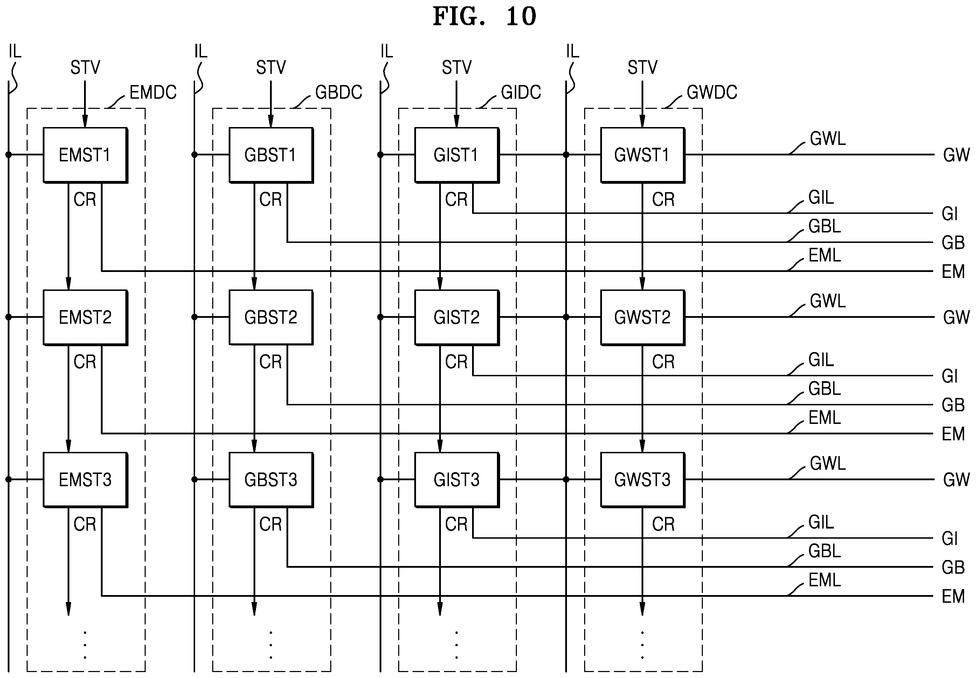

FIG. 10 schematically illustrates a gate driving circuit according to an embodiment. FIG. 10 illustrates a schematic configuration of an emission control driving circuit EMDC, a bypass driving circuit GBDC, an initialization driving circuit GIDC, and a data write driving circuit GWDC.

Referring to FIG. 10, the emission control driving circuit EMDC may be implemented as a shift register including a plurality of emission control stages EMST1, EMST2, EMST3, .... Each of the plurality of emission control stages EMST1, EMST2, EMST3, ... may be a sub-driving circuit. Each of the emission control stages EMST1, EMST2, EMST3, ... may be connected to a corresponding emission control line EML, and may output an emission control signal EM to the corresponding emission control line EML. The first emission control stage EMST1 may output the emission control signal EM in response to an external start signal STV, and each of the remaining emission control stages EMST2, EMST3, ... except for the first emission control stage EMST1 may receive, as a start signal, a carry signal CR output from a previous stage. Each of the emission control stages EMST1, EMST2, EMST3, ... may be connected to a plurality of input lines IL arranged outside the emission control stages EMST1, EMST2, EMST3, ....

The bypass driving circuit GBDC may be implemented as a shift register including a plurality of bypass stages GBST1, GBST2, GBST3, .... Each of the bypass stages GBST1, GBST2, GBST3, ... may be a sub-driving circuit. Each of the bypass stages GBST1, GBST2, GBST3, ... may be connected to a corresponding bypass control line GBL and may output a bypass control signal GB to the corresponding bypass control line GBL. The first bypass stage GBST1 may output a bypass control signal GB in response to an external start signal STV, and each of the remaining bypass stages GBST2, GBST3, ... except for the first bypass stage GBST1 may receive a carry signal CR output from a previous stage as a start signal. Each of the bypass stages GBST1, GBST2, GBST3, ... may be connected to a plurality of input lines IL arranged outside the bypass stages GBST1, GBST2, GBST3, ....

The initialization driving circuit GIDC may be implemented as a shift register including a plurality of initialization stages GIST1, GIST2, GIST3, .... Each of the plurality of initialization stages GIST1, GIST2, GIST3, ... may be a sub-driving circuit. Each of the plurality of initialization stages GIST1, GIST2, GIST3, ... may be connected to a corresponding initialization control line GIL, and may output an initialization control signal GI to the corresponding initialization control line GIL. The first initialization stage GIST1 may output an initialization control signal GI in response to an external start signal STV, and each of the remaining initialization stages GIST2, GIST3, ... except for the first initialization stage GIST1 may receive, as a start signal, a carry signal CR output from a previous stage. Each of the plurality of initialization stages GIST1, GIST2, GIST3, ... may be connected to a plurality of input lines IL arranged outside the initialization stages GIST1, GIST2, GIST3, ....

The data write driving circuit GWDCmay be implemented as a shift register including a plurality of data write stages GWST1, GWST2, GWST3, .... Each of the plurality of data write stages GWST1, GWST2, GWST3, ... may be a sub-driving circuit. Each of the plurality of data write stages GWST1, GWST2, GWST3, ... may be connected to a corresponding scan signal line GWL, and may output a scan signal GW to the corresponding scan signal line GWL. The first data write stage GWST1 may output a scan signal GW in response to an external start signal STV, and each of the remaining data write stages GWST2, GWST3, ... except for the first data write stage GWST1 may receive, as a start signal, a carry signal CR output from a previous stage. Each of the plurality of data write stages GWST1, GWST2, GWST3, ... may be connected to a plurality of input lines IL arranged outside the plurality of data write stages GWST1, GWST2, GWST3, ....

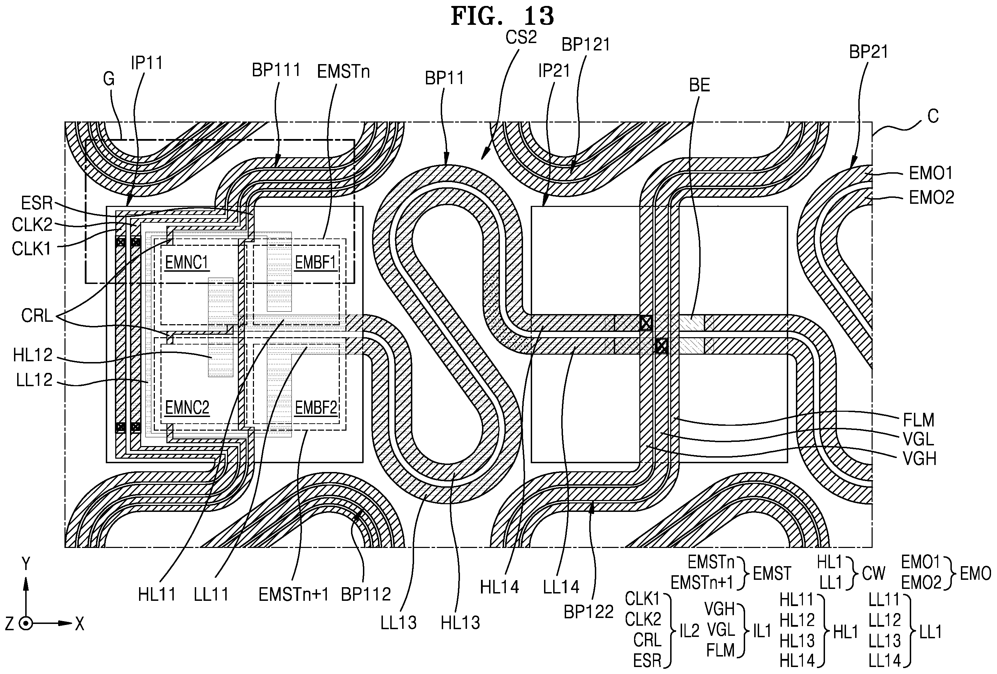

The plurality of input lines IL may be signal lines including a plurality of voltage lines and a plurality of clock lines. In FIG. 10, only one input line is shown for convenience of illustration. The plurality of input lines IL may include a gate high voltage line VGH of FIG. 13, a gate low voltage line VGL of FIG. 13, a start signal line FLM of FIG. 13, a first clock line CLK1 of FIG. 13, a second clock line CLK2 of FIG. 13, a carry line CRL of FIG. 13, and a reset signal line ESR of FIG. 13.

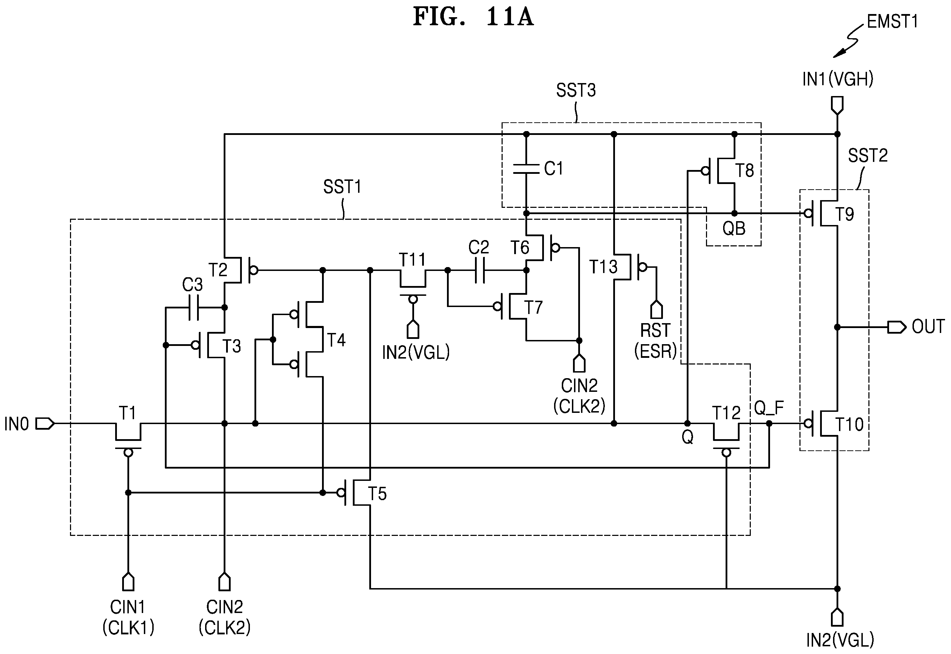

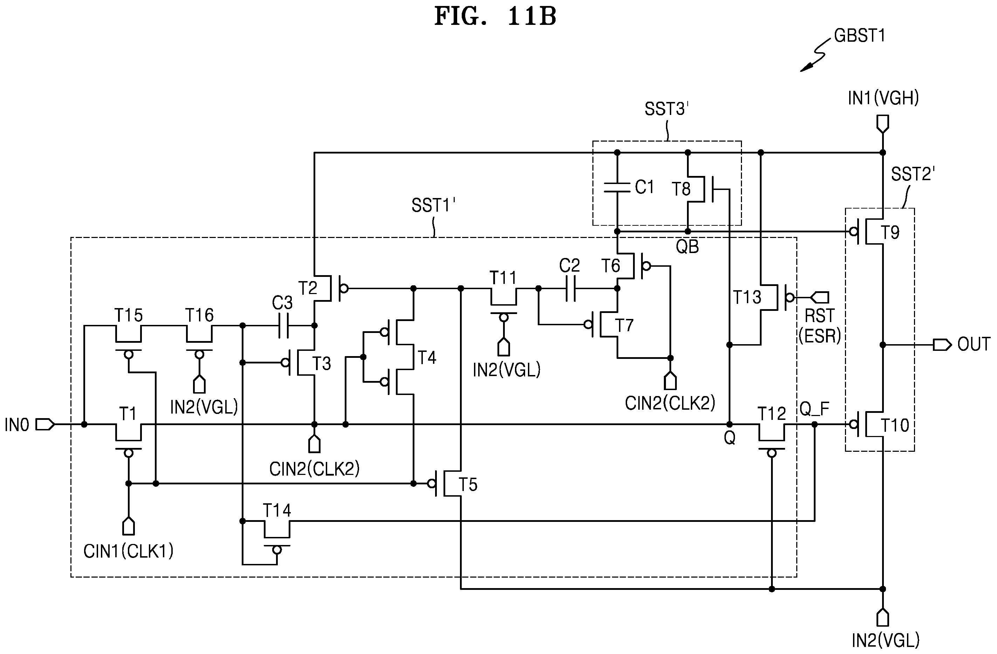

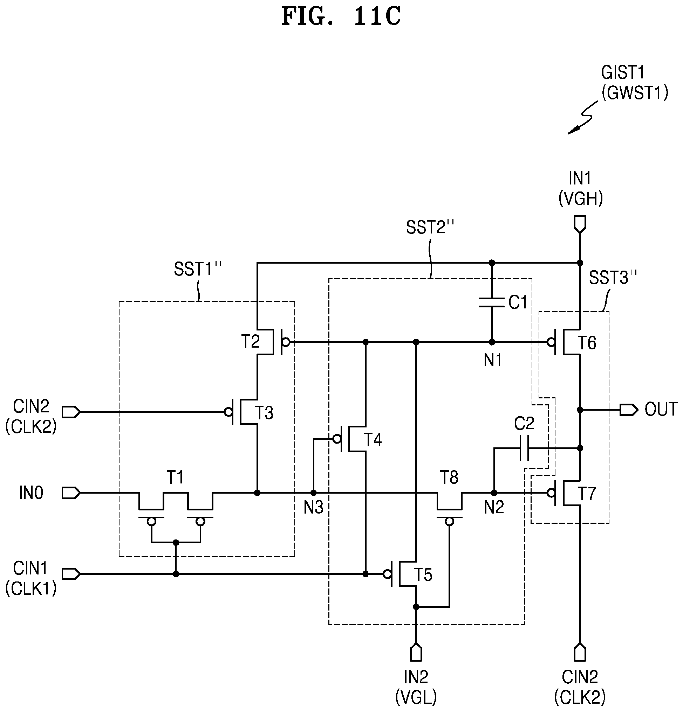

FIG. 11A is a circuit diagram of an embodiment of the first emission control stage EMST1 included in the gate driving circuit of FIG. 10, FIG. 11B is a circuit diagram of an embodiment of the first bypass stage GBST1 included in the gate driving circuit of FIG. 10, and FIG. 11C is a circuit diagram of an embodiment of the first initialization stage GIST1 included in the gate driving circuit of FIG. 10.

First, referring to FIG. 11A, the first emission control stage EMST1 may include an input terminal IN0, a first power input terminal IN1, a second power input terminal IN2, a first clock input terminal CIN1, a second clock input terminal CIN2, a reset terminal RST, and an output terminal OUT. An internal circuit configuration of the first emission control stage EMST1 may be substantially the same as internal circuit configurations of the other emission control stages.

The first power input terminal IN1 may be connected to the gate high voltage line VGH of FIG. 13, the second power input terminal IN2 may be connected to the gate low voltage line VGL of FIG. 13, and the reset terminal RST may be connected to the reset signal line ESR of FIG. 13. The first clock input terminal CIN1 may be connected to the first clock line CLK1, and the second clock input terminal CIN2 may be connected to the second clock line CLK2. The input terminal IN0 may be connected to the start signal line FLM of FIG. 13, and the emission control stages other than the first emission control stage EMST1 may be connected to the carry line CRL of FIG. 13 connected to an output terminal OUT of a previous stage.

The first emission control stage EMST1 may include a node controller SST1, an output unit SST2 (or a buffer unit), and a node sustain unit SST3.

First, the output unit SST2 may be connected to the first power input terminal IN1 and the second power input terminal IN2, and the output unit SST2 may output a gate power supply voltage as a first gate signal to the output terminal OUT, based on a voltage of a second control node Q_F and a voltage of a first control node QB.

The output unit SST2 may include a ninth transistor T9 (or a pull-up transistor) and a tenth transistor T10 (or a pull-down transistor). The ninth transistor T9 may include a first electrode connected to the first power input terminal IN1, a second electrode connected to the output terminal OUT, and a gate electrode connected to the first control node QB.

The tenth transistor T10 may include a first electrode connected to the output terminal OUT, a second electrode connected to the second power input terminal IN2, and a gate electrode connected to the second control node Q_F.

The node controller SST1 may be connected to the input terminal IN0, the first power input terminal IN1, the second power input terminal IN2, the first clock input terminal CIN1, and the second clock input terminal CIN2. The node controller SST1 may control the voltage of the first control node QB and the voltage of the second control node Q_F by using the start signal (or a previous gate signal) provided through the input terminal IN0 and a gate high voltage received from the gate high voltage line VGH.

The node controller SST1 may include first, second, third, fourth, fifth, sixth, seventh, eleventh, twelfth, and thirteenth transistors T1, T2, T3, T4, T5, T6, T7, T11, T12, and T13, a second capacitor C2, and a third capacitor C3.

The first transistor T1 may include a first electrode connected to the input terminal IN0, a second electrode connected to a third control node Q (or a first electrode of the twelfth transistor T12), and a gate electrode connected to the first clock input terminal CIN1. The second transistor T2 may include a first electrode connected to the first power input terminal IN1, a second electrode connected to the first electrode of the third transistor T3, and a gate electrode connected to a first electrode of the eleventh transistor T11.

The third transistor T3 may include the first electrode connected to a second electrode of the second transistor T2, a second electrode connected to the second clock input terminal CIN2, and a gate electrode connected to the second control node Q_F. The third capacitor C3 may be formed between the second electrode of the second transistor T2 and the second control node Q_F, and may include the first electrode connected to the second electrode of the second transistor T2 and a second electrode connected to the second control node Q_F.

The fourth transistor T4 may be configured with a pair of transistors, and thus may be connected to each other in series between the gate electrode of the second transistor T2 and the first clock input terminal CIN1 and may include a gate electrode connected to the third control node Q. The fifth transistor T5 may include a first electrode connected to the gate electrode of the second transistor T2, a second electrode connected to the second power input terminal IN2, and a gate electrode connected to the first clock input terminal CIN1.

The sixth transistor T6 may include a first electrode connected to the first control node QB, a second electrode connected to a first electrode of the seventh transistor T7, and a gate electrode connected to the second clock input terminal CIN2. The seventh transistor T7 may include the first electrode connected to a second electrode of the sixth transistor T6, a second electrode connected to the second clock input terminal CIN2, and a gate electrode connected to a second electrode of the eleventh transistor T11.

The second capacitor C2 may be formed between the second electrode of the eleventh transistor T11 and the second electrode of the sixth transistor T6, and may include a first electrode connected to the second electrode of the eleventh transistor T11 and a second electrode connected to the second electrode of the sixth transistor T6. The eleventh transistor T11 may include the first electrode connected to the gate electrode of the second transistor T2, the second electrode connected to the first electrode of the second capacitor C2, and a gate electrode connected to the second power input terminal IN2.

The twelfth transistor T12 may include a first electrode connected to the third control node Q (or the second electrode of the first transistor T1), a second electrode connected to the second control node Q_F, and a gate electrode connected to the second power input terminal IN2. The thirteenth transistor T13 may include a first electrode connected to the first power input terminal IN1, a second electrode connected to a third control node Q (or the second electrode of the first transistor T1), and a gate electrode connected to the reset terminal RST. The reset terminal RST may be connected to the reset signal line ESR of FIG. 13. When the display apparatus is turned on or off, a low-level reset signal may be applied to the reset terminal RST, the thirteenth transistor T13 may be turned on in response to a logic low-level reset signal, and may perform a reset operation so that a voltage at the second electrode (and the third control node Q) of the transistor T1 has a high level.

The node sustain unit SST3 may maintain the voltage of the first control node QB constant in response to the voltage of the third control node Q. The node sustain unit SST3 may include a first capacitor C1 and an eighth transistor T8.

The first capacitor C1 may be formed between the first power input terminal IN1 and the first control node QB, and may include a first electrode connected to the first power input terminal IN1 and a second electrode connected to the first control node QB. The first capacitor C1 may keep a voltage difference between the first power input terminal IN1 and the first control node QB constant.

The eighth transistor T8 may include a first electrode connected to the first power input terminal IN1, a second electrode connected to the first control node QB, and a gate electrode connected to the third control node Q. The eighth transistor T8 may maintain the voltage of the first control node QB constant in response to the voltage of the third control node Q. For example, when the voltage of the third control node Q has a low level, the eighth transistor T8 may maintain the voltage of the first control node QB at a high level by using a gate high voltage.

Each of the first through thirteenth transistors T1 through T13 may be a P-type transistor. FIG. 11A shows the first through twelfth transistors T1 through T12 as single gate transistors, but embodiments are not limited thereto. For example, to improve reliability, at least one of the first through twelfth transistors T1 through T12 may be implemented as a dual gate transistor.

The emission control signal EM of FIG. 10 output by the first emission control stage EMST1 having such a configuration as described above may be transmitted to a corresponding emission control line EML of FIG. 10 through a corresponding emission control output line. A signal output by the first emission control stage EMST1 may be transmitted to the second emission control stage EMST2 of FIG. 10 located at the next stage to the first emission control stage EMST1 through the carry line CRL of FIG. 13.

Next, referring to FIG. 11B, the first bypass stage GBST1 may include an input terminal IN0, a first power input terminal IN1, a second power input terminal IN2, a first clock input terminal CIN1, a second clock input terminal CIN2, a reset terminal RST, and an output terminal OUT. An internal circuit configuration of the first bypass stage GBST1 may be substantially the same as internal circuit configurations of the other bypass stages.

The first power input terminal IN1 may be connected to the gate high voltage line VGH of FIG. 13, the second power input terminal IN2 may be connected to the gate low voltage line VGL of FIG. 13, and the reset terminal RST may be connected to the reset signal line ESR of FIG. 13. The first clock input terminal CIN1 may be connected to the first clock line CLK1, and the second clock input terminal CIN2 may be connected to the second clock line CLK2. The input terminal IN0 may be connected to the start signal line FLM of FIG. 13, and the bypass stages other than the first bypass stage GBST1 may be connected to the carry line CRL of FIG. 13 connected to an output terminal OUT of a previous stage.

The first bypass stage GBST1 may include a node controller SST1', an output unit SST2' (or a buffer unit), and a node sustain unit SST3'. The first bypass stage GBST1 may be substantially the same as or similar to the first emission control stage EMST1 except for fourteenth, fifteenth, and sixteenth transistors T14, T15, and T16. Thus, repeated descriptions thereof will be omitted.

The first bypass stage GBST1 may further include the fourteenth, fifteenth, and sixteenth transistors T14, T15, and T16.

The fourteenth transistor T14 may include a first electrode connected to the gate electrode of the third transistor T3, a second electrode connected to the second control node Q_F, and a gate electrode connected to the gate electrode of the third transistor T3. In other words, the fourteenth transistor T14 may be diode-connected between the gate electrode of the third transistor T3 and the second control node Q_F. The fourteenth transistor T14 may maintain the voltage of the second control node Q_F constant, regardless of a voltage variation of the gate electrode of the third transistor T3, after a specific point in time.

The fifteenth transistor T15 may include a first electrode connected to the input terminal IN0, a second electrode connected to a first electrode of the sixteenth transistor T16, and a gate electrode connected to the first clock input terminal CIN1. The fifteenth transistor T15 may initialize the gate electrode of the third transistor T3 by using a start signal (or a previous compensation gate signal) provided to the input terminal IN0, in response to a first clock signal provided through the first clock input terminal CIN1.

The sixteenth transistor T16 may include a first electrode connected to the second electrode of the fifteenth transistor T15, a second electrode connected to the gate electrode of the third transistor T3, and a gate electrode connected to the second power input terminal IN2. The sixteenth transistor T16 may reduce or distribute a bias voltage applied to the fifteenth transistor T15 between the input terminal IN0 and the gate electrode of the third transistor T3.

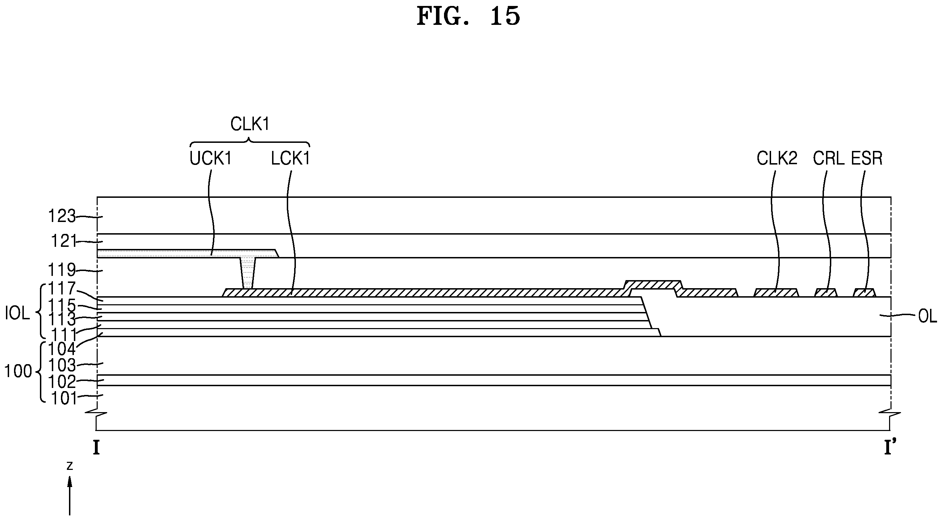

The bypass control signal GB of FIG. 10 output by the first bypass stage GBST1 having such a configuration as described above may be transmitted to a corresponding bypass control line GBL of FIG. 10 through a corresponding bypass output line. A signal output by the first bypass stage GBST1 may be transmitted to the second bypass stage GBST2 of FIG. 10 located at the next stage to the first bypass stage GBST1 through a carry line CRL of FIG. 15.

Next, referring to FIG. 11C, the first initialization stage GIST1 may include an input terminal IN0, a first power input terminal IN1, a second power input terminal IN2, a first clock input terminal CIN1, a second clock input terminal CIN2, and an output terminal OUT. An internal circuit configuration of the first initialization stage GIST1 may be the same as that of the first data write stage GWST1. An internal circuit configuration of the first initialization stage GIST1 may be substantially the same as those of the other initialization stages, and an internal circuit configuration of the first data write stage GWST1 may be substantially the same as those of the other data write stages.

The first power input terminal IN1 may be connected to the gate high voltage line VGH of FIG. 13, and the second power input terminal IN2 may be connected to the gate low voltage line VGL of FIG. 13. The first clock input terminal CIN1 may be connected to the first clock line CLK1, and the second clock input terminal CIN2 may be connected to the second clock line CLK2. The input terminal IN0 may be connected to the start signal line FLM of FIG. 13, and the initialization stages other than the first initialization stage GBST1 may be connected to the carry line CRL of FIG. 13 connected to an output terminal OUT of a previous stage.

The first initialization stage GIST1 may include a first node controller SST1", a second node controller SST2", and an output unit SST3".

The output unit SST3" may control a voltage supplied to the output terminal OUT in correspondence to respective voltages of a first node N1 and a second node N2. To this end, the output unit SST3" may include a sixth transistor T6 and a seventh transistor T7. The output unit SST3" may be driven by a buffer. The sixth transistor T6 and the seventh transistor T7 included in the output unit SST3" may be connected in parallel to each other, as shown in FIG. 11C.

The sixth transistor T6 may be connected between the first power input terminal IN1 connected to the gate high voltage line VGH and the output terminal OUT. The sixth transistor T6 may control connection between the first power input terminal IN1 and the output terminal OUT in correspondence to a voltage applied to the first node N1. The sixth transistor T6 may include a first electrode connected to the first power input terminal IN1, a second electrode connected to the output terminal OUT, and a gate electrode connected to the first node N1.

The seventh transistor T7 may be connected between the second clock input terminal CIN2 connected to the second clock line CLK2 and the output terminal OUT. The seventh transistor T7 may control connection between the output terminal OUT and the second clock input terminal CIN2 in correspondence to a voltage applied to the second node N2. The seventh transistor T7 may include a first electrode connected to the output terminal OUT, a second electrode connected to the second clock input terminal CIN2, and a gate electrode connected to the second node N2.

The first node controller SST1" may control a voltage of a third node N3 in correspondence to signals supplied to the input terminal IN0, the first clock input terminal CIN1, and the second clock input terminal CIN2. To this end, the first node controller SST1" may include a first transistor T1, a second transistor T2, and a third transistor T3.

The first transistor T1 may be connected between the input terminal IN0 to which the start signal (or a previous gate signal) is applied and the third node N3. The first transistor T1 may control connection between the input terminal IN0 and the third node N3 through the first clock signal supplied to the first clock input terminal CIN1. The first transistor T1 may have a double gate structure to prevent leakage current. The first transistor T1 may be configured with a pair of transistors, and may be connected in series between the input terminal IN0 and the third node N3 and may include a gate electrode connected to the first clock input terminal CIN1.

The second transistor T2 and the third transistor T3 may be connected in series between the third node N3 and the first power input terminal IN1. The third transistor T3 may be connected between the second transistor T2 and the third node N3. The first transistor T1 may control connection between the input terminal IN0 and the third node N3 through a second clock signal supplied to the second clock input terminal CIN2. The third transistor T3 may include a first electrode connected to the second electrode of the second transistor T2, a second electrode connected to the third node N3, and a gate electrode connected to the second clock input terminal CIN2.

The second transistor T2 may be connected between the third transistor T3 and the first power input terminal IN1. The second transistor T2 may control connection between the third transistor T3 and the first power input terminal IN1 in correspondence to the voltage of the first node N1. The second transistor T2 may include a first electrode connected to the first power input terminal IN1, a second electrode connected to the first electrode of the third transistor T3, and a gate electrode connected to the first node N1.

The second node controller SST2" may control the voltage of the first node N1 in correspondence to respective voltages of the first clock input terminal CIN1 and the third node N3. To this end, the second node controller SST2" may include an eighth transistor T8, a fourth transistor T4, a fifth transistor T5, a first capacitor C1, and a second capacitor C2.

The first capacitor C1 may be connected between the first node N1 and the first power input terminal IN1. The first capacitor C1 may be charged with a voltage applied to the first node N1. The first capacitor C1 may include a first electrode connected to the first node N1 and a second electrode connected to the first power input terminal IN1. The first electrode of the first capacitor C1 may be connected to the gate electrode of the second transistor T2 and the gate electrode of the sixth transistor T6.

The second capacitor C2 may be connected between the second node N2 and the output terminal OUT. The second capacitor C2 is charged with a voltage corresponding to turn-on and turn-off operations of the seventh transistor T7. The second capacitor C2 may include a first electrode connected to the second node N2 and a second electrode connected to the output terminal OUT. The first electrode of the second capacitor C2 may be electrically connected to the second electrode of the eighth transistor T8.

The fourth transistor T4 may be connected between the first node N1 and the first clock input terminal CIN1. The fourth transistor T4 may control connection between the first node N1 and the first clock input terminal CIN1 in correspondence to the voltage of the third node N3. The fourth transistor T4 may include a first electrode connected to the first clock input terminal CIN1, a second electrode connected to the first node N1, and a gate electrode connected to the third node N3.

The fifth transistor T5 may be located between the second power input terminal IN2 connected to the gate low voltage line VGL and the first node N1. The fifth transistor T5 may control connection between the first node N1 and the second power input terminal IN2 in correspondence to the first clock signal of the first clock input terminal CIN1. The fifth transistor T5 may include a first electrode connected to the first node N1, a second electrode connected to the second power input terminal IN2, and a gate electrode connected to the first clock input terminal CIN1.

The eighth transistor T8 may be located between the third node N3 and the second node N2. The eighth transistor T8 may maintain electrical connection between the third node N3 and the second node N2 while maintaining a turn-on state. The eighth transistor T8 may limit a voltage drop width of the third node N3 in correspondence to the voltage of the second node N2. The eighth transistor T8 may include a first electrode connected to the third node N3, a second electrode connected to the second node N2, and a gate electrode connected to the second power input terminal IN2.

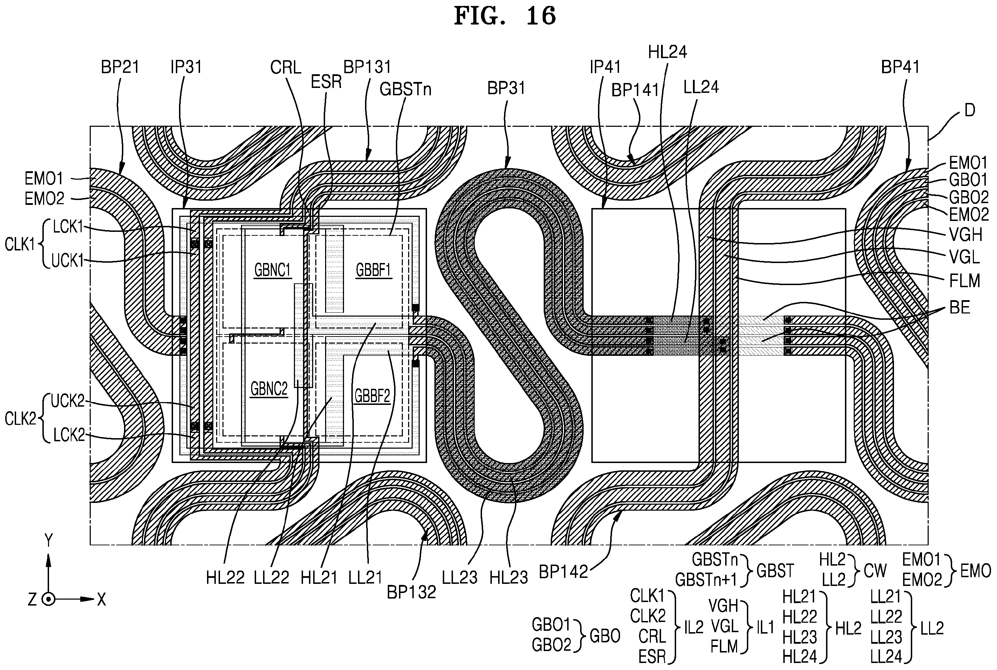

The initialization control signal GI of FIG. 10 output by the first initialization stage GIST1 having such a configuration as described above may be transmitted to a corresponding initialization control line GIL of FIG. 10 through a corresponding initialization output line. A signal output by the first initialization stage GIST1 may be transmitted to the second initialization stage GIST2 of FIG. 10 located at the next stage to the first initialization stage GIST1 through a carry line CRL of FIG. 16.

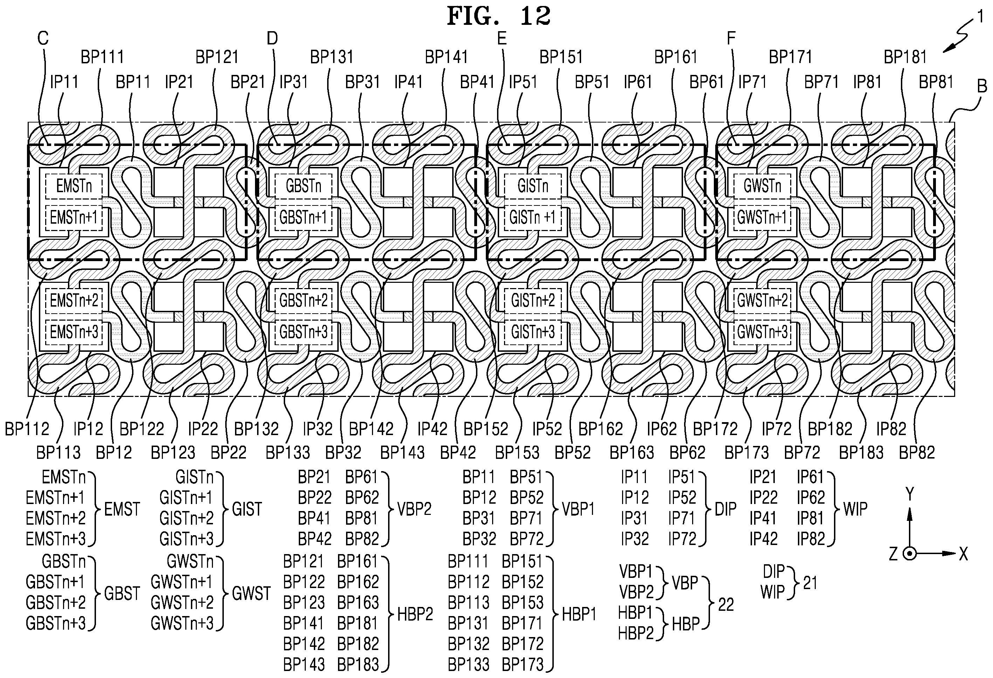

FIG. 12 is a schematic magnified plan view of a portion of a display apparatus according to an embodiment, namely, a magnified view of a region B of FIG. 3.

Referring to FIG. 12, a plurality of peripheral island portions 21 and a plurality of peripheral bridge portions 22 may be disposed in the non-display area NDA of FIG. 3. The plurality of peripheral island portions 21 may be arranged to be spaced apart from each other, and a peripheral bridge portion 22 may connect adjacent peripheral island portions 21 to each other. In this specification, adjacent peripheral island portions 21 being connected to each other by a peripheral bridge portion 22 refers to the peripheral bridge portion 22 extending between the adjacent peripheral island portions 21 and the peripheral island portion 21 and the plurality of peripheral bridge portions 22 being provided integrally.

The peripheral island portions 21 may include a driver island portion DIP where a driver stage may be placed, and a wiring island portion WIP where input lines may be arranged. In detail, one or more driver stages may be arranged in the driver island portion DIP, and some of input lines for applying signals or voltages to the driver stages may be arranged in the wiring island portion WIP. However, not all of the input lines for applying signals or voltages to the driver stages are arranged in the wiring island portion WIP. Some of the input lines may be arranged in the wiring island portion WIP, and the remaining input lines may be arranged in the driver island portion DIP. Some of a plurality of input lines arranged on the wiring island portion WIP will now be referred to as first input lines IL1 of FIG. 13, and the remaining ones among the plurality of input lines arranged on the driver island portion DIP will now be referred to as second input lines IL2 of FIG. 13.

The driver island portion DIP and the wiring island portion WIP may be arranged alternately in a first row along the first direction (e.g., the x direction), and the driver island portion DIP and the wiring island portion WIP may be arranged in a second row parallel to the first row in the same manner as in the first row. In other words, the driver island portion DIP may be continuously arranged in a first column along the second direction (e.g., the y direction), and the wiring island portion WIP may be continuously arranged in a second column parallel to the first column. As a plurality of wiring island portions WIP are continuously arranged in the second direction, a plurality of first input lines IL1 of FIG. 13 may extend in the second direction (e.g., the y-direction). Similarly, as a plurality of driver island portions DIP are continuously arranged in the second direction, a plurality of second input lines IL2 of FIG. 13 may extend in the second direction (e.g., the y-direction).

For example, the driver island portion DIP may include a 1-1 island portion IP11, a 1-2 island portion IP12, a 3-1 island portion IP31, a 3-2 island portion IP32, a 5-1 island portion IP51, a 5-2 island portion IP52, a 7-1 island portion IP71, and a 7-2 island portion IP72. The wiring island portion WIP may include a 2-1 island portion IP21, a 2-2 island portion IP22, a 4-1 island portion IP41, a 4-2 island portion IP42, a 6-1 island portion IP61, a 6-2 island portion IP62, an 8-1 island portion IP81, and an 8-2 island portion IP82.

The peripheral bridge portion 22 is a portion that connects adjacent peripheral island portions 21 to form an elongated structure, and may have a serpentine shape. In the peripheral bridge portion 22, a plurality of output lines that transmit the output signal of a driver and a plurality of connection lines that are connected to an input line and transmit an input signal may be arranged.

The peripheral bridge portion 22 may include a vertical bridge portion VBP and a horizontal bridge portion HBP. In detail, the vertical bridge portion VBP is a peripheral bridge portion 22 connecting the driver island portion DIP to the wiring island portion WIP, and may have an 'S' shape based on the first direction (e.g., the x direction). The horizontal bridge portion HBP is a peripheral bridge portion 22 connecting adjacent driver island portions DIP to each other or adjacent wiring island portions WIP to each other, and may have an 'S' shape based on the second direction (e.g., the y direction). In other words, the horizontal bridge portion HBP may have a shape that is rotated 90 degrees from the shape of the vertical bridge portion VBP. As used herein, the terminologies of "horizontal" and "vertical" are used to mean that a direction in which islands portions connected by the horizontal bridge portion are arranged is different from a direction in which islands portions connected by the vertical bridge portion are arranged, not to mean that each bridge portion is geometrically horizontal or vertical.

The vertical bridge portion VBP may include a first vertical bridge portion VBP1 and a second vertical bridge portion VBP2. The first vertical bridge portion VBP1 may be a peripheral bridge portion 22 disposed between a specific driver island portion DIP and a wiring island portion WIP where input lines for applying signals to the specific driver island portion DIP are arranged. The second vertical bridge portion VBP2 may be disposed between a specific driver island portion DIP and a wiring island portion WIP where input lines for applying signals to a driver island portion DIP other than the specific driver island portion DIP are arranged. In other words, the first vertical bridge portion VBP1 may be a peripheral bridge portion 22 disposed between a specific driver island portion DIP and a wiring island portion WIP associated with the specific driver island portion DIP, and the second vertical bridge portion VBP2 may be a peripheral bridge portion 22 disposed between a specific driver island portion DIP and a wiring island portion WIP not associated with the specific driver island portion DIP.

Accordingly, the first vertical bridge portion VBP1 may have both the output lines of the driver and connection lines of the input lines arranged, while the second vertical bridge portion VBP2 may have only the output lines of the driver arranged. The first vertical bridge portion VBP1 and the second vertical bridge portion VBP2 may be alternately arranged in the first direction. For example, the first vertical bridge portion VBP1 may include a 1-1 bridge portion BP11, a 1-2 bridge portion BP12, a 3-1 bridge portion BP31, a 3-2 bridge portion BP32, a 5-1 bridge portion BP51, a 5-2 bridge portion BP52, a 7-1 bridge portion BP71, and a 7-2 bridge portion BP72. The second vertical bridge portion VBP2 may include a 2-1 bridge portion BP21, a 2-2 bridge portion BP22, a 4-1 bridge portion BP41, a 4-2 bridge portion BP42, a 6-1 bridge portion BP61, a 6-2 bridge portion BP62, an 8-1 bridge portion BP81, and an 8-2 bridge portion BP82.

The horizontal bridge portion HBP may include a first horizontal bridge portion HBP1 and a second horizontal bridge portion HBP2. The first horizontal bridge part HBP1 may be a peripheral bridge portion 22 that connects adjacent driver island portions DIP to each other. The second horizontal bridge part HBP2 may be a peripheral bridge portion 22 that connects adjacent wiring island portions WIP to each other. Thus, the first horizontal bridge portion HBP1 and the second horizontal bridge portion HBP2 may be alternately arranged in the first direction (e.g., the x direction).

For example, the first horizontal bridge portion HBP1 may include an 11-1 bridge portion BP111, an 11-2 bridge portion BP112, an 11-3 bridge portion BP113, a 13-1 bridge portion BP131, a 13-2 bridge portion BP132, a 13-3 bridge portion BP133, a 15-1 bridge portion BP151, a 15-2 bridge portion BP152, a 15-3 bridge portion BP153 , a 17-1 bridge portion BP171, a 17-2 bridge portion BP172, and a 17-3 bridge portion BP173. The second horizontal bridge portion HBP2 may include an 12-1 bridge portion BP121, an 12-2 bridge portion BP122, a 12-3 bridge portion BP123, a 14-1 bridge portion BP141, a 14-2 bridge portion BP142, a 14-3 bridge portion BP143, a 16-1 bridge portion BP161, a 16-2 bridge portion BP162, a 16-3 bridge portion BP163 , a 18-1 bridge portion BP181, a 18-2 bridge portion BP182, and a 18-3 bridge portion BP183.

In the gate driving circuit GDC of FIG. 3 disposed in the driver island portion DIP, the emission control driving circuit EMDC of FIG. 10, the bypass driving circuit GBDC of FIG. 10, the initialization driving circuit GIDC of FIG. 10, and the data write driving circuit GWDC of FIG. 10 may be arranged in this order from the outside toward the display area DA of FIG. 3. As shown in FIG. 12, when a size and/or width of the peripheral island portion 21 is greater than a size and/or width of the main island portion 11 as in FIG. 4, two driver stages may be disposed in the driver island portion DIP.

For example, emission control stages may be disposed in the 1-1 island portion IP11 and the 1-2 island portion IP12. In detail, an n-th emission control stage EMSTn and an (n+1)th emission control stage EMSTn+1 (where n may be a natural number equal to or greater than 1) may be arranged in the 1-1 island portion IP11, and an (n+2)th emission control stage EMSTn+2 and an (n+3)th emission control stage EMSTn+3 may be arranged in the 1-2 island portion IP12.

Similarly, bypass stages may be disposed in the 3-1 island portion IP31 and the 3-2 island portion IP32. In detail, an n-th bypass stage GBSTn and an (n+1)th bypass stage GBSTn+1 may be disposed in the 3-1 island portion IP31, and an (n+2)th bypass stage GBSTn+2 and an (n+3)th bypass stage GBSTn+3 may be disposed in the 3-2 island portion IP32.

Initialization stages may be disposed in the 5-1 island portion IP51 and the 5-2 island portion IP52. In detail, an n-th initialization stage GISTn and an (n+1)th initialization stage GISTn+1 may be disposed in the 5-1 island portion IP51, and an (n+2)th initialization stage GISTn+2 and an (n+3)th initialization stage GISTn+3 may be disposed in the 5-2 island portion IP52.

Data write stages may be disposed in the 7-1 island portion IP71 and the 7-2 island portion IP72. In detail, an n-th data write stage GWSTn and an (n+1)th data write stage GWSTn+1 may be disposed in the 7-1 island portion IP71, and an (n+2)th data write stage GWSTn+2 and an (n+3)th data write stage GWSTn+3 may be disposed in the 7-2 island portion IP72.

As described above, input lines for applying signals or voltages to each driver stage may include first input lines IL1 (see FIG. 13) disposed in the wiring island portion WIP and second input lines IL2 (see FIG. 13) disposed in the driver island portion DIP. The first input lines IL1 (see FIG. 12) may be disposed in the wiring island portion WIP, and may extend by also being disposed in the second horizontal bridge portion HBP2. The second input lines IL2 (see FIG. 12) may be disposed in the driver island portion DIP, and may extend by also being disposed in the first horizontal bridge portion HBP1.

For example, some of the input lines for supplying signals or voltages to the emission control stage EMST may extend through the 12-1 bridge portion BP121, the 12-2 bridge portion BP122, and the 12-3 bridge portion BP123, and the remaining ones may extend through the 11-1 bridge portion BP111, the 11-2 bridge portion BP112, and the 11-3 bridge portion BP113. Similarly, some of the input lines for supplying signals or voltages to the bypass stage GBST may extend through the 14-1 bridge portion BP141, the 14-2 bridge portion BP142, and the 14-3 bridge portion BP143, and the remaining ones may extend through the 13-1 bridge portion BP131, the 13-2 bridge portion BP132, and the 13-3 bridge portion BP133. Some of the input lines for supplying signals or voltages to the initialization stage GIST may extend through the 16-1 bridge portion BP161, the 16-2 bridge portion BP162, and the 16-3 bridge portion BP163, and the remaining ones may extend through the 15-1 bridge portion BP151, the 15-2 bridge portion BP152, and the 15-3 bridge portion BP153. Some of the input lines for supplying signals or voltages to the data write stage GWST may extend through the 18-1 bridge portion BP181, the 18-2 bridge portion BP182, and the 18-3 bridge portion BP183, and the remaining ones may extend through the 17-1 bridge portion BP171, the 17-2 bridge portion BP172, and the 17-3 bridge portion BP173.

An output line that transmits an output signal of each driver stage may extend toward the display area DA (see FIG. 3) in the first direction (e.g., the x direction). Accordingly, the output line may be arranged in the same row as a driver island portion DIP where a connected driver stage is disposed, and may extend through a plurality of vertical bridge portions VBP more adjacent to the display area DA (see FIG. 3) than the driver island portion DIP is.

For example, an emission control output line of the n-th emission control stage EMSTn may be arranged in the same row as the 1-1 island portion IP11, but may extend through the 1-1 bridge portion BP11, the 2-1 bridge portion BP21, the 3-1 bridge portion BP31, the 4-1 bridge portion BP41, the 5-1 bridge portion BP51, the 6-1 bridge portion BP61, the 7-1 bridge portion BP71, and the 8-1 bridge portion BP81 more adjacent to the display area DA (see FIG. 3) than the 1-1 island portion IP11 is. Similarly, a bypass output line of the n-th bypass stage GBSTn may be arranged in the same row as the 3-1 island portion IP31, but may extend through the 3-1 bridge portion BP31, the 4-1 bridge portion BP41, the 5-1 bridge portion BP51, the 6-1 bridge portion BP61, the 7-1 bridge portion BP71, and the 8-1 bridge portion BP81 more adjacent to the display area DA (see FIG. 3) than the 3-1 island portion IP31 is. An initialization output line of the n-th initialization stage GISTn may be arranged in the same row as the 5-1 island portion IP51, but may extend through the 5-1 bridge portion BP51, the 6-1 bridge portion BP61, the 7-1 bridge portion BP71, and the 8-1 bridge portion BP81 more adjacent to the display area DA (see FIG. 3) than the 5-1 island portion IP51 is. A data write output line of the n-th data write stage GWSTn may be arranged in the same row as the 7-1 island portion IP71, but may be connected through the 7-1 bridge portion BP71, and the 8-1 bridge portion BP81 more adjacent to the display area DA (see FIG. 3) than the 7-1 island portion IP71 is.

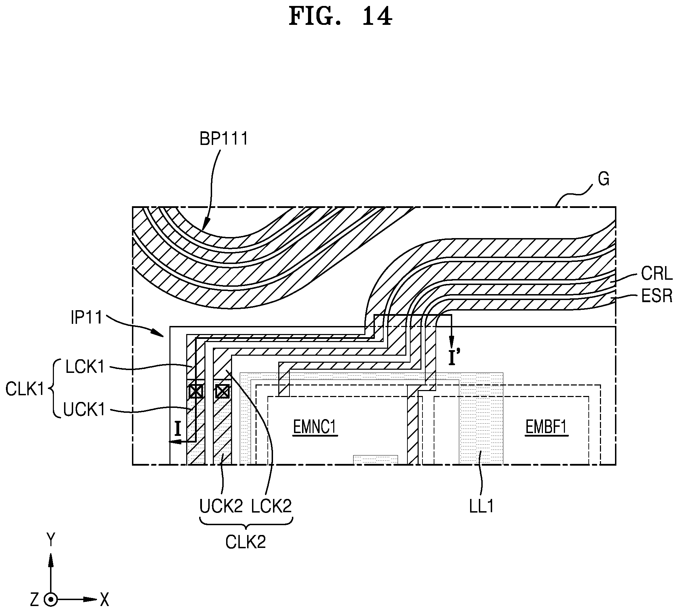

FIG. 13 is a schematic magnified plan view of a portion of a display apparatus according to an embodiment, that is, a magnified view of a region C of FIG. 12. FIG. 14 is a schematic magnified plan view of a portion of a display apparatus according to an embodiment, that is, a magnified view of a region G of FIG. 13. FIG. 15 is a cross-sectional view of a portion of a display apparatus according to an embodiment, and corresponds to a cross-section taken along line I-I' of FIG. 14.

First, referring to FIG. 13, the n-th emission control stage EMSTn and the (n+1)th emission control stage EMSTn+1 may be arranged in the 1-1 island portion IP11. Each light emission control stage EMST may include a node controller and a buffer transistor. For example, the n-th emission control stage EMSTn may include a first emission node controller EMNC1 and a first emission buffer transistor EMBF1, and the (n+1t)th emission control stage EMSTn+1 may include a second emission node controller EMNC2 and a second emission buffer transistor EMBF2. Each of the first emission node controller EMNC1 and the second emission node controller EMNC2 may include a plurality of transistors and capacitors, and may control the voltage of a node by using a start signal, etc. provided through an input terminal. Each of the first emission buffer transistor EMBF1 and the second emission buffer transistor EMBF2 may be a transistor disposed to isolate a signal source from a circuit that is driven by the signal source. Each of the n-th emission control stage EMSTn and the (n+1)th emission control stage EMSTn+1 may have substantially the same circuit configuration as the first emission control stage EMST1 (see FIG. 11A) shown in FIG. 11A.

Each of the n-th emission control stage EMSTn and the (n+1)th emission control stage EMSTn+1 may apply the emission control signal EM of FIG. 10 to the display area DA of FIG. 3 through an emission control output line EMO. In detail, the emission control signal EM output by the emission control stage EMST may be first transmitted to the emission control output line EMO, and then may be supplied to the pixels of the display area DA of FIG. 3 through the emission control line EML of FIG. 10 connected to the emission control output line EMO.

The emission control output line EMO may include a first emission control output line EMO1 connected to the n-th emission control stage EMSTn and a second emission control output line EMO2 connected to the (n+1)th emission control stage EMSTn+1. In other words, one output line may be disposed per stage. According to another embodiment, when one emission control stage EMST is disposed on the 1-1 island portion IP11, one emission control output line EMO may be disposed on the 1-1 bridge portion BP11.

The emission control output line EMO may extend through the 1-1 bridge portion BP11, the 2-1 island portion IP21, and the 2-1 bridge portion BP21. The emission control output line EMO may extend through a bridge electrode BE in an area overlapping a plurality of first input lines IL1 disposed on the 2-1 island portion IP21. Although not shown in FIG. 13, the emission control output line EMO may extend toward the display area DA of FIG. 3 through the bypass driving circuit GBDC of FIG. 10, the initialization driving circuit GIDC of FIG. 10, and the data write driving circuit GWDC of FIG. 10. The emission control output line EMO may be disposed on substantially the same layer as the layer on which the source electrode SE of FIG. 7A of the main island portion 11 of FIG. 4 is disposed.

In the non-display area NDA of FIG. 3, input lines that apply signals or voltages to the emission control stage EMST may be arranged. The input lines may include first input lines IL1 disposed in the wiring island portion WIP of FIG. 12 and second input lines IL2 disposed in the driver island portion DIP of FIG. 12. In other words, among the input lines necessary for the emission control stage EMST, the first input lines IL1 may be arranged on the 2-1 island portion IP21, and the second input lines IL2 may be arranged on the 1-1 island portion IP11. Each of the first input lines IL1 and the second input lines IL2 may extend in the second direction (e.g., the y direction). Accordingly, the first input lines IL1 may extend through the 12-1 bridge portion BP121 and the 12-2 bridge portion BP122, and the second input lines IL2 may extend through the 11-1 bridge portion BP111 and the 11-2 bridge portion BP112.

According to an embodiment, the first input lines IL1 may include a gate high voltage line VGH, a gate low voltage line VGL, and a start signal line FLM. The gate high voltage line VGH and the gate low voltage line VGL are lines that apply a driving voltage to the emission control stage EMST. The gate high voltage line VGH may apply a gate-off voltage, and the gate low voltage line VGL may apply a gate-on voltage. The start signal line FLM may be a line that applies a start signal to the first emission control stage EMST1 of FIG. 10.

According to an embodiment, the second input lines IL2 may include a first clock line CLK1, a second clock line CLK2, a carry line CRL, and a reset signal line ESR. The first clock line CLK1 and the second clock line CLK2 are lines that transmit a first clock signal and a second clock signal, respectively, and each of the first clock signal and the second clock signal may be a square wave signal that repeats a logic high level and a logic low level. The carry line CRL is a line for transmitting a carry signal, and the carry signal may be a start signal for the next stage. For example, each of the remaining emission control stages EMST except for the first emission control stage EMST of FIG. 10 may receive a carry signal output from a previous stage as a start signal. The reset signal line ESR is a line that transmits a reset signal, and the reset signal may be a signal that is activated at a low level when the display apparatus 1 of FIG. 11 is powered on or reset.

Because the second input lines IL2 may be disposed adjacent to the emission control stage EMST in the 1-1 island portion IP11, it may be easy to transmit signals. On the other hand, because the first input lines IL1 are disposed in the 2-1 island portion IP21 spaced apart from the 1-1 island portion IP11, an additional connection line CW may be needed. The connection line CW may include a high voltage connection line HL1 connected to the gate high voltage line VGH among the first input lines IL1, and a low voltage connection line LL1 connected to the gate low voltage line VGL among the first input lines IL1. Because the start signal line FLM among the first input lines IL1 does not need to transmit signals to the n-th emission control stage EMSTn and the (n+1)th emission control stage EMSTn+1, the start signal line FLM may not be connected to the connection line CW.

The high voltage connection line HL1 may include a first portion HL11, a second portion HL12, a third portion HL13, and a fourth portion HL14. The first portion HL11 of the high voltage connection line HL1, the second portion HL12 of the high voltage connection line HL1, the third portion HL13 of the high voltage connection line HL1, and the fourth portion HL14 of the high voltage connection line HL1 may be integrally formed to be connected to one another. The first portion HL11 of the high voltage connection line HL1, the second portion HL12 of the high voltage connection line HL1, the third portion HL13 of the high voltage connection line HL1, and the fourth portion HL14 of the high voltage connection line HL1 may be arranged in the same layer.

The fourth portion HL14 of the high voltage connection line HL1 may refer to a portion of the high voltage connection line HL1 that is disposed in the wiring island portion WIP of FIG. 12. For example, the fourth portion HL14 of the high voltage connection line HL1 may be disposed in the 2-1 island portion IP21. The fourth portion HL14 of the high voltage connection line HL1 is directly connected to the gate high voltage line VGH, and may be connected to the gate high voltage line VGH through a contact hole. Because the gate high voltage line VGH extends in the second direction (e.g., the y direction), the fourth portion HL14 of the high voltage connection line HL1 may extend in the first direction (e.g., the x direction) that intersects the gate high voltage line VGH.

The third portion HL13 of the high voltage connection line HL1 may refer to a portion of the high voltage connection line HL1 that is disposed in the first vertical bridge portion VBP1. For example, the third portion HL 13 of the high voltage connection line HL1 may be disposed in the 1-1 bridge portion BP11. The third portion HL 13 of the high voltage connection line HL1 may be disposed between the driver island portion DIP of FIG. 12 and the wiring island portion WIP of FIG. 12, and may connect the first portion HL11 of the high voltage connection line HL1 to the fourth portion HL14 of the high voltage connection line HL1. The third portion HL13 of the high voltage connection line HL1 may have a serpentine shape or an 'S 'shape. The third portion HL13 of the high voltage connection line HL1 may overlap the above-described emission control output line EMO but may be arranged in a different layer from the layer in which the emission control output line EMO is arranged.

The first portion HL11 of the high voltage connection line HL1 and the second portion HL12 of the high voltage connection line HL1 may refer to portions of the high voltage connection line HL1 that is disposed in the driver island portion DIP of FIG. 12. For example, the first portion HL11 of the high voltage connection line HL1 and the second portion HL12 of the high voltage connection line HL1 may be disposed in the 1-1 island portion IP11. The first portion HL11 of the high voltage connection line HL1 may be a portion extending in the first direction (e.g., the x direction) on the 1-1 island portion IP11, and the second portion HL12 of the high voltage connection line HL1 may be a portion branched from the first portion HL11 of the high voltage connection line HL1 and extending in the second direction (e.g., the y direction).

In detail, the high voltage connection line HL1 may include a portion having a 'T' shape on the 1-1 island portion IP11 in a plan view. The 'T' shape in a plan view may be included through the first portion HL11 of the high voltage connection line HL1 and the second portion HL12 of the high voltage connection line HL1. According to an embodiment, the first portion HL11 of the high voltage connection line HL1 may extend in the first direction (e.g., the x direction) from the 1-1 bridge portion BP11 toward a center of the 1-1 island portion IP11. The second portion HL12 of the high voltage connection line HL1 may branch from the first portion HL11 of the high voltage connection line HL1 and extend in the second direction (e.g., the y direction). In this case, the second portion HL12 of the high voltage connection line HL1 may follow the second direction (e.g., the y direction) and may extend in both directions. For example, the second portion HL12 of the high voltage connection line HL1 may vertically extend from the first portion HL11 of the high voltage connection line HL1 in a +y direction and a -y direction.

The second portion HL12 of the high voltage connection line HL1 may be electrically connected to stages disposed in the driver island portion DIP of FIG. 12. As described above, one stage or two stages may be disposed in the driver island portion DIP of FIG. 12. For example, the n-th emission control stage EMSTn and the (n+1)th emission control stage EMSTn+1 may be arranged in the 1-1 island portion IP11. Because the second portion HL12 of the high voltage connection line HL1 extends vertically from the first portion HL11 of the high voltage connection line HL1, the second portion HL12 of the high voltage connection line HL1 may directly transmit voltages to the n-th emission control stage EMSTn and the (n+1)th emission control stage EMSTn+1.

The low voltage connection line LL1 may include a first portion LL11, a second portion LL12, a third portion LL13, and a fourth portion LL14. The first portion LL11 of the low voltage connection line LL1, the second portion LL12 of the low voltage connection line LL1, the third portion LL13 of the low voltage connection line LL1, and the fourth portion LL14 of the low voltage connection line LL1 may be integrally formed to be connected to one another. The first portion LL11 of the low voltage connection line LL1, the second portion LL12 of the low voltage connection line LL1, the third portion LL13 of the low voltage connection line LL1, and the fourth portion LL14 of the low voltage connection line LL1 may be arranged in the same layer.

The fourth portion LL14 of the low voltage connection line LL1 may refer to a portion of the low voltage connection line LL1 that is disposed in the wiring island portion WIP of FIG. 12. For example, the fourth portion LL14 of the low voltage connection line LL1 may be disposed in the 2-1 island portion IP21. The fourth portion LL14 of the low voltage connection line LL1 is directly connected to the gate low voltage line VGL, and may be connected to the gate low voltage line VGL through a contact hole. Because the gate low voltage line VGL extends in the second direction (e.g., the y direction), the fourth portion LL14 of the low voltage connection line LL1 may extend in the first direction (e.g., the x direction) that intersects the gate low voltage line VGL.

The third portion LL13 of the low voltage connection line LL1 may refer to a portion of the low voltage connection line LL1 that is disposed in the first vertical bridge portion VBP1. For example, the third portion LL13 of the low voltage connection line LL1 may be disposed in the 1-1 bridge portion BP11. The third portion LL13 of the low voltage connection line LL1 may be disposed between the driver island portion DIP of FIG. 12 and the wiring island portion WIP of FIG. 12, and may connect the first portion LL11 of the low voltage connection line LL1 to the fourth portion LL14 of the low voltage connection line LL1. The third portion LL13 of the low voltage connection line LL1 may have a serpentine shape or an 'S 'shape. The third portion LL13 of the low voltage connection line LL1 may overlap the above-described emission control output line EMO but may be arranged in a different layer from the layer in which the emission control output line EMO is arranged.

The first portion LL11 of the low voltage connection line LL1 and the second portion LL12 of the low voltage connection line LL1 may refer to portions of the low voltage connection line LL1 that are disposed in the driver island portion DIP of FIG. 12. For example, the first portion LL11 of the low voltage connection line LL1 and the second portion LL12 of the low voltage connection line LL1 may be disposed in the 1-1 island portion IP11. The first portion LL11 of the low voltage connection line LL1 may be a portion extending in the first direction (e.g., the x direction) on the 1-1 island portion IP11, and the second portion LL12 of the low voltage connection line LL1 may be a portion branched from the first portion LL11 of the low voltage connection line LL1 and extending in the second direction (e.g., the y direction).

In detail, the low voltage connection line LL1 may include a portion having a loop shape with one side open on the 1-1 island portion IP11 in a plan view. The loop shape with one side open in a plan view may be included through the first portion LL11 of the low voltage connection line LL1 and the second portion LL12 of the low voltage connection line LL1. According to an embodiment, the first portion LL11 of the low voltage connection line LL1 may extend in the first direction (e.g., the x direction) from the 1-1 bridge portion BP11 toward a center of the 1-1 island portion IP11. The second portion LL12 of the low voltage connection line LL1 may branch from the first portion LL11 of the low voltage connection line LL1, and thus may surround at least a portion of the emission control stage EMST and may have a rectangular shape with one side open. In other words, the second portion LL12 of the low voltage connection line LL1 may extend to surround the outside of the 1-1 island portion IP11 and may have a rectangular shape including an opening on one side. In this case, the first portion HL11 of the high voltage connection line HL1 may extend toward the center of the 1-1 island portion IP11 through the opening of the second portion LL12 of the low voltage connection line LL1.

The second portion LL12 of the low voltage connection line LL1 may be electrically connected to stages disposed in the driver island portion DIP of FIG. 12. As described above, one stage or two stages may be disposed in the driver island portion DIP of FIG. 12. For example, the n-th emission control stage EMSTn and the (n+1)th emission control stage EMSTn+1 may be arranged in the 1-1 island portion IP11. Because the second portion LL12 of the low voltage connection line LL1 is disposed to surround at least a portion of the emission control stage EMST, the second portion LL12 of the low voltage connection line LL1 may directly transmit voltages to the n-th emission control stage EMSTn and the (n+1)th emission control stage EMSTn+1.

In particular, a portion of the second portion LL12 of the low voltage connection line LL1 is disposed to overlap the first and second emission buffer transistors EMBF1 and EMBF2, and thus may also be electrically connected to the first and second emission buffer transistors EMBF1 and EMBF2. The second portion LL12 of the low voltage connection line LL1 that overlaps the first and second emission buffer transistors EMBF1 and EMBF2 has a sufficient space for arrangement, and thus may be arranged to have a relatively thick width compared to the remaining portion of the second portion LL12 of the low voltage connection line LL1.

Because the high voltage connection line HL1 and the low voltage connection line LL1 have a structure as described above, the display device according to an embodiment may be stretched in various directions and may also efficiently use a space in a non-display area. A display apparatus including a structure as shown in FIG. 13 may reduce the load on lines and realize images of good quality, by maximizing respective widths of the high voltage connection line HL1 and the low voltage connection line LL1 in the peripheral island portion 21 of FIG. 12 and the peripheral bridge portion 22 of FIG. 12.

Referring to FIGS. 14 and 15, as described above, a plurality of second input lines IL2 may also be disposed in the driver island portion DIP of FIG. 12. The plurality of second input lines IL2 may include a first clock line CLK1, a second clock line CLK2, a carry line CRL, and a reset signal line ESR. Because the plurality of second input lines IL2 are disposed on the driver island portion DIP of FIG. 12, they each extend in the second direction (e.g., the y direction) through the first horizontal bridge portion HBP1 of FIG. 12. For example, the plurality of second input lines IL2 are disposed on the 1-1 island portion IP11 and may each extend vertically through the 11-1 bridge portion BP111 and the 11-2 bridge portion BP112.

According to an embodiment, some areas of the first clock line CLK1 and the second clock line CLK2 disposed on the driver island portion DIP of FIG. 12 may have a double wiring structure. For example, each of the first clock line CLK1 and the second clock line CLK2 may have a double wiring structure on the 1-1 island portion IP11. In detail, the first clock line CLK1 may include a first lower clock line LCK1 and a first upper clock line UCK1 disposed on the first lower clock line LCK1. The first lower clock line LCK1 and the first upper clock line UCK1 may be electrically connected to each other through a contact hole. Similarly, the second clock line CLK2 may include a second lower clock line LCK2 and a second upper clock line UCK2 disposed on the second lower clock line LCK2. The second lower clock line LCK2 and the second upper clock line UCK2 may also be electrically connected to each other through a contact hole. When each of the first clock line CLK1 and the second clock line CLK2 has a double wiring structure, respective loads on the first clock line CLK1 and the second clock line CLK2 decrease, and thus a display apparatus according to an embodiment may realize images of better quality.

Referring to FIG. 15, the first lower clock line LCK1 may be disposed between the second interlayer-insulating layer 117 and the first organic insulating layer 119. The first lower clock line LCK1 may be disposed on substantially the same layer as the layer on which the source electrode SE of FIG. 7A is disposed in the main island portion 11 of FIG. 4, and may include the same material as the source electrode SE of FIG. 7A. Because the second lower clock line LCK2 may be disposed in the same layer as the layer on which the first lower clock line LCK1 is disposed, the second lower clock line LCK2 may also be disposed in the same layer as the layer on which the source electrode SE of FIG. 7A is disposed.

The first upper clock line UCK1 may be disposed between the first organic insulating layer 119 and the second organic insulating layer 121. The first upper clock line UCK1 may be disposed on substantially the same layer as the layer on which the first connection piece CM1 of FIG. 7A is disposed in the main island portion 11 of FIG. 4, and may include the same material as the first connection piece CM1 of FIG. 7A. Because the second upper clock line UCK2 may be disposed in the same layer as the layer on which the first upper clock line UCK1 is disposed, the second upper clock line UCK2 may also be disposed in the same layer as the layer on which the first connection piece CM1 of FIG. 7A is disposed.

FIG. 16 is a schematic magnified plan view of a portion of a display apparatus according to an embodiment, that is, a magnified view of a region D of FIG. 12.

Referring to FIG. 16, the n-th bypass stage GBSTn and the (n+1)th bypass stage GBSTn+1 may be arranged in the 3-1 island portion IP31. Each bypass stage GBST may include a node controller and a buffer transistor. For example, the n-th bypass stage GBSTn may include a first bypass node controller GBNC1 and a first bypass buffer transistor GBBF1, and the (n+1t)th bypass control stage GBSTn+1 may include a second bypass node controller GBNC2 and a second bypass buffer transistor GBBF2.

Each of the n-th bypass stage GBSTn and the (n+1)th bypass stage GBSTn+1 may apply the bypass control signal GB of FIG. 10 to the display area DA of FIG. 3 through a bypass output line GBO. In detail, the bypass control signal GB of FIG. 10 output by the bypass stage GBST may be first transmitted to the bypass output line GBO, and then may be supplied to the pixels of the display area DA of FIG. 3 through the bypass control line GBL of FIG. 10 connected to the bypass output line GBO.

The bypass output line GBO may include a first bypass output line GBO1 connected to the n-th bypass stage GBSTn and a second bypass output line GBO2 connected to the (n+1)th bypass stage GBSTn+1. According to another embodiment, when one bypass stage GBST is disposed on the 3-1 island portion IP31, one bypass output line GBO may be disposed on the 3-1 bridge portion BP31.

The bypass output line GBO may extend through the 3-1 bridge portion BP31, the 4-1 island portion IP41, and the 4-1 bridge portion BP41. The bypass output line GBO may extend through the bridge electrode BE in an area overlapping a plurality of first input lines IL1 disposed on the 4-1 island portion IP41. Although not shown in FIG. 16, the bypass output line GBO may extend toward the display area DA of FIG. 3 through the initialization driving circuit GIDC of FIG. 10 and the data write driving circuit GWDC of FIG. 10.

The emission control output line EMO extending from the 2-1 bridge portion BP21 may be arranged in the 3-1 island portion IP31, the 3-1 bridge portion BP31, and the 4-1 island portion IP41. Because the emission control output line EMO transmits the output signal of the emission control stage EMST of FIG. 13 disposed more outside than the bypass stage GBST, the emission control output line EMO may also be referred to as a 'pre-output line'. The pre-output lines arranged in the 3-1 island portion IP31 may extend around the perimeter of the bypass stage GBST. In detail, the first emission control output line EMO1 may extend to surround an upper portion of the n-th bypass stage GBSTn, and the second emission control output line EMO2 may extend to surround a lower portion of the (n+1)th bypass stage GBSTn+1.

The emission control output line EMO extending around the perimeter of the 3-1 island portion IP31 may be disposed in the same layer as the layer on which the bypass output line GBO is disposed in the 3-1 bridge portion BP31. In other words, the first emission control output line EMO1, the first bypass output line GBO1, the second bypass output line GBO2, and the second emission control output line EMO2 may be arranged on the 3-1 bridge portion BP31. The emission control output line EMO disposed on the 3-1 bridge portion BP31 may be disposed on substantially the same layer as the layer on which the source electrode SE of FIG. 7A of the main island portion 11 of FIG. 4 is disposed. However, a portion of the emission control output line EMO extending around the perimeter of the 3-1 island portion IP31 may be disposed on substantially the same layer as the layer on which the first connection piece CM1 of FIG. 4A of the main island portion 11 of FIG. 4 is disposed, in order to avoid overlapping with a circuit portion of the bypass stage GBST.

Input lines for applying signals or voltages to the bypass stage GBST may be disposed also in the 3-1 island portion IP31 and the 4-1 island portion IP41. The input lines may include first input lines IL1 disposed in the wiring island portion WIP of FIG. 12 and second input lines IL2 disposed in the driver island portion DIP of FIG. 12. In other words, among the input lines necessary for the bypass stage GBST, the first input lines IL1 may be arranged in the 4-1 island portion IP41, and the second input lines IL2 may be arranged in the 3-1 island portion IP31. Each of the first input lines IL1 and the second input lines IL2 may extend in the second direction (e.g., the y direction). Accordingly, the first input lines IL1 may extend through the 14-1 bridge portion BP141 and the 14-2 bridge portion BP142, and the second input lines IL2 may extend through the 13-1 bridge portion BP131 and the 13-2 bridge portion BP132.

According to an embodiment, the first input lines IL1 may include a gate high voltage line VGH, a gate low voltage line VGL, and a start signal line FLM, and the second input lines IL2 may include a first clock line CLK1, a second clock line CLK2, a carry line CRL, and a reset signal line ESR.

Because the first input lines IL1 are disposed in the 4-1 island portion IP41 spaced apart from the 3-1 island portion IP31, an additional connection line CW may be needed. The connection line CW may include a high voltage connection line HL2 connected to the gate high voltage line VGH among the first input lines IL1, and a low voltage connection line LL2 connected to the gate low voltage line VGL among the first input lines IL1.

The high voltage connection line HL2 may include a first portion HL21, a second portion HL22, a third portion HL23, and a fourth portion HL24. The first portion HL21 of the high voltage connection line HL2, the second portion HL22 of the high voltage connection line HL2, the third portion HL23 of the high voltage connection line HL2, and the fourth portion HL24 of the high voltage connection line HL2 may be integrally formed with one another and may be arranged in the same layer.

The fourth portion HL24 of the high voltage connection line HL2 may refer to a portion of the high voltage connection line HL2 that is disposed in the wiring island portion WIP of FIG. 12. For example, the fourth portion HL24 of the high voltage connection line HL2 may be disposed in the 4-1 island portion IP41. The fourth portion HL24 of the high voltage connection line HL2 may have substantially the same structure as the fourth portion HL14 of the high voltage connection line HL1 shown in FIG. 13.

The third portion HL23 of the high voltage connection line HL2 may refer to a portion of the high voltage connection line HL2 that is disposed in the first vertical bridge portion VBP1. For example, the third portion HL23 of the high voltage connection line HL2 may be disposed in the 3-1 bridge portion BP31. The third portion HL23 of the high voltage connection line HL2 may have substantially the same structure as the third portion HL13 of the high voltage connection line HL1 shown in FIG. 13.

The first portion HL21 of the high voltage connection line HL2 and the second portion HL22 of the high voltage connection line HL2 may refer to portions of the high voltage connection line HL2 that are disposed in the driver island portion DIP of FIG. 12. For example, the first portion HL21 of the high voltage connection line HL2 and the second portion HL22 of the high voltage connection line HL2 may be disposed in the 3-1 island portion IP31.

The high voltage connection line HL2 may include a portion having a 'T' shape on the 3-1 island portion IP31 in a plan view. The 'T' shape in a plan view may be included through the first portion HL21 of the high voltage connection line HL2 and the second portion HL22 of the high voltage connection line HL2. The first portion HL21 of the high voltage connection line HL2 and the second portion HL22 of the high voltage connection line HL2 may have substantially the same structure as the first portion HL11 of the high voltage connection line HL1 of FIG. 13 and the second portion HL12 of the high voltage connection line HL1 of FIG. 13, respectively.

The low voltage connection line LL2 may include a first portion LL21, a second portion LL22, a third portion LL23, and a fourth portion LL24. The first portion LL21 of the low voltage connection line LL2, the second portion LL22 of the low voltage connection line LL2, the third portion LL23 of the low voltage connection line LL2, and the fourth portion LL24 of the low voltage connection line LL2 may be integrally formed with one another and may be arranged in the same layer.

The fourth portion LL24 of the low voltage connection line LL2 may refer to a portion of the low voltage connection line LL2 that is disposed in the wiring island portion WIP of FIG. 12. For example, the fourth portion LL24 of the low voltage connection line LL2 may be disposed in the 4-1 island portion IP41. The fourth portion LL24 of the low voltage connection line LL2 may have substantially the same structure as the fourth portion LL14 of the low voltage connection line LL1 shown in FIG. 13.

The third portion LL23 of the low voltage connection line LL2 may refer to a portion of the low voltage connection line LL2 that is disposed in the first vertical bridge portion VBP1. For example, the third portion LL23 of the low voltage connection line LL2 may be disposed in the 3-1 bridge portion BP31. The third portion LL23 of the low voltage connection line LL2 may have substantially the same structure as the third portion LL13 of the low voltage connection line LL1 shown in FIG. 13.

The first portion LL21 of the low voltage connection line LL2 and the second portion LL22 of the low voltage connection line LL2 may refer to portions of the low voltage connection line LL2 that are disposed in the driver island portion DIP of FIG. 12. For example, the first portion LL21 of the low voltage connection line LL2 and the second portion LL22 of the low voltage connection line LL2 may be disposed in the 3-1 island portion IP31.

The low voltage connection line LL2 may include a portion having a loop shape with one side open on the 3-1 island portion IP31 in a plan view. The loop shape with one side open in a plan view may be included through the first portion LL21 of the low voltage connection line LL2 and the second portion LL22 of the low voltage connection line LL2. The first portion LL21 of the low voltage connection line LL2 and the second portion LL22 of the low voltage connection line LL2 may have substantially the same structure as the first portion LL11 of the low voltage connection line LL1 of FIG. 13 and the second portion LL12 of the low voltage connection line LL1 of FIG. 13, respectively.

As described above, a plurality of second input lines IL2 may also be disposed in the driver island portion DIP of FIG. 12. The plurality of second input lines IL2 may include a first clock line CLK1, a second clock line CLK2, a carry line CRL, and a reset signal line ESR. Because the plurality of second input lines IL2 are disposed on the driver island portion DIP of FIG. 12, they each extend in the second direction (e.g., the y direction) through the first horizontal bridge portion HBP1 of FIG. 12. For example, the plurality of second input lines IL2 are disposed on the 3-1 island portion IP31 and may each extend vertically through the 13-1 bridge portion BP131 and the 13-2 bridge portion BP132.

According to an embodiment, some areas of the first clock line CLK1 and the second clock line CLK2 disposed on the driver island portion DIP of FIG. 12 may have a double wiring structure. For example, each of the first clock line CLK1 and the second clock line CLK2 may have a double wiring structure on the 3-1 island portion IP31. In detail, the first clock line CLK1 may include a first lower clock line LCK1 and a first upper clock line UCK1 disposed on the first lower clock line LCK1. The first lower clock line LCK1 and the first upper clock line UCK1 may be electrically connected to each other through a contact hole. Similarly, the second clock line CLK2 may include a second lower clock line LCK2 and a second upper clock line UCK2 disposed on the second lower clock line LCK2. The second lower clock line LCK2 and the second upper clock line UCK2 may also be electrically connected to each other through a contact hole.

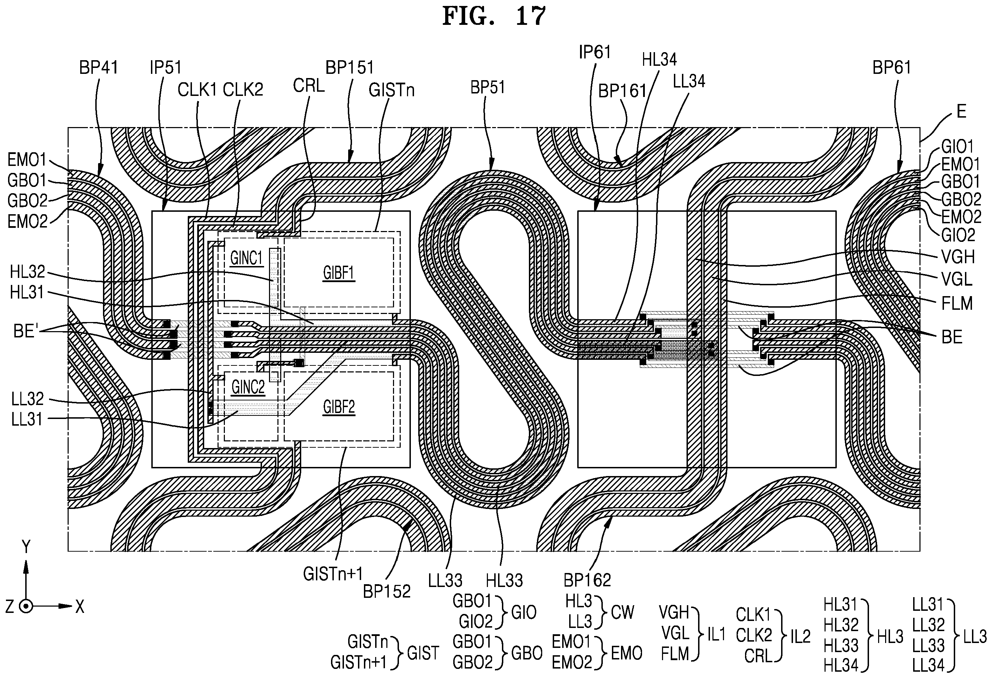

FIG. 17 is a schematic magnified plan view of a portion of a display apparatus according to an embodiment, that is, a magnified view of a region E of FIG. 12.

Referring to FIG. 17, the n-th initialization stage GISTn and the (n+1)th initialization stage GISTn+1 may be arranged in the 5-1 island portion IP51. Each initialization stage GIST may include a node controller and a buffer transistor. For example, the n-th initialization stage GISTn may include a first initialization node controller GINC1 and a first initialization buffer transistor GIBF1, and the (n+1t)th initialization control stage GISTn+1 may include a second initialization node controller GINC2 and a second initialization buffer transistor GIBF2.

Each of the n-th initialization stage GISTn and the (n+1)th initialization stage GISTn+1 may apply the initialization control signal GI of FIG. 10 to the display area DA of FIG. 3 through an initialization output line GIO. In detail, the initialization control signal GI of FIG. 10 output by the initialization stage GIST may be first transmitted to the initialization output line GIO, and then may be supplied to the pixels of the display area DA of FIG. 3 through the initialization control line GIL of FIG. 10 connected to the initialization output line GIO.

The initialization output line GIO may include a first initialization output line GIO1 connected to the n-th initialization stage GISTn and a second initialization output line GIO2 connected to the (n+1)th initialization stage GISTn+1. According to another embodiment, when one initialization stage GIST is disposed on the 5-1 island portion IP51, one initialization output line GIO may be disposed on the 5-1 bridge portion BP51.

The initialization output line GIO may extend through the 5-1 bridge portion BP51, the 6-1 island portion IP61, and the 6-1 bridge portion BP61. The initialization output line GIO may extend through the bridge electrode BE in an area overlapping a plurality of first input lines IL1 disposed on the 6-1 island portion IP61. Although not shown in FIG. 17, the initialization output line GIO may extend toward the display area DA of FIG. 3 through the data write driving circuit GWDC of FIG. 10.

The emission control output line EMO and the bypass output line GBO each extending from the 4-1 bridge portion BP41 may be arranged in the 5-1 island portion IP51, the 5-1 bridge portion BP51, and the 6-1 island portion IP61. Because the emission control output line EMO and the bypass output line GBO transmit the respective output signals of the emission control stage EMST of FIG. 13 and the bypass stage GBST of FIG. 16 disposed more outside than the initialization stage GIST, the emission control output line EMO and the bypass output line GBO may also be referred to as 'pre-output lines'. The pre-output lines arranged in the 5-1 island portion IP51 may each extend to pass through a space where the n-th initialization stage GISTn and the (n+1)th initialization stage GISTn+1 are spaced apart from each other. In other words, the pre-output lines disposed on the 5-1 island portion IP51 may each extend in the first direction (e.g., the x direction) through the center of the 5-1 island portion IP51. However, the pre-output lines may each extend through a bridge electrode BE' in an area overlapping a plurality of second input lines IL2.

Input lines for applying signals or voltages to the initialization stage GIST may be disposed also in the 5-1 island portion IP51 and the 6-1 island portion IP61. The input lines may include first input lines IL1 disposed in the wiring island portion WIP of FIG. 12 and second input lines IL2 disposed in the driver island portion DIP of FIG. 12. In other words, among the input lines necessary for the initialization stage GIST, the first input lines IL1 may be arranged in the 6-1 island portion IP61, and the second input lines IL2 may be arranged in the 5-1 island portion IP51. Each of the first input lines IL1 and the second input lines IL2 may extend in the second direction (e.g., the y direction). Accordingly, the first input lines IL1 may extend through the 16-1 bridge portion BP161 and the 16-2 bridge portion BP162, and the second input lines IL2 may extend through the 15-1 bridge portion BP151 and the 15-2 bridge portion BP152.

According to an embodiment, the first input lines IL1 may include a gate high voltage line VGH, a gate low voltage line VGL, and a start signal line FLM, and the second input lines IL2 may include a first clock line CLK1, a second clock line CLK2, and a carry line CRL.

Because the first input lines IL1 are disposed in the 6-1 island portion IP61 spaced apart from the 5-1 island portion IP51, an additional connection line CW may be needed. The connection line CW may include a high voltage connection line HL3 connected to the gate high voltage line VGH among the first input lines IL1, and a low voltage connection line LL3 connected to the gate low voltage line VGL among the first input lines IL1.

The high voltage connection line HL3 may include a first portion HL31, a second portion HL32, a third portion HL33, and a fourth portion HL34. The first portion HL31 of the high voltage connection line HL3, the second portion HL32 of the high voltage connection line HL3, the third portion HL33 of the high voltage connection line HL3, and the fourth portion HL34 of the high voltage connection line HL3 may be integrally formed with one another and may be arranged in the same layer.

The fourth portion HL34 of the high voltage connection line HL3 may refer to a portion of the high voltage connection line HL3 that is disposed in the wiring island portion WIP of FIG. 12. For example, the fourth portion HL34 of the high voltage connection line HL3 may be disposed in the 6-1 island portion IP61. The fourth portion HL34 of the high voltage connection line HL3 may have substantially the same structure as the fourth portion HL14 of the high voltage connection line HL1 shown in FIG. 13.

The third portion HL33 of the high voltage connection line HL3 may refer to a portion of the high voltage connection line HL3 that is disposed in the first vertical bridge portion VBP1. For example, the third portion HL33 of the high voltage connection line HL3 may be disposed in the 5-1 bridge portion BP51. The third portion HL33 of the high voltage connection line HL3 may have substantially the same structure as the third portion HL13 of the high voltage connection line HL1 shown in FIG. 13.

The first portion HL31 of the high voltage connection line HL3 and the second portion HL32 of the high voltage connection line HL3 may refer to portions of the high voltage connection line HL3 that are disposed in the driver island portion DIP of FIG. 12. For example, the first portion HL31 of the high voltage connection line HL3 and the second portion HL32 of the high voltage connection line HL3 may be disposed in the 5-1 island portion IP51.

The high voltage connection line HL3 may include a portion having a 'T' shape on the 5-1 island portion IP51 in a plan view. The 'T' shape in a plan view may be included through the first portion HL31 of the high voltage connection line HL3 and the second portion HL32 of the high voltage connection line HL3. The first portion HL31 of the high voltage connection line HL3 and the second portion HL32 of the high voltage connection line HL3 may have substantially the same structure as the first portion HL11 of the high voltage connection line HL1 of FIG. 13 and the second portion HL12 of the high voltage connection line HL1 of FIG. 13, respectively.

The low voltage connection line LL3 may include a first portion LL31, a second portion LL32, a third portion LL33, and a fourth portion LL34. The first portion LL31 of the low voltage connection line LL3, the third portion LL33 of the low voltage connection line LL3, and the fourth portion LL34 of the low voltage connection line LL3 may be integrally formed with one another and may be arranged in the same layer. However, according to an embodiment, the second portion LL32 of the low voltage connection line LL3 may be disposed in a different layer from the layer in which the first portion LL31 of the low voltage connection line LL3 is disposed. The first portion LL31 and the second portion LL32 may be electrically connected to each other through a contact hole.

The fourth portion LL34 of the low voltage connection line LL3 may refer to a portion of the low voltage connection line LL3 that is disposed in the wiring island portion WIP of FIG. 12. For example, the fourth portion LL34 of the low voltage connection line LL3 may be disposed in the 6-1 island portion IP61. The fourth portion LL34 of the low voltage connection line LL3 may have substantially the same structure as the fourth portion LL14 of the low voltage connection line LL1 shown in FIG. 13.

The third portion LL33 of the low voltage connection line LL3 may refer to a portion of the low voltage connection line LL3 that is disposed in the first vertical bridge portion VBP1. For example, the third portion LL33 of the low voltage connection line may be disposed in the 5-1 bridge portion BP51. The third portion LL33 of the low voltage connection line may have substantially the same structure as the third portion LL13 of the low voltage connection line shown in FIG. 13.

The first portion LL31 of the low voltage connection line LL3 and the second portion LL32 of the low voltage connection line LL3 may refer to portions of the low voltage connection line LL3 that are disposed in the driver island portion DIP of FIG. 12. For example, the first portion LL31 of the low voltage connection line LL3 and the second portion LL32 of the low voltage connection line LL3 may be disposed in the 5-1 island portion IP51.

The first portion LL31 of the low voltage connection line LL3 may be a portion extending in the first direction (e.g., the x direction) on the 5-1 island portion IP51. In detail, the first portion LL31 of the low-voltage connection line may extend in the first direction (e.g., the x direction) from the 5-1 bridge portion BP51 disposed on one side surface of the 5-1 island portion IP51 toward a side surface opposite to the one side surface. According to an embodiment, the first portion LL31 of the low voltage connection line LL3 may include a diagonal portion extending in a diagonal direction between the first direction (e.g., the x direction) and the second direction (e.g., the y direction). Accordingly, the first portion LL31 of the low voltage connection line LL3 may extend from the center of a right side surface of the 5-1 island portion IP51 to a lower area of a left side surface thereof via the (n+1)th data write stage GWSTn+1.

The second portion LL32 of the low voltage connection line LL3 may be a portion that branches from the first portion LL31 of the low voltage connection line LL3 and extends in the second direction (e.g., the y direction). Accordingly, the second portion LL32 of the low voltage connection line LL3 may extend from the lower region of the left side surface of the 5-1 island portion IP51 to an upper region of the left side surface thereof. However, the second portion LL32 of the low voltage connection line LL3 may be branched from the first portion LL31 of the low voltage connection line LL3, and may be disposed in a different layer from the layer in which the first portion LL31 of the low voltage connection line LL3 is disposed. In other words, the second portion LL32 of the low voltage connection line LL3 may be disposed in the same layer as the layer on which the first clock line CLK1 and the second clock line CLK2 are disposed, and may be electrically connected to the first portion LL31 of the low voltage connection line LL3 through a contact hole.

The second portion LL32 of the low voltage connection line LL3 may be electrically connected to stages disposed in the driver island portion DIP of FIG. 12. As described above, one stage or two stages may be disposed in the driver island portion DIP of FIG. 12. For example, the n-th initialization stage GISTn and the (n+1)th initialization stage GISTn+1 may be arranged in the 5-1 island portion IP51. Because the second portion LL32 of the low voltage connection line LL3 extends in the second direction (e.g., the y direction) to pass through respective side surfaces of the n-th initialization stage GISTn and the (n+1)th initialization stage GISTn+1, a voltage may be directly transmitted to each of the n-th initialization stage GISTn and the (n+1)th initialization stage GISTn+1.

Because the high voltage connection line HL3 and the low voltage connection line LL3 have a structure as described above, the display apparatus according to an embodiment may also efficiently use a space in a non-display area where the initialization driving circuit GIDC of FIG. 10 is disposed. A display apparatus including a structure as shown in FIG. 17 may reduce the load on lines and realize images of good quality, by maximizing respective widths of the high voltage connection line HL3 and the low voltage connection line LL3 in the peripheral island portion 21 of FIG. 12 and the peripheral bridge portion 22 of FIG. 12.

As described above, a plurality of second input lines IL2 may also be disposed in the driver island portion DIP of FIG. 12. The plurality of second input lines IL2 may include a first clock line CLK1, a second clock line CLK2, and a carry line CRL. Because the plurality of second input lines IL2 are disposed on the driver island portion DIP of FIG. 12, they each extend in the second direction (e.g., the y direction) through the first horizontal bridge portion HBP1 of FIG. 12. For example, the plurality of second input lines IL2 are disposed on the 5-1 island portion IP51 and may each extend vertically through the 15-1 bridge portion BP151 and the 15-2 bridge portion BP152.

As shown in FIG. 17, each of the first clock line CLK1 and the second clock line CLK2 disposed on the driver island portion DIP of FIG. 12 may have a single wiring structure. In other words, each of the first clock line CLK1 and the second clock line CLK2 may be integrally formed in the same layer. However, an embodiment is not limited thereto. According to another embodiment, the first clock line CLK1 and the second clock line CLK2 may have a double wiring structure.

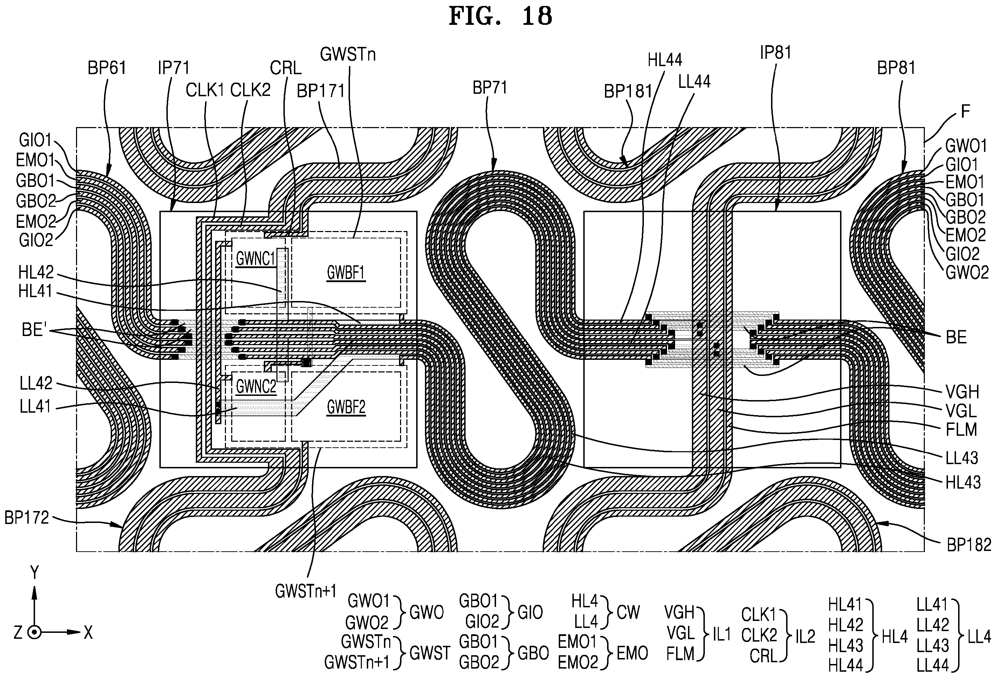

FIG. 18 is a schematic magnified plan view of a portion of a display apparatus according to an embodiment, that is, a magnified view of a region F of FIG. 12.

Referring to FIG. 18, the n-th data write stage GWSTn and the (n+1)th data write stage GWSTn+1 may be arranged in the 7-1 island portion IP71. Each data write stage GWST may include a node controller and a buffer transistor. For example, the n-th data write stage GWSTn may include a first scan node controller GWNC1 and a first scan buffer transistor GWBF1, and the (n+1t)th data write control stage GWSTn+1 may include a second scan node controller GWNC2 and a second scan buffer transistor GWBF2.

Each of the n-th data write stage GWSTn and the (n+1)th data write stage GWSTn+1 may apply the scan signal GW of FIG. 10 to the display area DA of FIG. 3 through the data write output line GWO. In detail, the scan signal GW of FIG. 10 output by the data write stage GWST may be first transmitted to the data write output line GWO, and then may be supplied to the pixels of the display area DA of FIG. 3 through the scan signal line GWL of FIG. 10 connected to the data write output line GWO.

The data write output line GWO may include a first data write output line GWO1 connected to the n-th data write stage GWSTn and a second data write output line GWO2 connected to the (n+1)th data write stage GWSTn+1. According to another embodiment, when one data write stage GWST is disposed on the 7-1 island portion IP71, one data write output line GWO may be disposed on the 7-1 bridge portion BP71.

The data write output line GWO may extend through the 7-1 bridge portion BP71, the 8-1 island portion IP81, and the 8-1 bridge portion BP81. The data write output line GWO may extend through the bridge electrode BE in an area overlapping a plurality of first input lines IL1 disposed on the 8-1 island portion IP81.

The emission control output line EMO, the bypass output line GBO, and the initialization output line GIO each extending from the 6-1 bridge portion BP61 may be arranged in the 7-1 island portion IP71, the 8-1 bridge portion BP81, and the 8-1 island portion IP81. Because the emission control output line EMO, the bypass output line GBO, and the initialization output line GIO transmit the respective output signals of the emission control stage EMST of FIG. 13, the bypass stage GBST of FIG. 16, and the initialization stage GIST of FIG. 17 disposed more outside than the data write stage GWST, the emission control output line EMO, the bypass output line GBO, and the initialization output line GIO may also be referred to as 'pre-output lines'. The pre-output lines arranged in the 7-1 island portion IP71 may each extend to pass through a space where the n-th data write stage GWSTn and the (n+1)th data write stage GWSTn+1 are spaced apart from each other. In other words, the pre-output lines disposed on the 7-1 island portion IP71 may each extend in the first direction (e.g., the x direction) through the center of the 7-1 island portion IP71. However, the pre-output lines may each extend through a bridge electrode BE' in an area overlapping a plurality of second input lines IL2.

Input lines for applying signals or voltages to the data write stage GWST may be disposed also in the 7-1 island portion IP71 and the 8-1 island portion IP81. The input lines may include first input lines IL1 disposed in the wiring island portion WIP of FIG. 12 and second input lines IL2 disposed in the driver island portion DIP of FIG. 12. In other words, among the input lines necessary for the data write stage GWST, the first input lines IL1 may be arranged in the 8-1 island portion IP81, and the second input lines IL2 may be arranged in the 7-1 island portion IP71. Each of the first input lines IL1 and the second input lines IL2 may extend in the second direction (e.g., the y direction). Accordingly, the first input lines IL1 may extend through the 18-1 bridge portion BP181 and the 18-2 bridge portion BP182, and the second input lines IL2 may extend through the 17-1 bridge portion BP171 and the 17-2 bridge portion BP172.

According to an embodiment, the first input lines IL1 may include a gate high voltage line VGH, a gate low voltage line VGL, and a start signal line FLM, and the second input lines IL2 may include a first clock line CLK1, a second clock line CLK2, and a carry line CRL.

Because the first input lines IL1 are disposed in the 8-1 island portion IP81 spaced apart from the 7-1 island portion IP71, an additional connection line CW may be needed. The connection line CW may include a high voltage connection line HL4 connected to the gate high voltage line VGH among the first input lines IL1, and a low voltage connection line LL4 connected to the gate low voltage line VGL among the first input lines IL1.

The high voltage connection line HL4 may include a first portion HL41, a second portion HL42, a third portion HL43, and a fourth portion HL44. The first portion HL41 of the high voltage connection line HL4, the second portion HL42 of the high voltage connection line HL4, the third portion HL43 of the high voltage connection line HL4, and the fourth portion HL44 of the high voltage connection line HL4 may be integrally formed with one another and may be arranged in the same layer.

The fourth portion HL44 of the high voltage connection line HL4 may refer to a portion of the high voltage connection line HL4 that is disposed in the wiring island portion WIP of FIG. 12. For example, the fourth portion HL44 of the high voltage connection line HL4 may be disposed in the 8-1 island portion IP81. The fourth portion HL44 of the high voltage connection line HL4 may have substantially the same structure as the fourth portion HL14 of the high voltage connection line HL1 shown in FIG. 13.

The third portion HL43 of the high voltage connection line HL4 may refer to a portion of the high voltage connection line HL4 that is disposed in the first vertical bridge portion VBP1. For example, the third portion HL43 of the high voltage connection line HL4 may be disposed in the 7-1 bridge portion BP71. The third portion HL43 of the high voltage connection line HL4 may have substantially the same structure as the third portion HL13 of the high voltage connection line HL1 shown in FIG. 13.

The first portion HL41 of the high voltage connection line HL4 and the second portion HL42 of the high voltage connection line HL4 may refer to portions of the high voltage connection line HL4 that are disposed in the driver island portion DIP of FIG. 12. For example, the first portion HL41 of the high voltage connection line HL4 and the second portion HL42 of the high voltage connection line HL4 may be disposed in the 7-1 island portion IP71.

The high voltage connection line HL4 may include a portion having a 'T' shape on the 7-1 island portion IP71 in a plan view. The 'T' shape in a plan view may be included through the first portion HL41 of the high voltage connection line HL4 and the second portion HL42 of the high voltage connection line HL4. The first portion HL41 of the high voltage connection line HL4 and the second portion HL42 of the high voltage connection line HL4 may have substantially the same structure as the first portion HL11 of the high voltage connection line HL1 of FIG. 13 and the second portion HL12 of the high voltage connection line HL1 of FIG. 13, respectively.

The low voltage connection line LL4 may include a first portion LL41, a second portion LL42, a third portion LL43, and a fourth portion LL44. The first portion LL41 of the low voltage connection line LL4, the third portion LL43 of the low voltage connection line LL4, and the fourth portion LL44 of the low voltage connection line LL4 may be integrally formed with one another and may be arranged in the same layer. However, according to an embodiment, the second portion LL42 of the low voltage connection line LL4 may be disposed in a different layer from the layer in which the first portion LL41 of the low voltage connection line LL4 is disposed.

The fourth portion LL44 of the low voltage connection line LL4 may refer to a portion of the low voltage connection line LL4 that is disposed in the wiring island portion WIP of FIG. 12. For example, the fourth portion LL44 of the low voltage connection line LL4 may be disposed in the 8-1 island portion IP81. The fourth portion LL44 of the low voltage connection line may have substantially the same structure as the fourth portion LL14 of the low voltage connection line LL1 shown in FIG. 13.

The third portion LL43 of the low voltage connection line LL4 may refer to a portion of the low voltage connection line LL4 that is disposed in the first vertical bridge portion VBP1. For example, the third portion LL43 of the low voltage connection line LL4 may be disposed in the 7-1 bridge portion BP71. The third portion LL43 of the low voltage connection line LL4 may have substantially the same structure as the third portion LL13 of the low voltage connection line LL1 shown in FIG. 13.

The first portion LL41 of the low voltage connection line LL4 and the second portion LL42 of the low voltage connection line LL4 may refer to portions of the low voltage connection line LL4 that are disposed in the driver island portion DIP of FIG. 12. For example, the first portion LL41 of the low voltage connection line LL4 and the second portion LL42 of the low voltage connection line LL4 may be disposed in the 7-1 island portion IP71. The first portion LL41 of the low voltage connection line LL4 and the second portion LL42 of the low voltage connection line LL4 may have substantially the same structure as the first portion LL31 of the low voltage connection line LL3 of FIG. 17 and the second portion LL32 of the low voltage connection line LL3 of FIG. 17, respectively.

As described above, a plurality of second input lines IL2 may also be disposed in the driver island portion DIP of FIG. 12. The plurality of second input lines IL2 may include a first clock line CLK1, a second clock line CLK2, and a carry line CRL. Because the plurality of second input lines IL2 are disposed on the driver island portion DIP of FIG. 12, they each extend in the second direction (e.g., the y direction) through the first horizontal bridge portion HBP1 of FIG. 12. For example, the plurality of second input lines IL2 are disposed on the 7-1 island portion IP71 and may each extend vertically through the 17-1 bridge portion BP171 and the 17-2 bridge portion BP172.

As shown in FIG. 18, each of the first clock line CLK1 and the second clock line CLK2 disposed on the driver island portion DIP of FIG. 12 may have a single wiring structure. In other words, each of the first clock line CLK1 and the second clock line CLK2 may be integrally formed in the same layer. However, an embodiment is not limited thereto. According to another embodiment, the first clock line CLK1 and the second clock line CLK2 may have a double wiring structure.

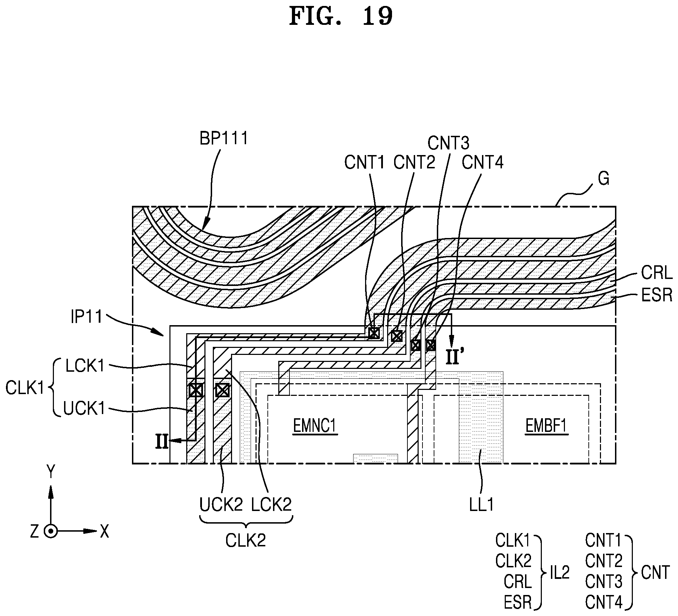

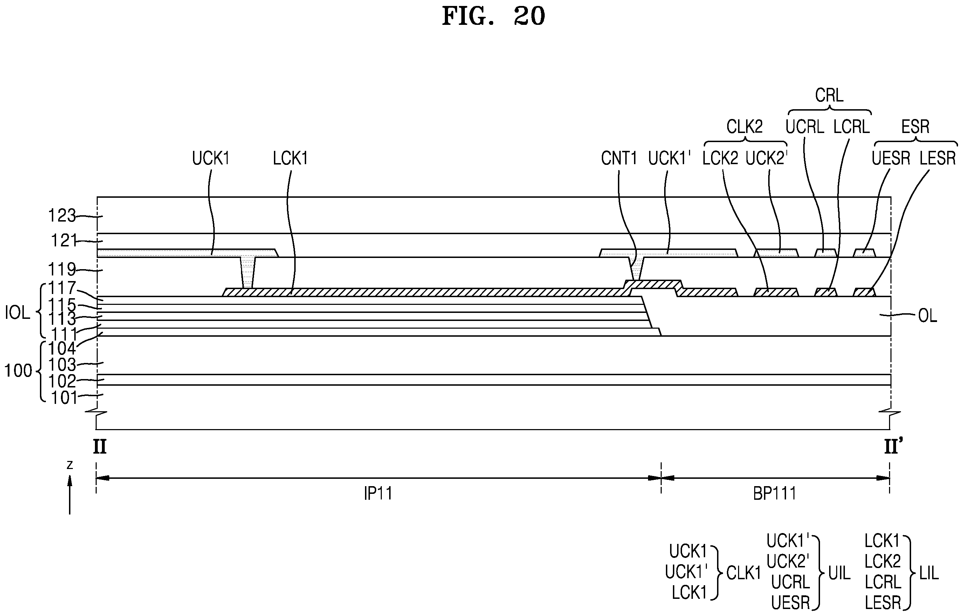

FIG. 19 is a schematic magnified plan view of a portion of a display apparatus according to another embodiment. FIG. 20 is a cross-sectional view of a portion of a display apparatus according to another embodiment, and corresponds to a cross-section taken along line II-II' of FIG. 19. Referring to FIGS. 19 and 20, other features except for the features of the plurality of second input lines IL2 are the same as those described above with reference to FIGS. 13 through 15. Descriptions of the same reference numerals among the components in FIGS. 19 and 20 are replaced by those given with reference to FIGS. 13 through 15, and differences therebetween will be explained below.

Referring to FIGS. 19 and 20, as described above, a plurality of second input lines IL2 may also be disposed in the driver island portion DIP of FIG. 12. The plurality of second input lines IL2 may include a first clock line CLK1, a second clock line CLK2, a carry line CRL, and a reset signal line ESR. Because the plurality of second input lines IL2 are disposed on the driver island portion DIP of FIG. 12, they each extend in the second direction (e.g., the y direction) through the first horizontal bridge portion HBP1 of FIG. 12. For example, the plurality of second input lines IL2 are disposed on the 1-1 island portion IP11 and may each extend vertically through the 11-1 bridge portion BP111 and the 11-2 bridge portion BP112.

As described above, some areas of the first clock line CLK1 and the second clock line CLK2 disposed on the driver island portion DIP of FIG. 12 may have a double wiring structure. In detail, the first lower clock line LCK1 and the second lower clock line LCK2 may be disposed on substantially the same layer as the layer on which the source electrode SE of FIG. 7A is disposed, the first upper clock line UCK1 and the second upper clock line UCK2 may be disposed in the same layer as the layer on which the first connection piece CM1 of FIG. 7A is disposed.

Similarly, the plurality of second input lines IL2 disposed on the first horizontal bridge portion HBP1 of FIG. 12 may each have a double wiring structure. In other words, each of the plurality of second input lines IL2 may have a dual wiring structure including a lower input line LIL and an upper input line UIL disposed on the lower input line LIL. In detail, the first clock line CLK1 may include a first lower clock line LCK1 and a first upper clock line UCK1' overlapping the first lower clock line LCK1, on a bridge portion. Similarly, the second clock line CLK2 may include a second lower clock line LCK2 and a second upper clock line UCK2' overlapping the second lower clock line LCK2, on a bridge portion. The carry line CRL may include a lower carry line LCRL and an upper carry line UCRL overlapping the lower carry line LCRL, on a bridge portion. The reset signal line ESR may include a lower reset signal line LESR and an upper reset signal line UESR overlapping the lower reset signal line LESR, on a bridge portion.

In other words, the lower input lines LIL disposed on the first horizontal bridge portion HBP1 of FIG. 12 may include the first lower clock line LCK1, the second lower clock line LCK2, the lower carry line LCRL, and the lower reset signal line LESR, and the upper input lines UIL disposed on the first horizontal bridge part HBP1 of FIG. 12 may include the first upper clock line UCK1', the second upper clock line UCK2', the upper carry line UCRL, and the upper reset signal line UESR.

The lower input lines LIL may be disposed between the second interlayer-insulating layer 117 and the first organic insulating layer 119. The lower input lines LIL may be disposed on substantially the same layer as the layer on which the source electrode SE (see FIG. 7A) is disposed in the main island portion 11 (see FIG. 4). The upper input lines UIL may be disposed between the first organic insulating layer 119 and the second organic insulating layer 121. The upper input lines UIL may be disposed on substantially the same layer as the layer on which the first connection piece CM1 (see FIG. 7A) is disposed in the main island portion 11 (see FIG. 4).

The upper input line UIL and the lower input line LIL may be electrically connected through the contact hole CNT between wires that overlap each other. For example, the first upper clock line UCK1' and the first lower clock line LCK1 arranged on the bridge portion may be electrically connected to each other through a first contact hole CNT1. Similarly, the second upper clock line UCK2' and the second lower clock line LCK2 may be electrically connected to each other through a second contact hole CNT2. The upper carry line UCRL and the lower carry line LCRL may be connected to each other through a third contact hole CNT3, and the upper reset signal line UESR and the lower reset signal line LESR may be connected to each other through a fourth contact hole CNT4.

In this case, a plurality of contact holes CNT connecting the upper input line UIL to the lower input line LIL may be arranged on an island portion. For example, the first, second, third, and fourth contact holes CNT1, CNT2, CNT3, and CNT4 may be disposed on the 1-1 island portion IP11.

Because a display apparatus according to an embodiment has a dual wiring structure as described above, the display apparatus may reduce the load on lines and realize images of good quality. Having a dual wiring structure is not limited to a plurality of second input lines IL2. Each of the plurality of first input lines IL1 may also have a double wiring structure like the plurality of second input lines IL2. Not only the input lines connected to the emission control stage EMST of FIG. 12 may have a double wiring structure, but also the input lines connected to the bypass stage GBST of FIG. 12, the initialization stage GIST of FIG. 12, and the data write stage GWST of FIG. 12 may have a double wiring structure on the bridge portion.

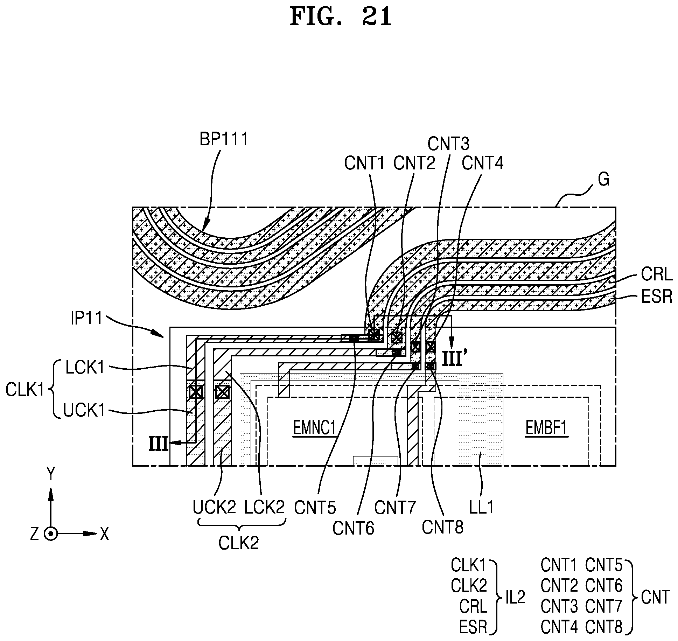

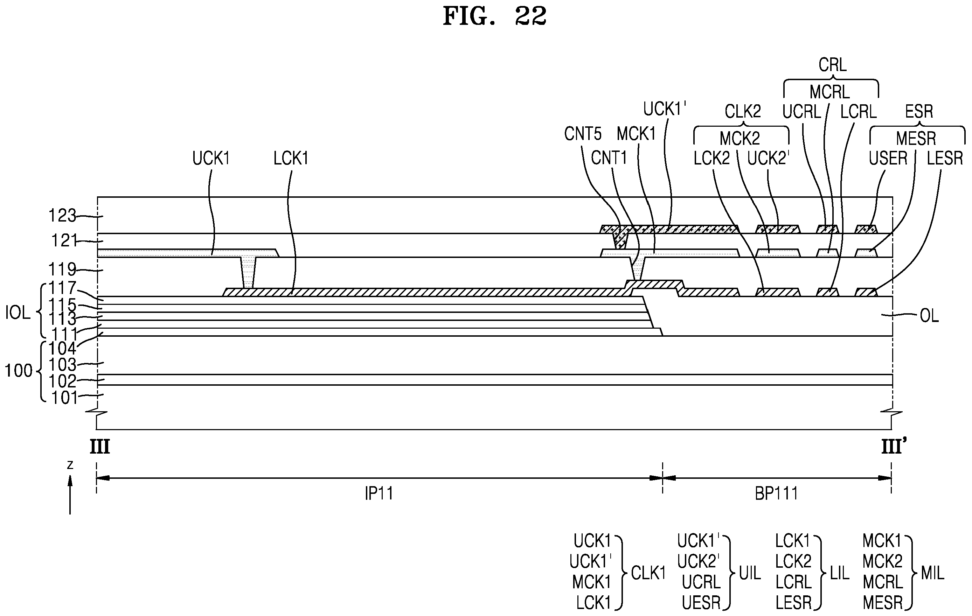

FIG. 21 is a schematic magnified plan view of a portion of a display apparatus according to another embodiment. FIG. 22 is a cross-sectional view of a portion of a display apparatus according to another embodiment, and corresponds to a cross-section taken along line III-III' of FIG. 21. Referring to FIGS. 21 and 22, other features except for the features of the plurality of second input lines IL2 are the same as those described above with reference to FIGS. 13 through 15. Descriptions of the same reference numerals among the components in FIGS. 21 and 22 are replaced by those given with reference to FIGS. 13 through 15, and differences therebetween will be explained below.

Referring to FIGS. 21 and 22, as described above, a plurality of second input lines IL2 may also be disposed in the driver island portion DIP of FIG. 12. The plurality of second input lines IL2 may include a first clock line CLK1, a second clock line CLK2, a carry line CRL, and a reset signal line ESR. Because the plurality of second input lines IL2 are disposed on the driver island portion DIP of FIG. 12, they each extend in the second direction (e.g., the y direction) through the first horizontal bridge portion HBP1 of FIG. 12. For example, the plurality of second input lines IL2 are disposed on the 1-1 island portion IP11 and may each extend vertically through the 11-1 bridge portion BP111 and the 11-2 bridge portion BP112.

According to an embodiment, the plurality of second input lines IL2 disposed on the first horizontal bridge portion HBP1 of FIG. 12 may each have a triple wiring structure. In other words, each of the plurality of second input lines IL2 may have a triple wiring structure including a lower input line LIL, a middle input line MIL disposed on the lower input line LIL, and an upper input line UIL disposed on the middle input line MIL. In detail, the first clock line CLK1 may include a first lower clock line LCK1, a first middle clock line MCK1, and a first upper clock line UCK1' overlapping one another, on a bridge portion. Similarly, the second clock line CLK2 may include a second lower clock line LCK2, a second middle clock line MCK2, and a second upper clock line UCK2' overlapping one another, on a bridge portion. The carry line CRL may include a lower carry line LCRL, a middle carry line MCRL, and an upper carry line UCRL overlapping one another, on a bridge portion. The reset signal line ESR may include a lower reset signal line LESR, a middle reset signal line MESR, and an upper reset signal line UESR overlapping one another, on a bridge portion.

In other words, the lower input lines LIL disposed on the first horizontal bridge portion HBP1 of FIG. 12 may include the first lower clock line LCK1, the second lower clock line LCK2, the lower carry line LCRL, and the lower reset signal line LESR, and the middle input lines MIL disposed on the first horizontal bridge part HBP1 of FIG. 12 may include the first middle clock line MCK1, the second middle clock line MCK2, the middle carry line MCRL, and the middle reset signal line MESR. Similarly, the upper input lines UIL disposed on the first horizontal bridge part HBP1 of FIG. 12 may include the first upper clock line UCK1', the second upper clock line UCK2', the upper carry line UCRL, and the upper reset signal line UESR.

The lower input lines LIL may be disposed between the second interlayer-insulating layer 117 and the first organic insulating layer 119. The lower input lines LIL may be disposed on substantially the same layer as the layer on which the source electrode SE (see FIG. 7A) is disposed in the main island portion 11 (see FIG. 4). The middle input lines MIL may be disposed between the first organic insulating layer 119 and the second organic insulating layer 121. The middle input lines MIL may be disposed on substantially the same layer as the layer on which the first connection piece CM1 (see FIG. 7A) is disposed in the main island portion 11 (see FIG. 4). The upper input lines UIL may be disposed between the second organic insulating layer 121 and the third organic insulating layer 123. The upper input lines UIL may be disposed on substantially the same layer as the layer on which the second connection piece CM2 (see FIG. 7A) is disposed in the main island portion 11 (see FIG. 4).

The upper input line UIL, the middle input line MIL, and the lower input line LIL may be electrically connected to each other by overlapping lines through the contact hole CNT. For example, the first lower clock line LCK1 and the first middle clock line MCK1 arranged on the bridge portion may be connected to each other through a first contact hole CNT1, and the first middle clock line MCK1 and the first upper clock line UCK1' may be connected to each other through a fifth contact hole CNT5. Similarly, the second lower clock line LCK2 and the second middle clock line MCK2 arranged on the bridge portion may be connected to each other through a second contact hole CNT2, and the second middle clock line MCK2 and the second upper clock line UCK2' may be connected to each other through a sixth contact hole CNT6. Similarly, the lower carry line LCRL and the middle carry line MCRL arranged on the bridge portion may be connected to each other through a third contact hole CNT3, and the middle carry line MCRL and the upper carry line UCRL may be connected to each other through a seventh contact hole CNT7. The lower reset signal line LESR and the middle reset signal line MESR arranged on the bridge portion may be connected to each other through a fourth contact hole CNT4, and the middle reset signal line MESR and the upper reset signal line UESR may be connected to each other through an eighth contact hole CNT8.

In this case, a plurality of contact holes CNT connecting the upper input line UIL to the middle input line MIL or connecting the middle input line MIL to the lower input line LIL may be arranged on an island portion. For example, the first, second, third, fourth, fifth, sixth, seventh, and eighth contact holes CNT1, CNT2, CNT3, CNT4, CNT5, CNT6, CNT7, and CNT8 may be disposed on the 1-1 island portion IP11.

Because a display apparatus according to an embodiment has a triple wiring structure as described above, the display apparatus may reduce the load on lines and thus realize images of good quality. Having a triple wiring structure is not limited to a plurality of second input lines IL2. Each of the plurality of first input lines IL1 may also have a triple wiring structure like the plurality of second input lines IL2. Not only the input lines connected to the emission control stage EMST of FIG. 12 may have a triple wiring structure, but also the input lines connected to the bypass stage GBST of FIG. 12, the initialization stage GIST of FIG. 12, and the data write stage GWST of FIG. 12 may have a triple wiring structure on the bridge portion.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. A display apparatus comprising:
a substrate comprising a first island portion and a second island portion spaced apart from each other, and a first bridge portion connecting the first island portion to the second island portion;
a gate driving circuit disposed on the first island portion;
a plurality of first input lines disposed on the second island portion; and
a connection line connected to some of the plurality of first input lines,
wherein the connection line is arranged to extend from the second island portion to the first island portion through the first bridge portion.

2. The display apparatus of claim 1, wherein the first island portion and the second island portion are arranged alternately in a first direction.

3. The display apparatus of claim 2, wherein the connection line comprises: a first portion extending in the first direction on the first island portion; and a second portion branching from the first portion and extending in a second direction intersecting the first direction.

4. The display apparatus of claim 3, wherein
the gate driving circuit comprises a plurality of stages,
at least one stage of the plurality of stages is disposed on the first island portion, and
the second portion is connected to the at least one stage.

5. The display apparatus of claim 1, wherein
the plurality of first input lines comprise at least one of a gate high voltage line or a gate low voltage line, and
the connection line comprises at least one of: a high voltage connection line connected to the gate high voltage line; or a low voltage connection line connected to the gate low voltage line.

6. The display apparatus of claim 5, wherein the high voltage connection line comprises a portion having a 'T' shape in a plan view.

7. The display apparatus of claim 6, wherein the high voltage connection line comprises:
a first portion extending in a first direction from the first bridge portion toward a center of the first island portion; and
a second portion branching from the first portion and extending in a second direction intersecting the first direction.

8. The display apparatus of claim 7, wherein the first portion of the high voltage connection line and the second portion of the high voltage connection line are disposed in a same layer and are formed integrally with each other.

9. The display apparatus of claim 5, wherein the low voltage connection line has a portion having a loop shape having one side open in a plan view.

10. The display apparatus of claim 9, wherein the low voltage connection line comprises:
a first portion extending in a first direction from the first bridge portion toward a center of the first island portion; and
a second portion branching from the first portion, surrounding at least a portion of the gate driving circuit in the plan view, and having a quadrangular shape with one side open.

11. The display apparatus of claim 10, wherein
the high voltage connection line extends through the open side of the second portion.

12. The display apparatus of claim 10, wherein the first portion of the low voltage connection line and the second portion of the low voltage connection line are formed integrally with each other.

13. The display apparatus of claim 5, wherein the low voltage connection line comprises:
a first portion extending in a first direction from the first bridge portion disposed on one side surface of the first island portion toward an opposite side surface of the first island portion; and
a second portion branching from the first portion and extending in a second direction intersecting the first direction.

14. The display apparatus of claim 13, wherein the first portion of the low voltage connection line comprises a portion having a diagonal shape extending in a diagonal direction between the first direction and the second direction.

15. The display apparatus of claim 13, wherein the first portion of the low voltage connection line and the second portion of the low voltage connection line are arranged in different layers from each other and are electrically connected to each other through a contact hole.

16. The display apparatus of claim 1, further comprising a plurality of second input lines arranged on the first island portion,
wherein the plurality of second input lines comprise at least one of a clock line, a carry line, or a reset signal line.

17. The display apparatus of claim 16, further comprising:
a main island portion disposed in a display area;
a pixel driving circuit portion disposed on the main island portion; and
a light-emitting element disposed on the main island portion and connected to the pixel driving circuit portion,
wherein the pixel driving circuit portion and the light-emitting element are connected to each other through at least one of: a first connection piece disposed on the pixel driving circuit portion; or a second connection piece disposed on the first connection piece.

18. The display apparatus of claim 17, wherein a partial region of the clock line disposed on the first island portion has a double wiring structure including a lower clock line and an upper clock line disposed on the lower clock line.

19. The display apparatus of claim 18, wherein
the lower clock line is disposed in a same layer as a layer in which at least one of a source electrode or a drain electrode of the pixel driving circuit portion is disposed, and
the upper clock line is disposed in a same layer as a layer in which the first connection piece is disposed.

20. The display apparatus of claim 17, wherein each of the first island portion and the second island portion is provided in plurality,
wherein the display apparatus further comprises a second bridge portion connecting first island portions arranged adjacent to each other among the plurality of first island portions or connecting second island portions arranged adjacent to each other among the plurality of second island portions,
wherein each of the plurality of first input lines and the plurality of second input lines extends through the second bridge portion.

21. The display apparatus of claim 20, wherein each of the plurality of first input lines and the plurality of second input lines has a single wiring structure on the second bridge portion.

22. The display apparatus of claim 21, wherein each of the plurality of first input lines and the plurality of second input lines is disposed in a same layer as a layer in which at least one of a source electrode or a drain electrode of the pixel driving circuit portion is disposed.

23. The display apparatus of claim 20, wherein each of the plurality of first input lines and the plurality of second input lines comprises a lower input line and an upper input line disposed on the lower input line and has a dual wiring structure on the second bridge portion.

24. The display apparatus of claim 23, wherein
the lower input line is disposed in a same layer as a layer in which at least one of a source electrode or a drain electrode of the pixel driving circuit portion is disposed, and
the upper input line is disposed in a same layer as a layer in which the first connection piece is disposed.

25. The display apparatus of claim 23, wherein
the lower input line and the upper input line are electrically connected to each other through a contact hole, and
the contact hole is disposed on the first island portion or the second island portion.

26. The display apparatus of claim 20, wherein each of the plurality of first input lines and the plurality of second input lines comprises a lower input line, a middle input line disposed on the lower input line, and an upper input line disposed on the middle input line, and has a triple wiring structure on the second bridge portion.

27. The display apparatus of claim 26, wherein
the lower input line is disposed in a same layer as a layer in which at least one of a source electrode or a drain electrode of the pixel driving circuit portion is disposed,
the middle input line is disposed in a same layer as a layer in which the first connection piece is disposed, and
the upper input line is disposed in a same layer as a layer in which the second connection piece is disposed.

28. The display apparatus of claim 26, wherein
the lower input line and the middle input line are electrically connected to each other through a first contact hole,
the middle input line and the upper input line are electrically connected to each other through a second contact hole, and
the first contact hole and the second contact hole are disposed on the first island portion or the second island portion.

29. The display apparatus of claim 1, wherein the gate driving circuit comprises at least one of an emission control driving circuit, a bypass driving circuit, an initialization driving circuit, or a data writing driving circuit.

30. The display apparatus of claim 1, wherein the first bridge portion is disposed on a center of a side surface of each of the first island portion and the second island portion.

31. The display apparatus of claim 30, wherein the first bridge portion has a serpentine shape.
